# EUROPEAN PATENT APPLICATION

(11) **EP 4 683 476 A1**
(43) Date of publication of application: **21.01.2026**
(21) Application number: 25189359.0
(22) Date of filing: 14.07.2025
(51) Int. Cl.: H10K 59/123, H10K 59/126, H10K 59/131

(54) **DISPLAY DEVICE AND ELECTRONIC DEVICE**

(30) Priority: 19.07.2024 KR 20240095895
(71) Applicant: Samsung Display Co., Ltd., Yongin-si, Gyeonggi-do (KR)
(72) Inventor: KIM, Sunho, Yongin-si (KR); KO, Yoomin, Yongin-si (KR); PARK, Juchan, Yongin-si (KR); CHOI, Chung Sock, Yongin-si (KR)
(74) Representative: Marks & Clerk LLP

(57) **Abstract**

A display device includes a base layer including a display area in which a plurality of pixels is disposed and a non-display area disposed adjacent to the display area, a gate driver disposed in the non-display area and configured to output a write scan signal, a scan line, and a shield pattern. The scan line includes a vertical line extending from the gate driver in a first direction and configured to apply the write scan signal to the plurality of pixels, and a horizontal line extending in a second direction crossing the first direction and electrically connected to the vertical line. The shield pattern overlaps the vertical line.

## Description

### TECHNICAL FIELD

Embodiments of the present disclosure relate to a display device, and more particularly, to a display device having improved display quality.

### DISCUSSION OF RELATED ART

Generally, electronic devices, such as smartphones, digital cameras, laptop computers, navigation systems, and smart televisions, which provide images to users, include a display device for displaying images. The display device generates images, and provides the generated images to the users through a display screen.

The display device typically includes a plurality of pixels for generating images, a scan driving circuit that applies scan signals to the pixels, a data driver that applies data voltages to the pixels, and a light emission driving unit that applies light emission signals to the pixels. The pixels receive data voltages in response to the scan signals. The pixels display images by emitting light with a brightness corresponding to the data voltages in response to the light emission signals.

The pixels can display video and still images. When the pixels display video, the pixels may be continuously provided with updated images. When the pixels display still images, the pixels may maintain the initially provided images and may not be provided with images thereafter.

### SUMMARY

At least some embodiments of the present disclosure provide a display device that may improve display quality by reducing coupling noise that occurs between wiring lines.

According to an embodiment of the present disclosure, a display device includes a base layer including a display area in which a plurality of pixels is disposed and a non-display area disposed adjacent to the display area. The display device further includes a gate driver disposed in the non-display area and configured to output a write scan signal, and a scan line. The scan line includes a vertical line extending from the gate driver in a first direction and configured to apply the write scan signal to the plurality of pixels, and a horizontal line extending in a second direction crossing the first direction and electrically connected to the vertical line. The display device further includes a shield pattern overlapping the vertical line.

According to an embodiment of the present disclosure, a display device includes a base layer including a display area and a non-display area disposed adjacent to the display area, a driving element layer disposed on the base layer, and a plurality of light-emitting elements disposed on the driving element layer. Each light-emitting element includes a first electrode, an intermediate layer disposed on the first electrode, and a second electrode disposed on the intermediate layer. The display device further includes a gate driver disposed in the non-display area and configured to output a write scan signal. The driving element layer includes a scan line electrically connected to the gate driver, a first transistor electrically connected to the second electrode, a third electrode, to which the write scan signal is applied from the scan line, and a shield pattern overlapping the scan line and at least a portion of a drain pattern of the second transistor.

According to an embodiment of the present disclosure, an electronic device includes a display device, an electronic module overlapping the display device, and a housing accommodating the display device. The display device includes a base layer including a display area in which a plurality of pixels is disposed and a non-display area disposed adjacent to the display area, a gate driver disposed in the non-display area and configured to output a write scan signal, and a scan line. The scan line includes a vertical line extending from the gate driver in a first direction and configured to apply the write scan signal to the plurality of pixels, and a horizontal line extending in a second direction crossing the first direction and electrically connected to the vertical line. The display device further includes a shield pattern overlapping the vertical line.

At least some of the above and other features of the invention are set out in the claims.

### BRIEF DESCRIPTION OF THE DRAWINGS

The above and other objects and features of the present disclosure will become more apparent by describing in detail embodiments thereof with reference to the accompanying drawings.
FIG. 1 is a perspective view of an electronic device according to an embodiment of the present disclosure.
FIG. 2A is a cross-sectional view of a display device included in the electronic device of FIG. 1.
FIG. 2B is a cross-sectional view of a display panel illustrated in FIG. 2A.
FIG. 3 is a block diagram of a display device according to an embodiment of the present disclosure.
FIGS. 4A, 4B, and 4C are equivalent circuit diagrams of a pixel according to an embodiment of the present disclosure.
FIG. 5 is a plan view schematically illustrating a display panel according to an embodiment of the present disclosure.
FIG. 6 is a plan view illustrating a light emission unit and a pixel driving unit connected thereto according to an embodiment of the present disclosure.
FIGS. 7A to 7D are enlarged plan views of a partial area of a display panel according to an embodiment of the present disclosure.
FIG. 8 is an enlarged plan view of a partial area of a display panel according to an embodiment of the present disclosure.
FIG. 9A is a cross-sectional view illustrating a portion corresponding to line I-I' of FIG. 7A according to an embodiment of the present disclosure. FIG. 9B is an enlarged cross-sectional view illustrating area BB' of FIG. 9A.
FIGS. 10A and 10B are cross-sectional views of a display panel according to an embodiment of the present disclosure illustrating a portion corresponding to line I-I' of FIG. 7A.
FIG. 11A is a plan view schematically illustrating a display panel according to an embodiment of the present disclosure.
FIG. 11B is an enlarged cross-sectional view of area CC' of FIG. 11A.
FIG. 11C is an enlarged cross-sectional view of area DD' of FIG. 11A.
FIG. 11D is a block diagram of a gate driver according to an embodiment of the present disclosure.
FIG. 12 is a plan view schematically illustrating a display panel according to an embodiment of the present disclosure.
FIGS. 13A to 13G are process diagrams illustrating a disposition order of circuit layers according to an embodiment of the present disclosure.
FIG. 14 is a perspective view of an electronic device according to an embodiment of the present disclosure.
FIG. 15 is a view illustrating a folded state of the electronic device illustrated in FIG. 14.
FIG. 16 is an exploded perspective view of the electronic device illustrated in FIG. 14.
FIG. 17 is a block diagram of the electronic device illustrated in FIG. 14.
FIG. 18 is a diagram illustrating an electronic device according to an embodiment of the present disclosure.

### DETAILED DESCRIPTION

Embodiments of the present disclosure will be described more fully hereinafter with reference to the accompanying drawings. Like reference numerals may refer to like elements throughout the accompanying drawings.

It will be understood that the terms "first," "second," "third," etc. are used herein to distinguish one element from another, and the elements are not limited by these terms. Thus, a "first" element in an embodiment may be described as a "second" element in another embodiment.

It should be understood that descriptions of features or aspects within each embodiment should typically be considered as available for other similar features or aspects in other embodiments, unless the context clearly indicates otherwise.

As used herein, the singular forms "a", "an" and "the" are intended to include the plural forms as well, unless the context clearly indicates otherwise.

Spatially relative terms, such as "beneath", "below", "lower", "under", "above", "upper", etc., may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below.

It will be understood that when a component is referred to as being "on", "connected to", "coupled to", or "adjacent to" another component, it can be directly on, connected, coupled, or adjacent to the other component, or intervening components may be present. It will also be understood that when a component is referred to as being "between" two components, it can be the only component between the two components, or one or more intervening components may also be present. It will also be understood that when a component is referred to as "covering" another component, it can be the only component covering the other component, or one or more intervening components may also be covering the other component. Other words used to describe the relationships between components should be interpreted in a like fashion.

The term "and/or" includes one or more combinations that may be defined by the associated components.

When terms such as "comprise" and/or "comprising" are used in the specification, it should be understood that they specify the presence of the above-mentioned features, numbers, steps, operations, components, parts, and/or combinations thereof, and do not exclude the presence or addition of one or more other numbers, steps, operations, components, parts, and/or combinations thereof.

Embodiments of the present disclosure relate to a display device that may improve display quality by reducing coupling noise that occurs between wiring lines within the display device. For example, coupling noise may arise due to changes in electric fields between a second drain electrode pattern and a scan line, both of which are located in the same layer but are not electrically connected. This interference can degrade image clarity and performance, including, for example, in high-resolution display devices that operate with precise signal transmission.

To address this issue, embodiments of the present disclosure utilize a shield pattern that overlaps both the second drain electrode pattern and the scan line. This shield pattern may be electrically charged with a constant voltage, thus, effectively acting as a barrier to prevent or reduce unwanted electrical coupling. By implementing this structure, a display device according to embodiments of the present disclosure may significantly reduce or prevent coupling noise, resulting in improved image quality, improved signal integrity, and greater overall display performance.

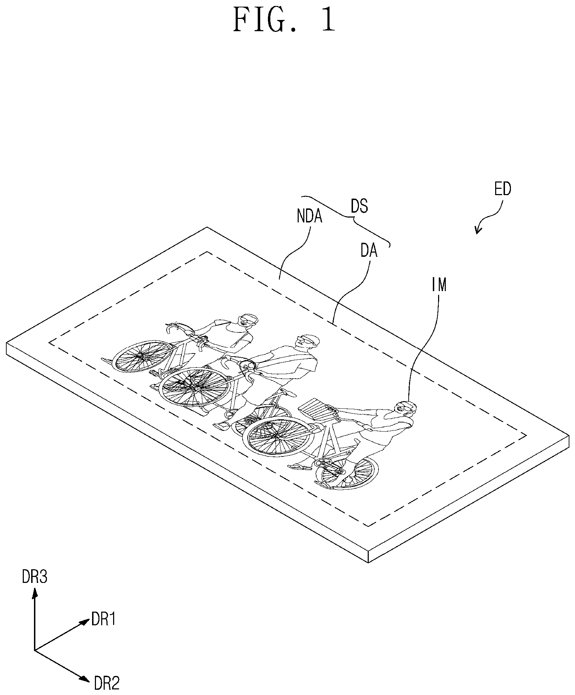

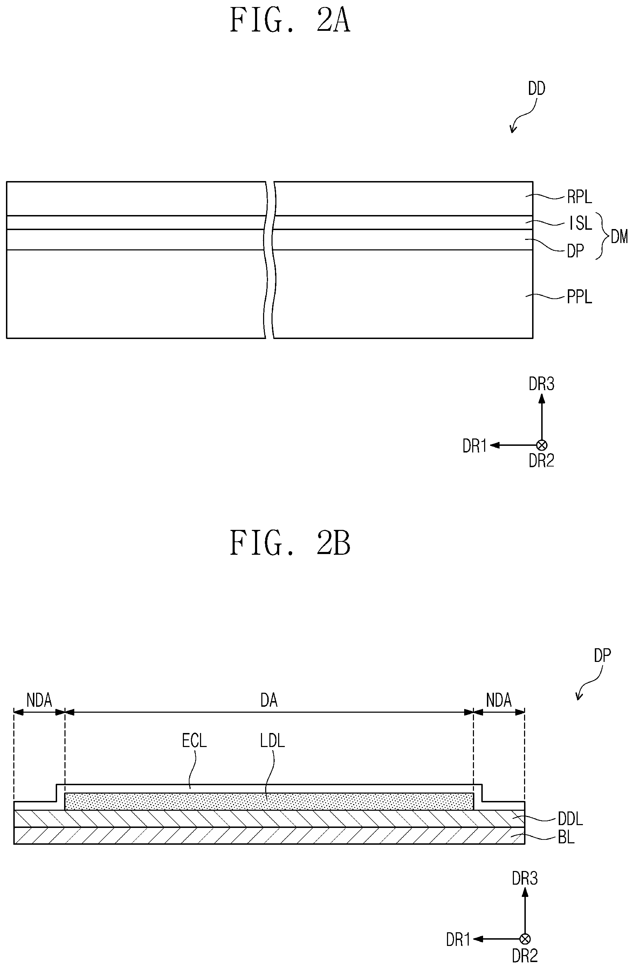

FIG. 1 is a perspective view of an electronic device according to an embodiment of the present disclosure. FIG. 2A is a cross-sectional view of a display device included in the electronic device of FIG. 1. FIG. 2B is a cross-sectional view of a display panel illustrated in FIG. 2A.

Referring to FIG. 1, an electronic device ED according to an embodiment of the present disclosure may have a rectangular shape having short sides (relative to long sides) that extend in a first direction DR1 and long sides (relative to the short sides) that extend in a second direction DR2 that crosses the first direction DR1. However, the present disclosure is not limited thereto, and the electronic device ED may have various shapes, such as, for example, a circle and a polygon.

Hereinafter, a direction that is substantially perpendicular to a plane defined by the first direction DR1 and the second direction DR2 is defined as a third direction DR3. Furthermore, in the specification, "when viewed on a plane" may be defined as a state in which the object of discussion is viewed from the third direction DR3. For example, according to embodiments, a plan view refers to a perspective in which the object is observed along the third direction DR3, capturing its spatial arrangement as projected onto a plane defined by the first direction DR1 and the second direction DR2. Therefore, unless otherwise specified, descriptions referring to an overlapping relationship "on a plane" or "in a plan view" may indicate that the elements being described are aligned or overlapping when observed from the third direction DR3, regardless of whether they are physically disposed at the same vertical level in the device structure.

An upper surface of the electronic device ED may be defined as a display surface DS, and the display surface DS may have a plane that is defined by the first direction DR1 and the second direction DR2. Images IM generated by the electronic device ED may be provided to the user through the display surface DS.

The display surface DS may include a display area DA and a non-display area NDA disposed around the display area DA. An image may be displayed in the display area DA, and an image is not displayed in the non-display area NDA. The non-display area NDA may surround the display area DA, and may define a periphery of the electronic device ED printed with a specific color. For example, the non-display area NDA may correspond to a bezel of the electronic device ED.

The electronic device ED may include a display device DD (see FIG. 2A). The display device DD will be described in further detail below.

Referring to FIG. 2A, the display device DD may include a display module DM, a reflection prevention layer RPL that is disposed on the display module DM, and a panel protection layer PPL that is disposed under the display module DM. The display module DM may include a display panel DP and a sensing layer ISL that is disposed on the display panel DP. The display panel DP may be a flexible panel. For example, the display panel DP may include a flexible substrate, and a plurality of elements that is disposed on the flexible substrate.

The display panel DP according to an embodiment of the present disclosure may be a light-emitting display panel, but is not particularly limited thereto. For example, the display panel DP may be an organic light-emitting display panel or an inorganic light-emitting display panel. A light emission layer of the organic light-emitting display panel may include an organic light-emitting material. A light emission layer of the inorganic light-emitting display panel may include, for example, a quantum dot, a quantum rod, and the like. Hereinafter, the display panel DP is described as an organic light-emitting display panel.

The sensing layer ISL may include a plurality of sensor parts for sensing an external input in a capacitive manner. The sensing layer ISL may be directly formed on the display panel DP with no separate adhesive layer when the display device DD is manufactured. For example, the sensing layer ISL may be directly formed on the display panel DP with no intervening layers, such as an adhesive layer, disposed therebetween.

The reflection prevention layer RPL may be disposed on the sensing layer ISL. When the display device DD is manufactured, the reflection prevention layer RPL may be directly formed on the sensing layer ISL. The reflection prevention layer RPL may be defined as an external light reflection prevention film. The reflection prevention layer RPL may reduce a reflectance of external light that is input toward the display panel DP from a top of the electronic device ED.

By way of example, the sensing layer ISL may be directly formed on the display panel DP, and the reflection prevention layer RPL may be directly formed on the sensing layer ISL, but embodiments of the present disclosure are not limited thereto. For example, the sensing layer ISL may be separately manufactured and attached to the display panel DP by an adhesive layer, and the reflection prevention layer RPL may be separately manufactured and attached to the sensing layer ISL by an adhesive layer.

The panel protection layer PPL may be disposed under the display panel DP. The panel protection layer PPL may protect a lower portion of the display panel DP. The panel protection layer PPL may include a flexible plastic material. For example, the panel protection layer PPL may include polyethylene terephthalate (PET).

Referring to FIG. 2B, the display panel DP may include a base layer BL, a driving element layer DDL that is disposed on the base layer BL, a light-emitting element layer LDL that is disposed on the driving element layer DDL, and an encapsulation layer ECL that is disposed on the light-emitting element layer LDL.

The base layer BL may include a display area DA and a non-display area NDA disposed adjacent to the display area DA. For example, the non-display area may be disposed around the display area DA. The base layer BL may include a flexible plastic material, such as, for example, glass or polyimide (PI). The light-emitting element layer LDL may be disposed on the display area DA.

A plurality of pixels may be disposed in the driving element layer DDL and the light-emitting element layer LDL. Each of the pixels may include a transistor that is disposed in the driving element layer DDL and a light-emitting element that is disposed in the light-emitting element layer LDL and is connected to the transistor.

The encapsulation layer ECL may be disposed on the driving element layer DDL to cover the light-emitting element layer LDL. The encapsulation layer ECL may protect pixels from, for example, moisture, oxygen, and external foreign substances.

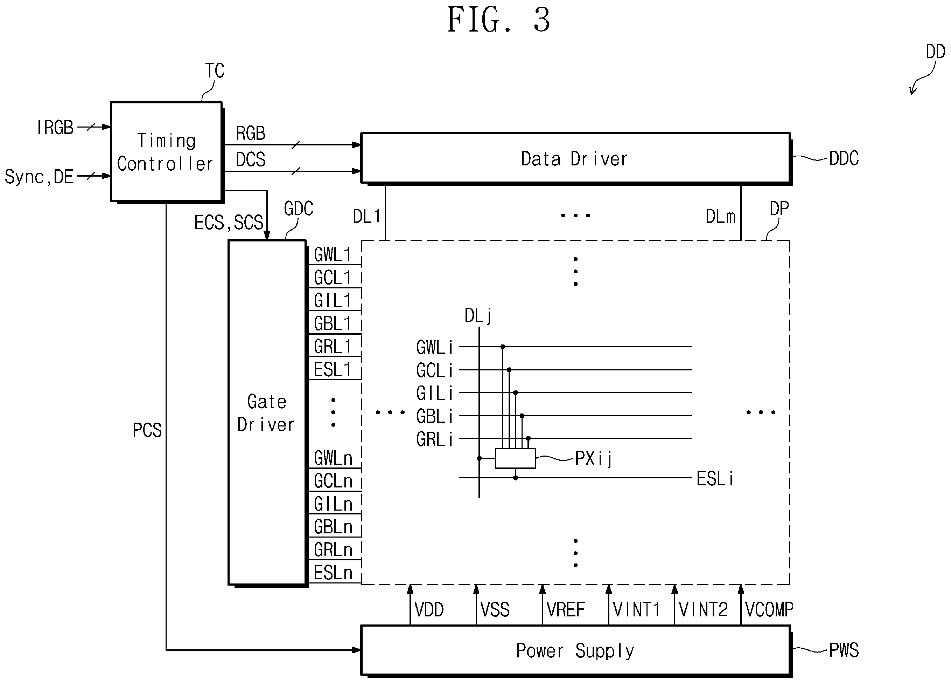

FIG. 3 is a block diagram of a display device according to an embodiment of the present disclosure.

Referring to FIG. 3, the display device DD may include a display panel DP, panel drivers GDC and DDC, a power supply PWS, and a timing controller TC. In an embodiment, the display panel DP is described as a light-emitting display panel. The light-emitting display panel may include an organic light-emitting display panel, an inorganic light-emitting display panel, or a quantum dot light-emitting display panel. In an embodiment that is to be described below, the organic light-emitting display panel is described in detail as an example. The panel drivers GDC and DDC may include a gate driver GDC and a data driver DDC. Although FIG. 3 illustrates that the gate driver GDC and the data driver DDC are disposed on different side surfaces of the display panel DP, the gate driver GDC and the data driver DDC may be disposed together on one side of the display panel DP.

The display panel DP may include scan lines GWL1 to GWLn, GCL1 to GCLn, GIL1 to GILn, GBL1 to GBLn, GRL1 to GRLn, light emission lines ESL1 to ESLn, and data lines DL1 to DLm. The display panel DP may include a plurality of pixels that are connected to the scan lines GWL1 to GWLn, GCL1 to GCLn, GIL1 to GILn, GBL1 to GBLn, GRL1 to GRLn, the light emission lines ESL1 to ESLn, and the data lines DL1 to DLm. Here, "m" and "n" are integers that are greater than 1.

For example, pixels PXij (where "i" and "j" are integers that are greater than 1) located in an i-th horizontal line (or an i-th pixel row) and a j-th vertical line (or a j-th pixel row) may be connected to an i-th first scan line (or a write scan line) GWLi, an i-th second scan line (or a compensation scan line) GCLi, an i-th third scan line (or a first initialization scan line) GILi, an i-th fourth scan line (or a second initialization scan line) GBLi, an i-th fifth scan line (or a reset scan line) GRLi, a j-th data line DLj, and an i-th light emission line ESLi.

The pixel PXij may include a plurality of light-emitting elements, a plurality of transistors, and a plurality of capacitors. The pixel PXij may be supplied with a first power source voltage VDD, a second power source voltage VSS, a third power source voltage (or a reference voltage) VREF, a fourth power source voltage (or a first initialization voltage) VINT1, a fifth power source voltage (or a second initialization voltage) VINT2, and a sixth power source voltage (or a compensation voltage) VCOMP, through a power supply PWS.

Voltage values of the first power source voltage VDD and the second power source voltage VSS are set such that a current flows through the light-emitting element to emit light. For example, the first power source voltage VDD may be set to a voltage that is higher than the second power source voltage VSS.

The third power source voltage VREF may be a voltage for initializing a gate of a driving transistor included in the pixel PXij. The third power source voltage VREF may be used to implement a specific gray level by using a voltage difference from a data signal. To this end, the third power source voltage VREF may be set to a specific voltage within a voltage range of the data signal.

The fourth power source voltage VINT1 may be a voltage for initializing a capacitor included in the pixel PXij. The fourth power source voltage VINT1 may be set to a voltage that is lower than the third power source voltage VREF. For example, the fourth power source voltage VINT1 may be set to a voltage that is lower than a difference between the third power source voltage VREF and a threshold voltage of the driving transistor. However, the present disclosure is not limited thereto.

The fifth power source voltage VINT2 may be a voltage for initializing a cathode of a light-emitting element included in the pixel PXij. The fifth power source voltage VINT2 may be set to a voltage that is lower than the first power source voltage VDD or the fourth power source voltage VINT1, or may be set to a voltage that is similar to or the same as the third power source voltage VREF, but the present disclosure is not limited thereto, and the fifth power source voltage VINT2 may be set to a voltage that is similar to or the same as the first power source voltage VDD.

The sixth power source voltage VCOMP may supply a specific current to the driving transistor when the threshold voltage of the driving transistor is compensated for.

FIG. 1 illustrates that the first to sixth power source voltages VDD, VSS, VREF, VINT1, VINT2, and VCOMP are all supplied from the power supply PWS, but the present disclosure is not limited thereto. For example, the first power source voltage VDD and the second power source voltage VSS are all supplied regardless of the structure of the pixel PXij, and at least one of the third power source voltage VREF, the fourth power source voltage VINT1, the fifth power source voltage VINT2, and the sixth power source voltage VCOMP may not be supplied in correspondence with the structure of the pixel PXij.

In an embodiment of the present disclosure, signal lines connected to the pixel PXij may be variously set in correspondence with a circuit structure of the pixel PXij.

The gate driver GDC may receive a first control signal SCS from the timing controller TC, and may supply a scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn, based on the first control signal SCS.

The scan signal may be set to a voltage at which transistors supplied with the scan signal may be turned on. For example, the scan signal supplied to a P-type transistor may be set to a logic low level, and the scan signal supplied to an N-type transistor may be set to a logic high level. Hereinafter, the meaning of "a scan signal is supplied" may be understood as being supplied as a logic level at which the scan signal turns on a transistor controlled thereby.

Furthermore, the gate driver GDC may receive a second control signal ECS from the timing controller TC, and may supply a light emission signal to the light emission lines ESL1 to ESLn based on the second control signal ECS. For example, the light emission signal may be sequentially supplied to the light emission lines ESL1 to ESLn.

Transistors that are connected to the light emission lines ESL1 to ESLn of the present disclosure may be configured as N-type transistors. Then, the light emission signal supplied to the light emission lines ESL1 to ESLn may be set to a gate-off voltage. The transistors that receive the light emission signal may be turned off when the light emission signal is supplied, and may be set to a turn-on state in other cases.

The second control signal ECS includes a light emission start signal and clock signals, and the gate driver GDC may be implemented by a shift register that sequentially generates and outputs a light emission signal in the form of a pulse by sequentially shifting the light emission start signal in the form of a pulse by using clock signals.

According to an embodiment of the present disclosure, the gate driver GDC may be provided in a single manner. As a result, the non-display area NDA (see FIG. 1), in which the gate driver GDC is disposed, may be decreased. That is, the display area DA (see FIG. 1) of a sufficient extent may be provided. However, the present disclosure is not limited thereto, and according to an embodiment, to supply a scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn, a light emission driver for supplying a light emission signal to the plurality of scan drivers and the light emission lines ESL1 to ESLn may be provided.

The data driver DDC may receive the third control signal DCS and the image data RGB from the timing controller TC. The data driver DDC may convert image data RGB in a digital form into an analog data signal (e.g., a data signal). The data driver DDC may supply a data signal to the data lines DL1 to DLm in response to the third control signal DCS.

The third control signal DCS may include a data enable signal that indicates an output of a valid data signal, a horizontal start signal, and a data clock signal. For example, the data driver DDC may include a shift register that generates a sampling signal by shifting a horizontal start signal in synchronization with a data clock signal, a latch that latches the image data RGB in response to the sampling signal, a digital-to-analog converter (or a decoder) that converts the latched image data (e.g., digital data) into analog data signals, and buffers (or amplifiers) that output the data signals to the data lines DL1 to DLm.

The power supply PWS may supply a first power source voltage VDD, a second power source voltage VSS, and a third power source voltage VREF for driving the pixels PXij to the display panel DP. Furthermore, the power supply PWS may supply at least one of the fourth power source voltage VINT 1, the fifth power source voltage VINT2, and the sixth power source voltage VCOMP to the display panel DP.

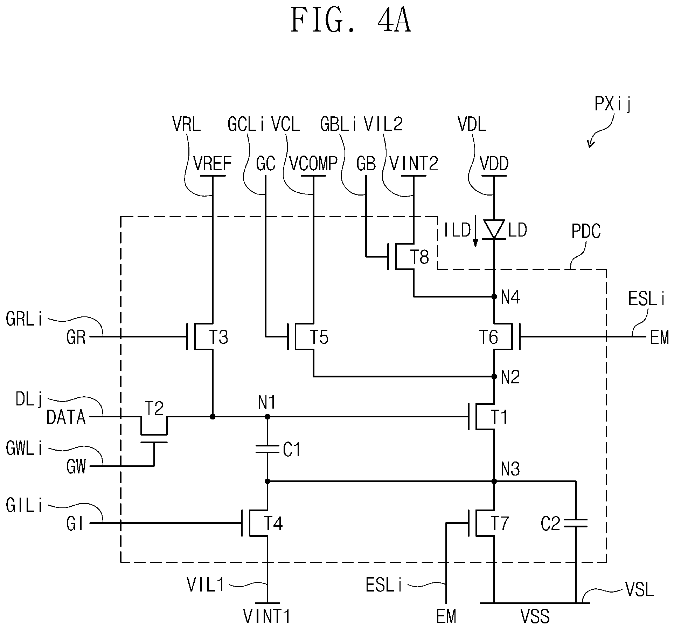

As an example, the power supply PWS may supply each of the first power source voltage VDD, the second power source voltage VSS, the third power source voltage VREF, the fourth power source voltage VINT1, the fifth power source voltage VINT2, and the sixth power source voltage VCOMP, to the display panel DP via the first power source line VDL (see FIG. 4A), the second power source line VSL (see FIG. 4A), the third power source line (or a reference voltage line) VRL (see FIG. 4A), the fourth power source line (or a first initialization voltage line) VIL1 (see FIG. 4A), the fifth power source line (or a second initialization voltage line) VIL2 (see FIG. 4A), and the sixth power source line (or a compensation voltage line VCL (see FIG. 4A).

The power supply PWS may be implemented by a power management integrated circuit, but is not limited thereto.

The timing controller TC may generate the first control signal SCS, the second control signal ECS, the third control signal DCS, and the fourth control signal PCS based on an input image data IRGB, a synchronization signal Sync (for example, a vertical synchronization signal, a horizontal synchronization signal, and the like), a data enable signal DE, and a clock signal. The first control signal SCS and the second control signal ECS may be supplied to the gate driver GDC, the third control signal DCS may be supplied to the data driver DDC, and the fourth control signal PCS may be supplied to the power supply PWS. The timing controller TC may generate the image data RGB (or frame data) by rearranging the input image data IRGB in correspondence with the arrangement of the pixels PXij in the display panel DP.

The gate driver GDC, the data driver DDC, the power supply PWS, and/or the timing controller TC may be formed directly on the display panel DP or provided in the form of separate driving chips to be connected to the display panel DP. Furthermore, at least two of the gate driver GDC, the data driver DDC, the power supply PWS, and the timing controller TC may be provided as one driving chip. For example, the data driver DDC and the timing controller TC may be provided as one driving chip.

In the above description, the display device DD according to an embodiment has been described with reference to FIGS. 1 to 3, but the display device of the present disclosure is not limited thereto. For example, signal lines may be further added or omitted depending on a configuration of the pixel. Furthermore, a connection relationship between one pixel and the signal lines may be changed. When one of the signal lines is omitted, the omitted signal line may be replaced by another signal line.

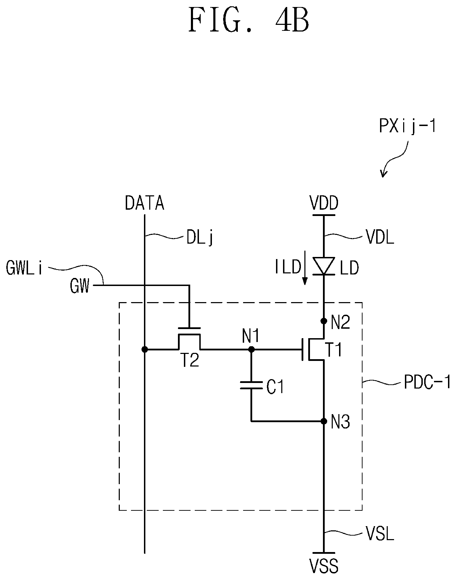

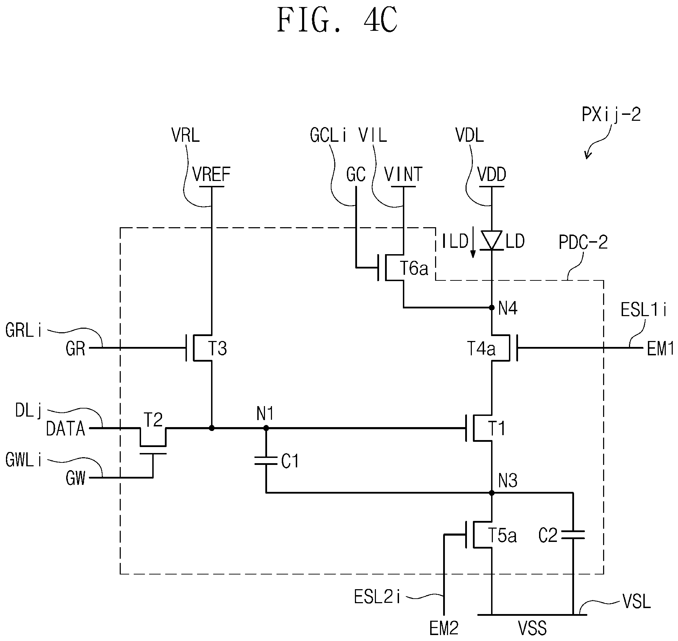

FIGS. 4A, 4B, and 4C are equivalent circuit diagrams of a pixel according to an embodiment of the present disclosure. FIGS. 4A, 4B, and 4C illustrate equivalent circuit diagrams of pixels PXij, PXij-1, and PXij-2 that are connected to an i-th first scan line GWLi (hereinafter, a first scan line) and a j-th data line DLj (hereinafter, a data line) by way of example.

As illustrated in FIG. 4A, the pixel PXij includes a light-emitting element LD and a pixel driver PDC. The light-emitting element LD is electrically connected to a first power source line VDL and a pixel driver PDC.

The pixel driver PDC may be connected to a plurality of scan lines GWLi, GCLi, GILi, GBLi, and GRLi, a data line DLj, a light emission line ESLi, and a plurality of power source voltage lines VDL, VSL, VIL1, VIL2, VRL, and VCL. The pixel driver PDC may include first to eighth transistors T1, T2, T3, T4, T5, T6, T7, and T8, a first capacitor C1, and a second capacitor C2. Hereinafter, a case in which all of the first to eighth transistors T1, T2, T3, T4, T5, T6, T7 and T8 is of an N-type, will be described as an example. However, the present disclosure is not limited thereto, and some of the first to eighth transistors T1 to T8 may be N-type transistors, and the remaining ones may be P-type transistors, and each of the first to eighth transistors T1 to T8 may be a P-type transistor, and embodiments of the present disclosure are not limited thereto.

A gate of the first transistor T1 may be connected to a first node N1. A first electrode of the first transistor T1 may be connected to a second node N2, and a second electrode may be connected to a third node N3. The first transistor T1 may be a driving transistor. The first transistor T1 may control a driving current ILD that flows from the first power source line VDL to the second power source line VSL via the light-emitting element LD in response to the voltage of the first node N1. Then, the first power source voltage VDD may be set to a voltage having a higher potential than that of the second power source voltage VSS.

In the specification, "electrically connected between a transistor and a signal line or between a transistor and a transistor" means "a source, a drain, or a gate of a transistor having an integral shape with the signal line or being connected through a connection electrode."

The second transistor T2 may include a gate that is connected to the write scan line GWLi, a first electrode that is connected to the data line DLj, and a second electrode that is connected to the first node N1. The second transistor T2 may supply the data signal DATA to the first node N1 in response to the write scan signal GW transmitted through the write scan line GWLi. The second transistor T2 may be turned on when the write scan signal GW is supplied to the write scan line GWLi to electrically connect the data line DLj to the first node N1.

The third transistor T3 may be connected between the first node N1 and the reference voltage line VRL. A first electrode of the third transistor T3 may receive the reference voltage VREF through the reference voltage line VRL, and a second electrode of the third transistor T3 may be connected to the first node N1. In an embodiment, a gate of the third transistor T3 may receive a reset scan signal GR through an i-th fifth scan line GRLi (hereinafter, referred to as a reset scan line). When the reset scan signal GR is supplied to the reset scan line GRLi, the third transistor T3 may be turned on to provide the reference voltage VREF to the first node N1.

The fourth transistor T4 may be connected between the third node N3 and the first initialization voltage line VIL1. A first electrode of the fourth transistor T4 may be connected to the third node N3, and a second electrode of the fourth transistor T4 may be connected to the first initialization voltage line VIL1 that provides the first initialization voltage VINT1. The fourth transistor T4 may be referred to as a first initialization transistor. A gate of the fourth transistor T4 may receive the first initialization scan signal GI through the i-th third scan line GILi (hereinafter, referred to as a first initialization scan line). When the first initialization scan signal GI is supplied to the first initialization scan line GILi, the fourth transistor T4 may be turned on to supply the first initialization voltage VINT1 to the third node N3.

The fifth transistor T5 may be connected between the compensation voltage line VCL and the second node N2. A first electrode of the fifth transistor T5 may receive the compensation voltage VCOMP through the compensation voltage line VCL, and a second electrode of the fifth transistor T5 may be electrically connected to the second node N2 to be electrically connected to the first electrode of the first transistor T1. A gate of the fifth transistor T5 may receive the compensation scan signal GC through an i-th second scan line GCLi (hereinafter, a compensation scan line). When the compensation scan signal GC is supplied to the compensation scan line GCLi, the fifth transistor T5 may be turned on to provide the compensation voltage VCOMP to the second node N2, and a threshold voltage of the first transistor T1 may be compensated for during a compensation period.

The sixth transistor T6 may be connected between the first transistor T1 and the light-emitting element LD. For example, a gate of the sixth transistor T6 may receive a light emission signal EM through an i-th light emission line ESLi (hereinafter, referred to as a light emission line). A first electrode of the sixth transistor T6 may be connected to a cathode of the light-emitting element LD through the fourth node N4, and a second electrode of the sixth transistor T6 may be connected to the first electrode of the first transistor T1 through the second node N2. The sixth transistor T6 may be referred to as a first light emission control transistor. When the light emission signal EM is supplied to the light emission line ESLi, the sixth transistor T6 may be turned on to electrically connect the light-emitting element LD to the first transistor T1.

The seventh transistor T7 may be connected between the second power source line VSL and the third node N3. A first electrode of the seventh transistor T7 may be connected to the second electrode of the first transistor T1 through the third node N3, and a second electrode of the seventh transistor T7 may receive the second power source voltage VSS through the second power source line VSL. A gate of the seventh transistor T7 may be electrically connected to the light emission line ESLi. The seventh transistor T7 may be referred to as a second light emission control transistor. When the light emission signal EM is supplied to the light emission line ESLi, the seventh transistor T7 is turned on to electrically connect the second electrode of the first transistor T1 to the second power source line VSL.

In an embodiment, it is illustrated that the sixth transistor T6 and the seventh transistor T7 are connected to the same light emission line ESLi and are turned on through the same light emission signal EM, but this is illustrated as an example, and embodiments are not limited thereto. For example, in an embodiment, the sixth transistor T6 and the seventh transistor T7 may be turned on independently by different signals that are distinguished from each other. Furthermore, in the pixel driver PDC according to an embodiment of the present disclosure, any one of the sixth transistor T6 and the seventh transistor T7 may be omitted.

The eighth transistor T8 may be connected between the second initialization voltage line VIL2 and the fourth node N4. That is, the eighth transistor T8 may include a gate that is connected to the i-th fourth scan line GBLi (hereinafter, referred to as a second initialization scan line), a first electrode that is connected to the second initialization voltage line VIL2, and a second electrode that is connected to the fourth node N4. The eighth transistor T8 may be referred to as a second initialization transistor. The eighth transistor T8 may supply the second initialization voltage VINT2 to the fourth node N4 corresponding to the cathode of the light-emitting element LD in response to the second initialization scan signal GB transmitted through the second initialization scan line GBLi. The cathode of the light-emitting element LD may be initialized by the second initialization voltage VINT2.

In an embodiment, some of the second to eighth transistors T2, T3, T4, T5, T6, T7, and T8 may be simultaneously turned on through the same scan signal. For example, the eighth transistor T8 and the fifth transistor T5 may be simultaneously turned on through the same scan signal. For example, the eighth transistor T8 and the fifth transistor T5 may be operated by the same compensation scan signal GC. The eighth transistor T8 and the fifth transistor T5 may be simultaneously turned on/off by the same compensation scan signal GC. In this case, the compensation scan line GCLi and the second initialization scan line GBLi may be provided substantially as a single scan line. Accordingly, the initialization of the cathode of the light-emitting element LD and the compensation of the threshold voltage of the first transistor T1 may be performed at the same timing. However, this is illustrated as an example, and embodiments of the present disclosure are not limited thereto.

Furthermore, according to an embodiment of the present disclosure, the initialization of the cathode of the light-emitting element LD and the compensation for the threshold voltage of the first transistor T1 may be performed by the application of the same power source voltage. For example, the compensation voltage line VCL and the second initialization voltage line VIL2 may be provided as a substantially single power source voltage line. In this case, the cathode initialization operation and the compensation operation of the driving transistor may be performed with one power source voltage, and thus, design of the drivers may be simplified. However, this is illustrated as an example, and embodiments of the present disclosure are not limited thereto.

The first capacitor C1 may be disposed between the first node N1 and the third node N3. The first capacitor C1 may store a differential voltage between the first node N1 and the third node N3. The first capacitor C1 may be referred to as a storage capacitor.

The second capacitor C2 may be disposed between the third node N3 and the second power source line VSL. That is, one electrode of the second capacitor C2 may be connected to the second power source line VSL supplied with the second power source voltage VSS, and the other electrode of the second capacitor C2 may be connected to the third node N3. The second capacitor C2 may store electric charges corresponding to a voltage difference between the second power source voltage VSS and the third node N3. The second capacitor C2 may be referred to as a hold capacitor. The second capacitor C2 may have a higher storage capacity than the first capacitor C1. Accordingly, the second capacitor C2 may minimize or reduce the voltage change of the third node N3 in response to the voltage change of the first node N1.

In an embodiment, the light-emitting element LD may be connected to the pixel driver PDC through the fourth node N4. The light-emitting element LD may include an anode that is connected to the first power source line VDL and a cathode that is opposite thereto. In an embodiment, the light-emitting element LD may be connected to the pixel driver PDC through the cathode. That is, in the pixel PXij according to an embodiment, the connection node, to which the light-emitting element LD and the pixel driver PDC are connected, may be the fourth node N4, and the fourth node N4 may correspond to the connection node between the first electrode of the sixth transistor T6 and the cathode of the light-emitting element LD. Accordingly, a potential of the fourth node N4 may substantially correspond to a potential of the cathode of the light-emitting element LD.

For example, the anode of the light-emitting element LD may be connected to a first power source line VDL to apply a first power source voltage VDD that is a constant voltage, and the cathode thereof may be connected to the first transistor T1 through the sixth transistor T6. That is, in an embodiment in which the first to eighth transistors T1 to T8 are N-type transistors, a potential of the third node N3 corresponding to the source of the first transistor T1 that is a driving transistor may not be directly affected by the characteristics of the light-emitting element LD. Accordingly, even when the light-emitting element LD deteriorates, an influence on the transistors that constitute the pixel driver PDC, for example, the gate-source voltage Vgs of the driving transistor, may be reduced. That is, because an amount of change in the driving current due to the deterioration of the light-emitting element LD may be reduced, afterimage defects of the display panel according to an increase in a usage time may be reduced and a lifespan thereof may be improved.

In an embodiment, as illustrated in FIG. 4B, the pixel PXij-1 may include a pixel driver PDC-1 including two transistors T1 and T2 and one first capacitor C1. The pixel driver PDC-1 may be connected to a light-emitting element LD, a write scan line GWLi, a data line DLj, and a second power source line VSL. The pixel driver PDC-1 illustrated in FIG. 4B may correspond to the omission of the third to eighth transistors T3 to T8 and the second capacitor C2 from the pixel driver PDC illustrated in FIG. 4A.

Each of the first and second transistors T1 and T2 may be of an N-type or a P-type. In an embodiment, a case in which each of the first and second transistors T1 and T2 is an N-type transistor, will be described by way of example.

The first transistor T1 may include a gate that is connected to the first node N1, a first electrode that is connected to the second node N2, and a second electrode that is connected to the third node N3. The second node N2 may be a node that is electrically connected to the first power source line VDL, and the third node N3 may be a node that is connected to the second power source line VSL. The first transistor T1 is connected to the light-emitting element LD through the second node N2, and is connected to the second power source line VSL through the third node N3. The first transistor T1 may be a driving transistor.

The second transistor T2 may include a gate that receives the write scan signal GW through the write scan line GWLi, a first electrode that is connected to the data line DLj, and a second electrode that is connected to the first node N1. The second transistor T2 may supply the data signal DATA to the first node N1 in response to the write scan signal GW transmitted through the write scan line GWLi.

The first capacitor C1 may include an electrode that is connected to the first node N1 and an electrode that is connected to the third node N3. The first capacitor C1 may store the data signal DATA transmitted to the first node N1.

The light-emitting element LD may include an anode and a cathode. In an embodiment, the anode of the light-emitting element LD is connected to the first power source line VDL, and the cathode is connected to the pixel driver PDC-1 through the second node N2. In an embodiment, the cathode of the light-emitting element LD may be connected to the first transistor T1. The light-emitting element LD may emit light corresponding to the amount of current that flows through the first transistor T1 of the pixel driver PDC-1.

In an embodiment in which the first and second transistors T1 and T2 are N-type transistors, the second node N2, to which the cathode of the light-emitting element LD and the pixel driver PDC-1 are electrically connected, may correspond to a drain of the first transistor T1. That is, a change in the gate-source voltage Vgs of the first transistor T1 due to the light-emitting element LD may be prevented or reduced. Accordingly, because an amount of change in the driving current due to the deterioration of the light-emitting element LD may be reduced, afterimage defects of the display panel according to an increase in a usage time may be reduced and a lifespan thereof may be improved.

In an embodiment, as illustrated in FIG. 4C, the pixel PXij-2 may include a pixel driver PDC-2 including six transistors T1, T2, T3, T4a, T5a, and T6a and two capacitors C1 and C2.

The pixel driver PDC-2 may be connected to the light-emitting element LD, the write scan line GWLi, the reset scan line GRLi, the compensation scan line GCLi, the i-th first light emission line ESL1i (hereinafter referred to as a first light emission line), the i-th second light emission line ESL2i (hereinafter referred to as a second light emission line), the data line DLj, the first power source line VDL, the second power source line VSL, the third power source line VRL, and the initialization voltage line VIL.

The pixel driver PDC-2 illustrated in FIG. 4C may be similar to a structure in which the fourth and fifth transistors T4 and T5 are omitted from the pixel driver PDC illustrated in FIG. 4A. Because the size of the pixel driver PDC-2 illustrated in FIG. 4C is smaller than the size of the pixel driver PDC-1 illustrated in FIG. 4A, a high resolution may be implemented more easily.

Each of the first to sixth transistors T1, T2, T3, T4a, T5a, and T6a may be of an N-type or a P-type. In an embodiment, a case in which each of the first to sixth transistors T1, T2, T3, T4a, T5a, and T6a is an N-type transistor, will be described by way of example.

The first transistor T1 may include a gate that is connected to the first node N1, a first electrode that is connected to the second node N2, and a second electrode that is connected to the third node N3. The second node N2 may be a node that is electrically connected to the first power source line VDL, and the third node N3 may be a node that is connected to the second power source line VSL. The first transistor T1 is connected to the light-emitting element LD through the second node N2, and is connected to the second power source line VSL through the third node N3. The first transistor T1 may be a driving transistor.

The second transistor T2 may include a gate that receives the write scan signal GW through the write scan line GWLi, a first electrode that is connected to the data line DLj, and a second electrode that is connected to the first node N1. The second transistor T2 may supply the data signal DATA to the first node N1 in response to the write scan signal GW transmitted through the write scan line GWLi.

The third transistor T3 may be connected between the first node N1 and the reference voltage line VRL. A first electrode of the third transistor T3 may receive the reference voltage VREF through the reference voltage line VRL, and a second electrode of the third transistor T3 may be connected to the first node N1. In an embodiment, a gate of the third transistor T3 may receive a reset scan signal GR through a reset scan line GRLi. When the reset scan signal GR is supplied to the reset scan line GRLi, the third transistor T3 may be turned on to provide the reference voltage VREF to the first node N1.

The fourth transistor T4a may be connected between the first transistor T1 and the light-emitting element LD. For example, the gate of the fourth transistor T4a may receive the first light emission signal EM1 through the first light emission line ESL1i. The first electrode of the fourth transistor T4a may be connected to the cathode of the light-emitting element LD through the fourth node N4, and the second electrode of the fourth transistor T4a may be connected to the first electrode of the first transistor T1 through the second node N2. The fourth transistor T4a may be referred to as a first light emission control transistor. When the first light emission signal EM1 is supplied to the first light emission line ESL1i, the fourth transistor T4a may be turned on to electrically connect the light-emitting element LD and the first transistor T1.

The fifth transistor T5a may be connected between the second power source line VSL and the third node N3. A first electrode of the fifth transistor T5a may be connected to the second electrode of the first transistor T1 through the third node N3, and a second electrode of the fifth transistor T5a may receive the second power source voltage VSS through the second power source line VSL. A gate of the fifth transistor T5a may be electrically connected to the second light emission line ESL2i. The fifth transistor T5a may be referred to as a second light emission control transistor. When the second light emission signal EM2 is supplied to the second light emission line ESL2i, the fifth transistor T5a is turned on to electrically connect the second electrode of the first transistor T1 to the second power source line VSL.

In an embodiment, the fourth transistor T4a and the fifth transistor T5a may be connected to the first and second light emission lines ESL1i and ESL2i that are distinguished from each other, and may be turned on through the first and second light emission signals EM1 and EM2 that are distinguished from each other. That is, the fourth transistor T4a and the fifth transistor T5a may be turned on independently of each other. However, this is only an example and the present disclosure is not limited thereto. For example, in an embodiment of the present disclosure, the fourth transistor T4a and the fifth transistor T5a may be connected to the same light emission line, and may be controlled by the same light emission signal. Furthermore, in the pixel driver PDC-2 according to an embodiment of the present disclosure, any one of the fourth transistor T4a and the fifth transistor T5a may be omitted.

The sixth transistor T6a may be connected between the initialization voltage line VIL and the fourth node N4. That is, the sixth transistor T6a may include a gate that is connected to the compensation scan line GCLi, a first electrode that is connected to the initialization voltage line VIL, and a second electrode that is connected to the fourth node N4. The sixth transistor T6a may be referred to as an initialization transistor. The sixth transistor T6a may supply the initialization voltage VINT to the fourth node N4 corresponding to the cathode of the light-emitting element LD in response to the compensation scan signal GC transmitted through the compensation scan line GCLi. The cathode of the light-emitting element LD may be initialized by the initialization voltage VINT.

The first capacitor C1 may be disposed between the first node N1 and the third node N3. The first capacitor C1 may store a differential voltage between the first node N1 and the third node N3. The first capacitor C1 may be referred to as a storage capacitor.

The second capacitor C2 may be disposed between the third node N3 and the second power source line VSL. That is, one electrode of the second capacitor C2 may be connected to the second power source line VSL supplied with the second power source voltage VSS, and the other electrode of the second capacitor C2 may be connected to the third node N3. The second capacitor C2 may store electric charges corresponding to a voltage difference between the second power source voltage VSS and the third node N3. The second capacitor C2 may be referred to as a hold capacitor.

The light-emitting element LD may include an anode and a cathode. In an embodiment, the anode of the light-emitting element LD is connected to the first power source line VDL, and the cathode is connected to the pixel driver PDC-2 through the fourth node N4. In an embodiment, the cathode of the light-emitting element LD may be connected to the first transistor T1 through the fourth transistor T4a. The light-emitting element LD may emit light corresponding to the amount of current that flows through the first transistor T1 of the pixel driver PDC-2.

That is, in an embodiment in which the first to sixth transistors T1, T2, T3, T4a, T5a, and T6a are N-type transistors, a potential of the third node N3 corresponding to the source of the first transistor T1 that is a driving transistor may not be directly affected by the characteristics of the light-emitting element LD. Accordingly, even when the light-emitting element LD deteriorates, an influence on the transistors that constitute the pixel driver PDC-2, for example, the gate-source voltage Vgs of the driving transistor may be reduced. That is, because an amount of change in the driving current due to the deterioration of the light-emitting element LD may be reduced, afterimage defects of the display panel according to an increase in a usage time may be reduced and a lifespan thereof may be improved.

FIGS. 4A, 4B, and 4C illustrate a circuit for pixel drivers PDC, PDC-1, and PDC-2 according to embodiments of the present disclosure, and when the display panel according to an embodiment of the present disclosure is a circuit that is connected to the cathode of a light-emitting element LD, the number or arrangement relationship of the transistors and the number or arrangement relationship of the capacitors may be designed variously, and embodiments of the present disclosure are not limited thereto.

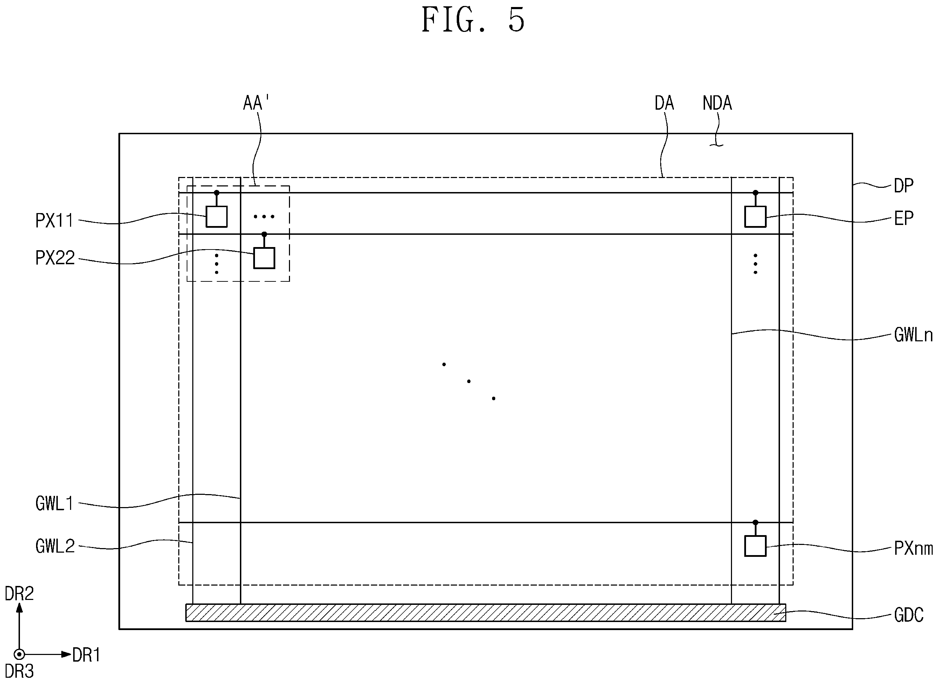

FIG. 5 is a plan view schematically illustrating a display panel according to an embodiment of the present disclosure. In FIG. 5, some components are omitted for convenience of explanation.

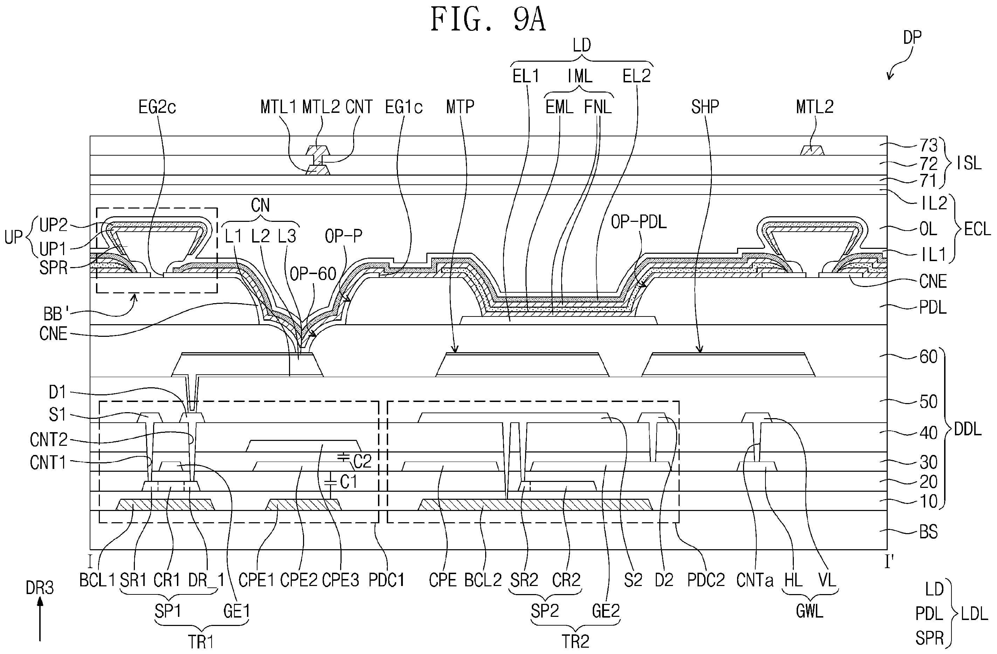

Referring to FIG. 5, the display panel DP may be divided into a display area DA and a non-display area NDA. The display area DA may include a plurality of light-emission parts EP. The light-emission parts EP may be areas in which light is emitted by the pixels PXij (see FIG. 3), respectively. For example, each of the light-emission parts EP may correspond to a light emission opening OP-PDL (see FIG. 9A) that is to be described below.

The non-display area NDA may be disposed adjacent to the display area DA. In an embodiment, the non-display area NDA is illustrated in a shape surrounding a periphery of the display area DA. However, this is illustrated as an example, and the non-display area NDA may be disposed on one side of the display area DA or may be omitted, and embodiments of the present disclosure are not limited thereto.

In an embodiment, the data driver DDC (see FIG. 3) may be provided in the form of a separate driving chip that is independent from the display panel DP, and may be connected to the display panel DP. However, this is described by way of example, and the data driver DDC may be formed in the same process as that of the gate driver GDC to form the display panel DP, and embodiments of the present disclosure are not limited thereto. The data driver DDC may be disposed adjacent to the same area as the gate driver GDC, that is, a lower portion of the display panel DP.

The display panel DP may have a shape of which a length corresponding to the first direction DR1 is greater than a length corresponding to the second direction DR2. It is illustrated by way of example that a plurality of pixels PX11 to PXnm arranged in n rows and m columns are disposed on the display area DA. In an embodiment, the display panel DP may include a gate driver GDC that is disposed adjacent to a lower end of the display panel DP. The gate driver GDC may extend in the first direction DR1.

For example, among scan lines GWL1 to GWLn, GCL1 to GCLn, GCL1 to GCLn, GIL1 to GILn, GBL1 to GBLn, GRL1 to GRLn (see FIG. 3), the write scan lines GWL1 to GWLn are illustrated in FIG. 5. The gate driver GDC may be connected to the write scan lines GWL1 to GWLn. However, the present disclosure is not limited thereto, and two gate drivers GDC may be provided. One of the two gate drivers GDC may be connected to some of the write scan lines GWL1 to GWLn, and the other of the two gate drivers GDC may be connected to others of the write scan lines GWL1 to GWLn. For example, one of the two gate drivers GDC may be connected to odd-numbered scan lines of the write scan lines GWL1 to GWLn, and the other of the two gate drivers GDC may be connected to even-numbered scan lines of the write scan lines GWL1 to GWLn.

In an embodiment, the gate driver GDC may be disposed in the non-display area NDA. However, the present disclosure is not limited thereto, and the gate driver GDC may overlap at least some of the plurality of light-emission parts EP disposed in the display area DA on a plane. As the gate driver GDC is disposed in the display area DA, the extent of the non-display area NDA may be decreased compared to a conventional display panel disposed in the non-display area, and the display device DD (see FIG. 1) having a thin bezel may be easily implemented.

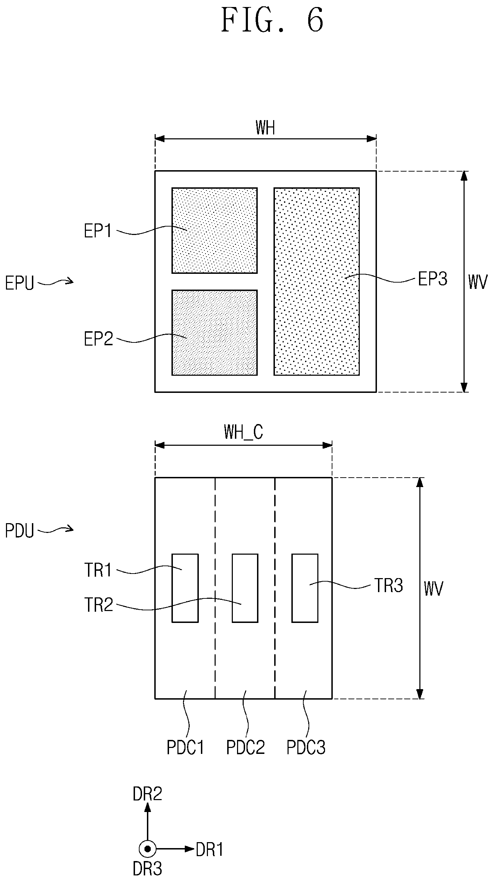

FIG. 6 is a plan view illustrating a light emission unit and a pixel driving unit connected thereto according to an embodiment of the present disclosure.

Referring to FIG. 6, in the light emission unit EPU, the first light-emission part EP1 and the second light-emission part EP2 are arranged in a direction that is parallel to the second direction DR2, and the third light-emission part EP3 is arranged at a position in the first direction DR1 with respect to each of the first light-emission part EP1 and the second light-emission part EP2. In an embodiment, the third light-emission part EP3 is illustrated as overlapping each of the first light-emission part EP1 and the second light-emission part EP2 when viewed from the first direction DR1. The shape or arrangement of the first to third light-emission parts EP1, EP2, and EP3 or the number of light-emission parts that constitute the light emission unit EPU may be variously selected, and embodiments of the present disclosure are not limited thereto. For example, the third light-emission part EP3 may include two sub-light-emission parts that are spaced apart from each other in the second direction DR2.

The pixel driving unit PDU may include first to third pixel drivers PDC 1, PDC2, and PDC3 that drive the first to third light-emission parts EP1, EP2 and EP3, respectively. The first to third pixel drivers PDC1, PDC2, and PDC3 may be arranged along the first direction DR1. The first to third pixel drivers PDC1, PDC2, and PDC3 include first to third connection transistors TR1, TR2, and TR3 that are electrically connected to the first to third light-emission parts EP1, EP2, and EP3, respectively. Each of the first to third connection transistors TR1, TR2, and TR3 may be a driving transistor (or a first transistor), but the present disclosure is not limited thereto.

A width WH of one light emission unit EPU in the first direction DR1 may be greater than a width WH_C of one pixel driving unit PDU corresponding thereto in the first direction DR1. For convenience of explanation, a length WV of the light emission unit EPU in the second direction DR2 and a length WV of the pixel driving unit PDU in the second direction DR2 are the same, but the present disclosure is not limited thereto. According to an embodiment, by designing the width WH_C of the pixel driving unit PDU to be smaller than the width WH of the light emission unit EPU, a display area DA (FIG. 2B) having a size that is smaller than that occupied by the driving element layer DDL (see FIG. 2B) may be provided. Accordingly, the display panel DP having a narrow bezel may be provided.

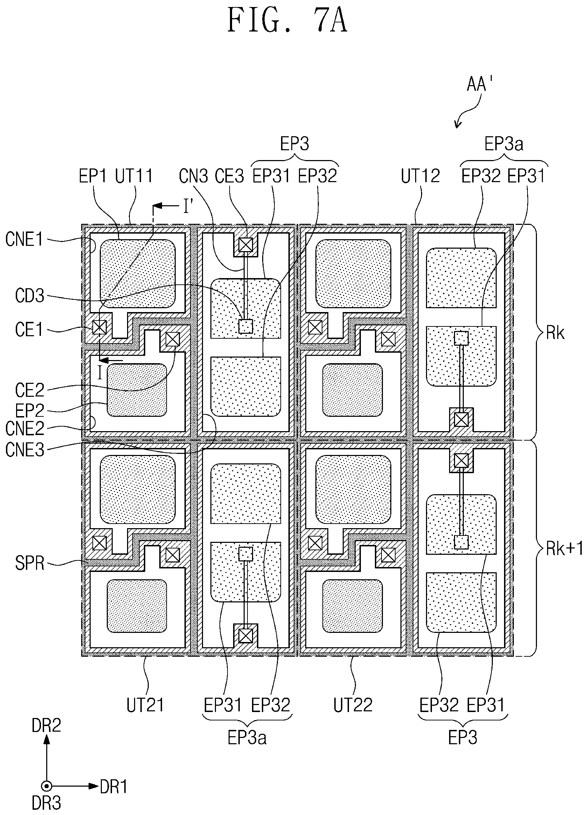

FIGS. 7A to 7D are enlarged plan views of a partial area of a display panel according to an embodiment of the present disclosure. For example, FIG. 7A is an enlarged view of area AA' illustrated in FIG. 5.

In FIG. 7A, light emission units UT11, UT12, UT21, and UT22 in the second row and the second column are illustrated by way of example. Referring to FIG. 7A, the first row light-emission parts Rk include light-emission parts that constitute the first row first column light emission unit UT11 and the first row second column light emission unit UT12, and the second row light-emission parts Rk+1 include light-emission parts that constitute the second row and first column light emission unit UT21 and the second row second column light emission unit UT22. One of the light emission units UT11, UT12, UT21, and UT22 may correspond to the light emission unit EPU described with reference to FIG. 6.

The light-emission parts EP1, EP2, and EP3 may correspond to the light-emission parts EP1, EP2, and EP3 described with reference to FIG. 6. That is, each of the light-emission parts EP1, EP2, and EP3 may be an area in which light is emitted by the above-described light-emitting element. The light-emission parts EP1, EP2, and EP3 may correspond to a unit that constitute an image displayed on the display panel DP (see FIG. 2A). For example, each of the light-emission parts EP1, EP2, and EP3 may correspond to an area defined by a lower surface of a light emission opening OP-PDL (see FIG. 9A) that will be described below.

The light-emission parts EP1, EP2, and EP3 may include a first light-emission part EP1, a second light-emission part EP2, and a third light-emission part EP3. The first light-emission part EP1, the second light-emission part EP2, and the third light-emission part EP3 may emit different colors of light. For example, the first light-emission part EP1 may emit red light, the second light-emission part EP2 may emit green light, and the third light-emission part EP3 may emit blue light, but a combination of colors is not limited thereto. Furthermore, at least two of the first to third light-emission parts EP1, EP2, and EP3 may emit light of the same color. For example, the first to third light-emission parts EP1, EP2, and EP3 may emit blue light, or all of them may emit white light.

The third light-emission part EP3 that displays the light emitted by, among the first to third light-emission parts EP1, EP2, and EP3, the third light-emitting element, may include two sub-light-emission parts EP31 and EP32 that are spaced apart from each other in the second direction DR2. However, this is illustrated as an example, and the third light-emission part EP3 may be provided as one pattern having a single shape like the first and second light-emission parts EP1 and EP2, and at least one of the first and second light-emission parts EP1 and EP2 may include sub-light-emission parts that are spaced apart from each other, and embodiments of the present disclosure are not limited thereto.

The first row light-emission parts Rk may include first to third light-emission parts EP1, EP2, and EP3 that constitute the first row first column light emission unit UT11 and first to third light-emission parts EP1, EP2, and EP3 that constitute the first row second column light emission unit UT12, and the second row light-emission parts Rk+1 may include first to third light-emission parts EP1, EP2, and EP3a that constitute the second row first column light emission unit UT21 and first to third light-emission parts EP1, EP2, and EP3 that constitute the second row second column light emission unit UT22.

In an embodiment of the present disclosure, the shapes of the light-emission parts that constitute the first row first column light emission unit UT11 and the light-emission parts that constitute the second row second column light emission unit UT22 may be substantially the same. Furthermore, the shapes of the light-emission parts that constitute the first row second column light emission unit UT12 and the light-emission parts that constitute the second row first column light emission unit UT21 may be substantially the same. The shapes of the light-emission parts that constitute the first row first column light emission unit UT11 may be different from the shapes of the light-emission parts that constitute the first row second column light emission unit UT12. For example, some of the first row light-emission parts Rk and some of the second column light-emission parts Rk+1 may have a symmetrical shape.

In an embodiment of the present disclosure, the third light-emission part EP3a of the second row first column light emission unit UT21 and the third light-emission part EP3 of the first row first column light emission unit UT11 may have a linearly symmetrical shape and arrangement with respect to an axis that is parallel to the first direction DR1, and the third light-emission part EP3 of the second row second column light emission unit UT22 and the third light-emission part EP3a of the first row second column light emission unit UT12 may have a linearly symmetrical shape and arrangement with respect to an axis that is parallel to the first direction DR1. However, this is an example, and embodiments of the present disclosure are not limited thereto.

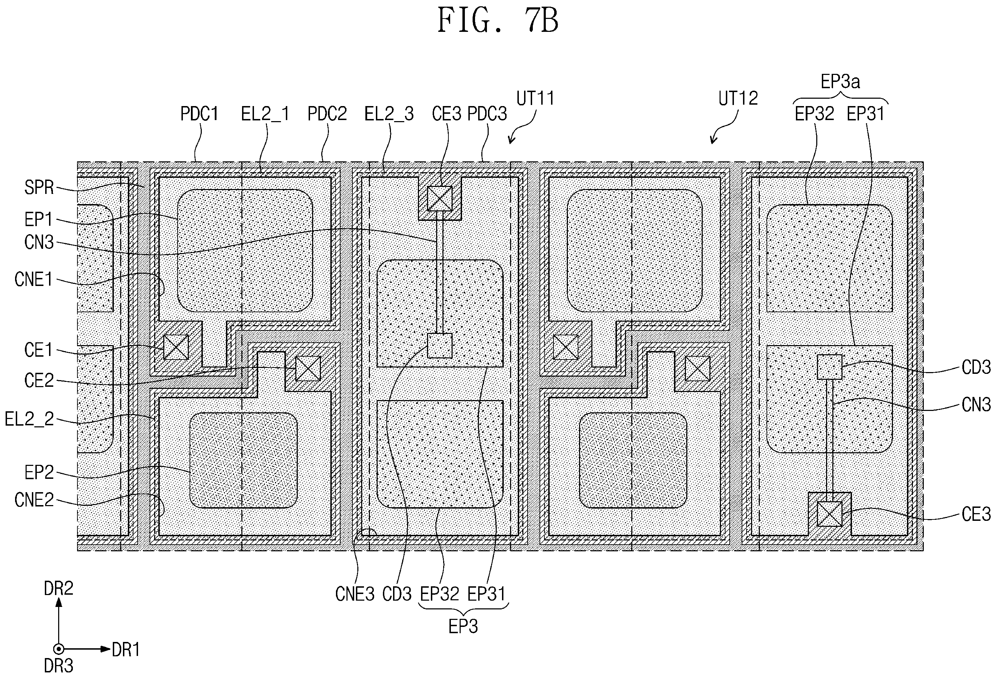

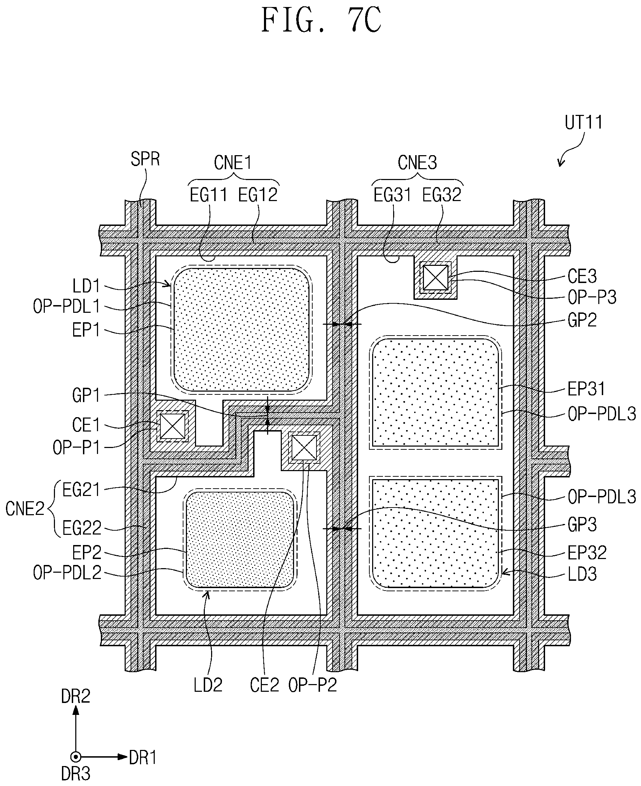

In FIG. 7B, light-emission parts arranged in one row are illustrated. In FIG. 7B, for convenience of explanation, a plurality of second electrodes EL2_1, EL2_2, and EL2_3, a plurality of pixel drivers PDC1, PDC2, and PDC3, first to third connection electrodes CNE1, CNE2, and CNE3 and a separator SPR are illustrated. In FIG. 7C, among the components of the display panel, a separator SPR, a plurality of light-emission parts EP1, EP2, and EP3 that are disposed in areas divided by the separator SPR, and a plurality of connection electrodes CNE1, CNE2, and CNE3 are illustrated.

Referring to FIGS. 7B and 7C, the second electrodes EL2_1, EL2_2, and EL2_3 may be electrically disconnected from each other by the separator SPR. In an embodiment, one light emission unit UT11 may include three light-emission parts EP1, EP2, and EP3. Accordingly, the light emission unit UT11 may include three second electrodes EL2_1, EL2_2, and EL2_3 (hereinafter, first to third cathodes), three pixel drivers PDC1, PDC2, and PDC3, and three connection electrodes CNE1, CNE2, and CNE3. However, this is illustrated by way of example, and the number and arrangement of the light-emission parts included in the light emission unit UT11 may be designed variously, and embodiments of the present disclosure are not limited thereto.

The first to third pixel drivers PDC1, PDC2, and PDC3 are electrically connected to the first to third light-emitting elements LD1, LD2, and LD3 including the first to third light-emitting parts EP1, EP2, and EP3, respectively. In the specification, "connected" may refer to a case of being electrically connected as well as a case of being physically in direct contact.

Furthermore, areas in which the first to third pixel drivers PDC1, PDC2, and PDC3 are defined on a plane as in FIG. 7B may correspond to a unit, in which transistors and capacitor elements that constitute the pixel driver PDC (see FIG. 4A) for driving the light-emitting element of the pixel are repeatedly arranged.

The first to third pixel drivers PDC1, PDC2, and PDC3 may be sequentially disposed along the first direction DR1. The disposition positions of the first to third pixel drivers PDC1, PDC2, and PDC3 may be independently designed regardless of the positions or shapes of the first to third light-emission parts EP1, EP2 and EP3.

For example, the first to third pixel drivers PDC1, PDC2, and PDC3 may be disposed at positions that are different from the areas divided and defined by the separator SPR, that is, the positions, in which the first to third cathodes EL2_1, EL2_2, and EL2_3 are disposed, or may be designed to have shapes that are different from the shapes of the first to third cathodes EL2_1, EL2_2, and EL2_3. In an embodiment, the first to third pixel drivers PDC_1, PDC2, and PDC3 may be designed to have shapes and sizes that are similar to the areas that are disposed to overlap the positions, in which the first to third light-emission parts EP1, EP2, and EP3 are present, and divided by the separator SPR, for example, the first to third cathodes EL2_1, EL2_2, and EL2_3.

In an embodiment, the first to third pixel drivers PDC1, PDC2, and PDC3 is illustrated as having a rectangular shape, the first to third light-emission parts EP1, EP2, and EP3 are arranged in a form that is different from that of a smaller size, and the first to third cathodes EL2_1, EL2_2, and EL2_3 are disposed at positions that overlap the first to third light-emission parts EP1, EP2, and EP3 and are illustrated as having an amorphous shape.

Accordingly, as illustrated in FIG. 7B, the first pixel driver PDC1 may be disposed at a position in which it partially overlaps the first light-emission part EP1, the second light-emission part EP2, and other adjacent light emission units. The second pixel driver PDC2 may be disposed at a position in which it overlaps the first light-emission part EP1, the second light-emission part EP2, and the third cathode EL2_3. The third pixel driver PDC3 may be disposed at a position in which it overlaps the third light-emission part EP3. This is illustrated by way of example, and the positions of the first to third pixel drivers PDC1, PDC2, and PDC3 may be designed in various shapes and arrangements that are independent from the first to third light-emission parts EP1, EP2, and EP3, and embodiments of the present disclosure are not limited thereto.

The light emission unit UT11 may include first to third connection electrodes CNE1, CNE2, and CNE3. The first connection electrode CNE1 may electrically connect the first light-emitting element LD1 that forms the first light-emitting part EP1 (or the first light-emitting part EP1 is defined) and the first pixel driver PDC1, and the second connection electrode CNE2 may electrically connect the second light-emitting element LD2 that forms the second light-emitting part EP2 and the second pixel driver PDC2, and the third connection electrode CNE3 may electrically connect the third light-emitting element LD3 that forms the third light-emitting part EP3 and the third pixel driver PDC3. Each of the first to third light-emitting elements LD1, LD2, and LD3 may include a first electrode EL1, an intermediate layer IML that is disposed on the first electrode EL1, and a second electrode EL2 that is disposed on the intermediate layer.

For example, the first to third connection electrodes CNE1, CNE2, and CNE3 may electrically connect the first to third cathodes EL2_1, EL2_2, and EL2_3 to the first to third pixel drivers PDC1, PDC2, and PDC3 in a one-to-one correspondence, respectively. For example, the first connection electrode CNE1 may be electrically connected to the first pixel driver PDC1 and the first cathode EL2_1, and the second connection electrode CNE2 may be electrically connected to the second pixel driver PDC2 and the second cathode EL2_2, and the third connection electrode CNE3 may be electrically connected to the third pixel driver PDC3 and the third cathode EL2_3.

Each of the first to third connection electrodes CNE1, CNE2, and CNE3 may be disposed on a pixel definition film PDL (see FIG. 9A) that is to be described below. The first to third connection electrodes CNE1, CNE2, and CNE3 may have ring shapes that surround the corresponding first to third light-emission parts EP1, EP2, and EP3. In an embodiment of the present disclosure, it is illustrated for example that each of the first to third connection electrodes CNE1, CNE2, and CNE3 has a ring shape of a closed line, but the present disclosure is not limited thereto. For example, at least some of the first to third connection electrodes CNE1, CNE2, and CNE3 may have an open ring shape, in which a portion thereof is cut off.

Because the first to third connection electrodes CNE1, CNE2, and CNE3 have a ring shape, a degree of freedom of a position in which the first to third connection electrodes CNE1, CNE2, and CNE3 are connected to the first to third pixel drivers PDC1, PDC2, and PDC3 may be improved. For example, the first connection electrode CNE1 may be connected to the first pixel driver PDC1 through the first connection part CE1, the second connection electrode CNE2 may be connected to the second pixel driver PDC2 through the second connection part CE2, and the third connection electrode CNE3 may be connected to the third pixel driver PDC3 through the connection line CN3. That is, connection lines that are additionally connected to the first and second connection electrodes CNE1 and CNE2 may be omitted.

One connection line CN3 may electrically connect the third pixel driver PDC3 to the third light-emitting element LD3 that constitutes the third light-emission part EP3. For example, the connection line CN3 may correspond to a node (the fourth node N4 of FIG. 4A, the second node N2 of FIG. 4B, or the fourth node N4 of FIG. 4C), at which the light-emitting element LD (see FIG. 4A) is connected to the pixel driver (PDC of FIG. 4A, PDC-1 of FIG. 4B, or PDC-2 of FIG. 4C).

The connection line CN3 may include a third connection part CE3 and a driving connection part CD3. The third connection part CE3 may be provided to one side of the connection line CN3, and the driving connection part CD3 may be provided to an opposite side of the connection line CN3.

The driving connection part CD3 may be a portion of the connection line CN3 which is connected to a pixel driver PDC3. In an embodiment, the driving connection part CD3 may be connected to one electrode of a transistor that constitutes the pixel driver PDC3. For example, the driving connection part CD3 may be connected to a drain of the sixth transistor T6 illustrated in FIG. 4A, a drain of the first transistor T1 illustrated in FIG. 4B, or a drain of the fourth transistor T4a illustrated in FIG. 4C. Accordingly, a position of the driving connection part CD3 may correspond to a position of the transistor that is physically connected to the connection line CN3 in the pixel driver. The third connection part CE3 may be a portion of the connection line CN3 which is connected to the third light-emitting element LD3. In an embodiment, the third connection part CE3 may be electrically connected to the third connection electrode CNE3.

The first connection electrode CNE1 may include a first edge EG11 that surrounds at least a portion of the first light-emission part EP1 and a second edge EG12 that surrounds the first edge EG11. The second connection electrode CNE2 may include a first edge EG21 that surrounds at least a portion of the second light-emission part EP2, and a second edge EG22 that surrounds the first edge EG21. The third connection electrode CNE3 may include a first edge EG31 that surrounds at least a portion of the third light-emission part EP3 and a second edge EG32 that surrounds the first edge EG31.

The first to third connection electrodes CNE1, CNE2, and CNE3 may be arranged to be spaced apart from each other. For example, gaps GP1, GP2, and GP3 between a plurality of connection electrodes that are adjacent to each other, among the first to third connection electrodes CNE1, CNE2, and CNE3, may overlap the separator SPR. For example, the first edges EG11, EG21, and EG31 of the first to third connection electrodes CNE1, CNE2, and CNE3 are not covered by the separator SPR, and the second edges EG12, EG22, and EG32 of the first to third connection electrodes CNE1, CNE2, and CNE3 may overlap the separator SPR. In an embodiment, the second edges EG12, EG22, and EG32 of the first to third connection electrodes CNE1, CNE2, and CNE3 may be covered by the separator SPR.

In an embodiment of the present disclosure, the first to third connection parts CE1, CE2, and CE3 may be disposed at positions in which they do not overlap the first to third light-emission parts EP1, EP2, and EP3 on a plane. For example, in the pixel definition film PDL, a light emission opening OP-PDL (see FIG. 9A) and through-holes OP-P (see FIG. 9A) that are spaced apart from the light emission opening OP-PDL may be defined.

The through-holes OP-P may include a first through-hole OP-P1, a second through-hole OP-P2, and a third through-hole OP-P3. The first to third connection parts CE1, CE2, and CE3 may be arranged in correspondence with the first to third through-holes OP-P1, OP-P2, and OP-P3, respectively. The light emission opening OP-PDL may include a first light emission opening OP-PDL1, a second light emission opening OP-PDL2, and a third light emission opening OP-PLD3. The first to third light-emission parts EP1, EP2, and EP3 may be defined in correspondence with the first to third light emission openings OP-PDL1, OP-PDL2, and OP-PDL3, respectively. Accordingly, the first to third connection parts CE1, CE2, and CE3 may be disposed at positions in which they are spaced apart from the first to third light-emission parts EP1, EP2, and EP3.

The first to third connection electrodes CNE1, CNE2, and CNE3 may be disposed on the pixel definition film PDL (see FIG. 9A). When viewed on a plane, the first connection electrode CNE1 may surround the first light emission opening OP-PDL1, the second connection electrode CNE2 may surround the second light emission opening OP-PDL2, and the third connection electrode CNE3 may surround the third light emission opening OP-PDL3.

According to an embodiment of the present disclosure, the driving connection part CD3 that is at a position in which the connection line CN3 is connected to the transistor TR1 (see FIG. 9A) of the third pixel driver PDC3, may be defined at a position in which it does not overlap the third connection part CE3 on a plane and may be disposed at a position in which it overlaps the third light-emission part EP3. By electrically connecting the third cathode EL2_3 and the pixel driver PDC3 through the connection line CN3, restrictions due to the position or shape of the third light-emission part EP3 in the design of the pixel driver PDC3 may be reduced, and thus, a degree of freedom of design may be improved.

The first to third cathodes EL2_1, EL2_2, and EL2_3 may be electrically connected to the first to third connection electrodes CNE1, CNE2, and CNE3. For example, lower surfaces of the first to third cathodes EL2_1, EL2_2, and EL2_3 may be connected to (or contact) upper surfaces of the first to third connection electrodes CNE1, CNE2, and CNE3, respectively. Accordingly, a contact reliability (or a connection stability) of the first to third cathodes EL2_1, EL2_2, and EL2_3 and the first to third connection electrodes CNE1, CNE2, and CNE3 may be further improved.

Furthermore, connection areas, in which the first to third cathodes EL2_1, EL2_2, and EL2_3 and the first to third connection electrodes CNE1, CNE2, and CNE3 are connected to each other, may surround at least portions of the first to third light emission openings OP-PDL1, OP-PDL2, and OP-PDL3. The first to third cathodes EL2_1, EL2_2, and EL2_R and the first to third connection electrodes CNE1, CNE2, and CNE3 may be electrically connected in an area that is adjacent to the separator SPR, and each of the connection areas may be defined adjacent to the separator SPR. That is, the first to third cathodes EL2_1, EL2_2, and EL2_R and the first to third connection electrodes CNE1, CNE2, and CNE3 are not electrically connected to each other at a specific point, and may be electrically connected over a relatively wide area, for example, an area that is similar to a shape of each of the first to third connection electrodes CNE1, CNE2, and CNE3. That is, an extension of the connection area may be increased, and thus, the connection may be stably performed.

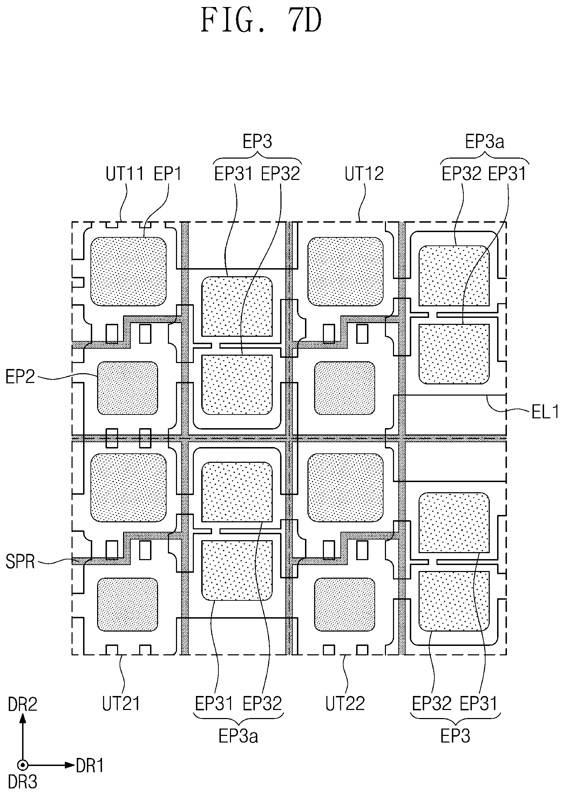

FIG. 7D illustrates the separator SPR, the light-emission parts EP1, EP2, and EP3, and the first electrode EL1.

Referring to FIG. 7D, the first electrode EL1 (hereinafter, referred to as an anode) of the light-emitting element LD (see FIG. 9A) according to an embodiment of the present disclosure may be provided in common to the first to third light-emission parts EP1, EP2, and EP3. That is, the anode EL1 may be formed as one overall integral layer of the display area DA, and thus, the anode EL1 may be disposed to overlap the separator SPR. In an embodiment, the anode EL1 of each of the light-emitting elements LD are formed in independent conductive patterns that are spaced apart from each other, and may be electrically connected to each other through different conductive layers, and thus, the patterns of the anodes EL1 may be disposed such that they do not overlap the separator SPR.

As described above, a first power source voltage VDD (see FIG. 4A) may be applied to the anode EL1, and a common voltage may be provided to all of the light-emission parts. The anode EL1 may be electrically connected to a first power source line VDL (see FIG. 4A) that provides a first power source voltage VDD in the non-display area NDA, or may be electrically connected to a first power source line VDL (see FIG. 4A) in the display area DA, and embodiments of the present disclosure are not limited thereto.

A plurality of openings may be defined in the anode EL1 according to an embodiment, and the openings may pass through the anode EL1 layer. The openings of the anode EL1 layer may be disposed at positions in which they do not overlap the light-emission parts EP (see FIG. 5), and may be generally defined in positions in which they overlap the separator SPR. The openings may facilitate the discharge of gas generated from an organic layer disposed under the anode EL1, for example, the sixth insulation layer 60 (see FIG. 9A). Accordingly, in a process of manufacturing the display panel, the gas of the organic layer disposed under the light-emitting element may be sufficiently discharged, and the gas discharged from the organic layer after the manufacturing may be decreased, and thus, a rate, at which the light-emitting element deteriorates, may be decreased.

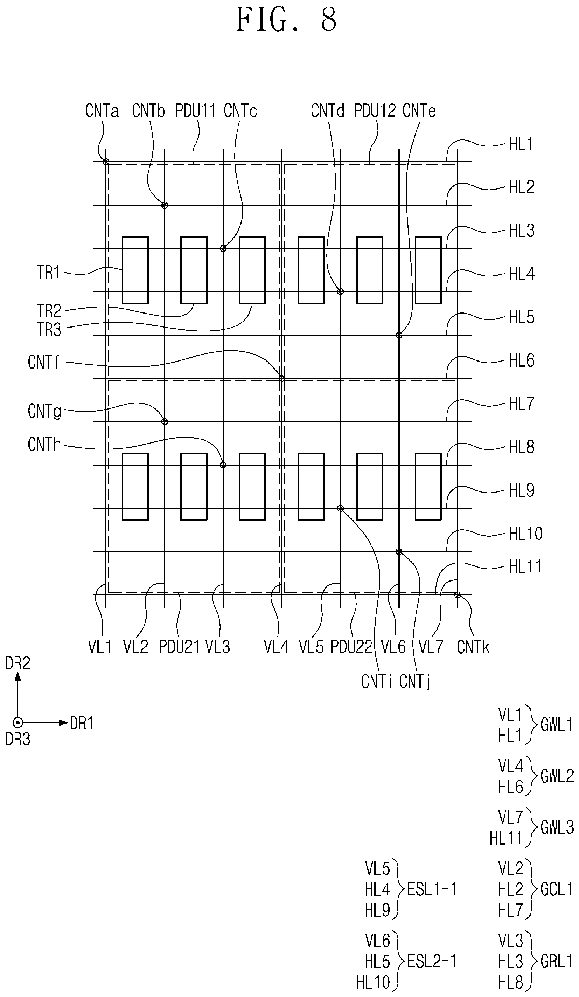

FIG. 8 is an enlarged plan view of a partial area of a display panel according to an embodiment of the present disclosure. FIG. 8 illustrates pixel driving units PDU11, PDU12, PDU21, and PDU22 corresponding to the light emission units UT11, UT12, UT21, and UT22 illustrated in FIG. 7A. One pixel driver, among the pixel driving units PDU11, PDU12, PDU21, and PDU22, may correspond to the pixel driving unit PDU illustrated in FIG. 6. Each of the pixel driving units PDU11, PDU12, PDU21, and PDU22 may include first to third connection transistors TR1, TR2, and TR3. For convenience of explanation, any description thereof that overlaps with the above description may be omitted.

Referring to FIG. 8, scan lines GWL1, GWL2, GWL3, and GRL1 and light emission lines ESL1-1 and ESL2-1 are illustrated. The scan lines GWL1, GWL2, GWL3, GCL1, and GRL1 are some of the scan lines GWL1 to GWLn, GCL1 to GCLn, and GRL1 to GRLn illustrated in FIG. 3, and the light emission lines ESL1-1 and ESL2-1 are some of the light emission lines ESL1 to ESLn.

According to an embodiment of the present disclosure, the first scan write line GWL1 may include a first vertical line (or a vertical line) VL1 that extends in the second direction DR2 and a first horizontal line (or a horizontal line) HL1 that extends in the first direction DR1. The first scan write line GWL1 may also be referred to as a scan line, the first vertical line VL1 may also be referred to as a first vertical scan line or a first vertical scan write line, and the first horizontal line HL1 may also be referred to as a first horizontal scan line or a first horizonal scan write line. The first vertical line VL1 and the first horizontal line HL1 may be disposed on different layers. The first vertical line VL1 and the first horizontal line HL1 may be connected to each other through a contact hole CNTa. The first horizontal line HL1 may receive a write scan signal GW (see FIG. 4A) from the first vertical line VL1 to supply it to the pixel driving units PDU11 and PDU12. The first horizontal line HL1 may supply the write scan signal GW to all of the pixel driving units disposed in the first row. That is, all of the pixel driving units disposed in the first row may receive the same write scan signal GW.

Similarly, the second scan write line GWL2 may include a fourth vertical line VL4 that extends in the second direction DR2 and a sixth horizontal line HL6 that extends in the first direction DR1. The fourth vertical line VL4 and the sixth horizontal line HL6 may be connected to each other through a contact hole CNTf. The sixth horizontal line HL6 may receive the write scan signal GW from the fourth vertical line VL4 to supply it to the second row pixel driving units PDU21 and PDU22. Furthermore, the third scan write line GWL3 may include a seventh vertical line VL7 that extends in the second direction DR2 and an eleventh horizontal line HL11 that extends in the first direction DR1. The seventh vertical line VL7 and the eleventh horizontal line HL11 may be connected to each other through a contact hole CNTk. The eleventh horizontal line HL11 may receive the write scan signal GW from the seventh vertical line VL7 to supply it to the third row pixel driving units.

A write scan signal GW supplied by the first horizontal line HL 1 to the first row pixel driving units PDU11 and PDU12 may be defined as a first write scan signal, a write scan signal GW supplied by the sixth horizontal line HL6 to the second row pixel driving units PDU21 and PDU22 may be defined as a second write scan signal, and a write scan signal GW supplied by the eleventh horizontal line HL11 to the second row pixel driving units may be defined as a third write scan signal. The first to third write scan signals may be different from each other. In an embodiment, the first to third write scan signals may have pulses of the same period.

According to an embodiment of the present disclosure, the first compensation scan line GCL1 may include a second vertical line VL2 that extends in the second direction DR2, and a second horizontal line HL2 and a seventh horizontal line HL7 that extend in the first direction DR1. The second vertical line VL2, the second horizontal line HL2, and the seventh horizontal line HL7 may be disposed on different layers. The second vertical line VL2 and the second horizontal line HL2 may be connected to each other through a contact hole CNTb, and the second vertical line VL2 and the seventh horizontal line HL7 may be connected to each other through a contact hole CNTg. The second horizontal line HL2 may receive a compensation scan signal GC (see FIG. 4a) from the second vertical line VL2 to supply it to the first row pixel driving units PDU11 and PDU12, and the seventh horizontal line HL7 may receive a compensation scan signal GC from the second vertical line VL2 to supply it to the second row pixel driving units PDU21 and PDU22. The second horizontal line HL2 may supply a compensation scan signal GC to all of the pixel driving units disposed in the first row, and the seventh horizontal line HL7 may supply a compensation scan signal GC to all of the pixel driving units disposed in the second row. That is, all of the pixel driving units disposed in the first row and all of the pixel driving units disposed in the second row may receive the same compensation scan signal GC.

According to an embodiment of the present disclosure, the first reset scan line GRL1 may include a third vertical line VL3 that extends in the second direction DR2, and a third horizontal line HL3 and an eighth horizontal line HL8 that extend in the first direction DR1. The third vertical line VL3, the third horizontal line HL3, and the eighth horizontal line HL8 may be disposed on different layers. The third vertical line VL3 and the third horizontal line HL3 may be connected to each other through a contact hole CNTc, and the third vertical line VL3 and the eighth horizontal line HL8 may be connected to each other through a contact hole CNTh. The third horizontal line HL3 may receive a reset scan signal GR (see FIG. 4a) from the third vertical line VL3 to supply it to the first row pixel driving units PDU11 and PDU12, and the eighth horizontal line HL8 may receive a reset scan signal GR from the third vertical line VL3 to supply it to the second row pixel driving units PDU21 and PDU22. The third horizontal line HL3 may supply the reset scan signals GR to all of the pixel driving units disposed in the first row, and the eighth horizontal line HL8 may supply the reset scan signals GR to all of the pixel driving units disposed in the second row. That is, all of the pixel driving units disposed in the first row and all of the pixel driving units disposed in the second row may receive the same reset scan signal GR.

According to an embodiment of the present disclosure, the (1-1)-th light emission line ESL1-1 may include a fifth vertical line VL5 (also referred to as a vertical light emission line) that extends in the second direction DR2, and a fourth horizontal line HL4 and a ninth horizontal line HL9 (also referred to as horizontal light emission lines) that extend in the first direction DR1. The fifth vertical line VL5, the fourth horizontal line HL4, and the ninth horizontal line HL9 may be disposed on different layers. The fifth vertical line VL5 and the fourth horizontal line HL4 may be connected to each other through a contact hole CNTd, and the fifth vertical line VL5 and the ninth horizontal line HL9 may be connected to each other through a contact hole CNTi. The fourth horizontal line HL4 may receive a first light emission signal EM1 (see FIG. 4A) from the fifth vertical line VL5 to supply it to the first row pixel driving units PDU11 and PDU12, and the ninth horizontal line HL9 may receive a first light emission signal EM1 from the fifth vertical line VL5 to supply it to the second row pixel driving units PDU21 and PDU22. The fourth horizontal line HL4 may supply a first light emission signal EM1 to all of the pixel driving units arranged in the first row, and the ninth horizontal line HL9 may supply a first light emission signal EM1 to all of the pixel driving units arranged in the second row. That is, all of the pixel driving units disposed in the first row and all of the pixel driving units disposed in the second row may receive the same first light emission signal EM1.

According to an embodiment of the present disclosure, the (2-1)-th light emission line ESL2-1 may include a sixth vertical line VL6 that extends in the second direction DR2, and a fifth horizontal line HL5 and a tenth horizontal line HL10 that extend in the first direction DR1. The sixth vertical line VL6, the fifth horizontal line HL5, and the tenth horizontal line HL10 may be disposed on different layers. The sixth vertical line VL6 and the fifth horizontal line HL5 may be connected to each other through a contact hole CNTe, and the sixth vertical line VL6 and the tenth horizontal line HL10 may be connected to each other through a contact hole CNTj. The fifth horizontal line HL5 may receive a second light emission signal EM2 (see FIG. 4A) from the sixth vertical line VL6 to supply it to the first row pixel driving units PDU11 and PDU12, and the tenth horizontal line HL10 may receive a second light emission signal EM2 from the sixth vertical line VL6 to supply it to the second row pixel driving units PDU21 and PDU22. The fifth horizontal line HL5 may supply the second light emission signal EM2 to all of the pixel driving units disposed in the first row, and the tenth horizontal line HL10 may supply a second light emission signal EM2 to all of the pixel driving units disposed in the second row. That is, all of the pixel driving units disposed in the first row and all of the pixel driving units disposed in the second row may receive the same second light emission signal EM2.

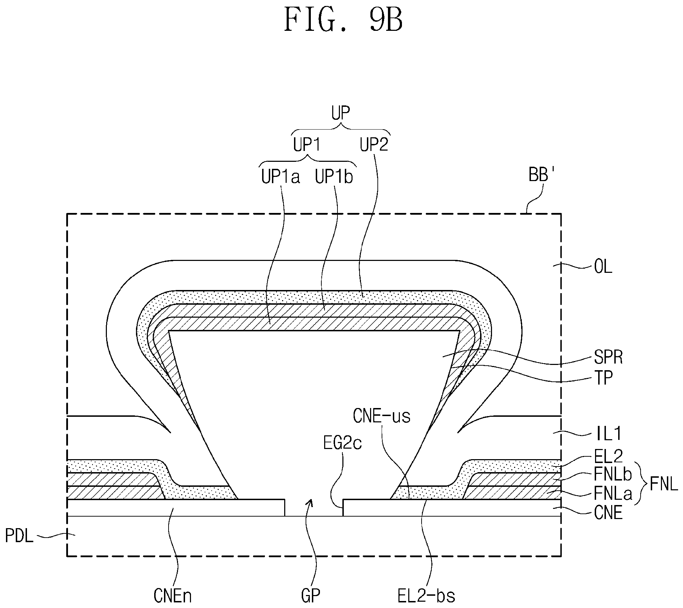

FIG. 9A is a cross-sectional view illustrating a portion corresponding to line I-I' of FIG. 7A according to an embodiment of the present disclosure. FIG. 9B is an enlarged cross-sectional view illustrating area BB' of FIG. 9A.

Referring to FIG. 9A, the display panel DP according to an embodiment of the present disclosure may include a base layer BS, a driving element layer DDL, a light-emitting element layer LDL, an encapsulation layer ECL, and a sensing layer ISL. However, this is only an example, and in an embodiment of the present disclosure, the display panel DP does not include the sensing layer ISL.

The driving element layer DDL may include a plurality of insulation layers 10, 20, 30, 40, 50, and 60 that are disposed on the base layer BS, and a plurality of conductive patterns and semiconductor patterns that are disposed between the insulation layers 10, 20, 30, 40, 50, and 60. The conductive patterns and the semiconductor patterns may be disposed between the insulation layers 10, 20, 30, 40, 50, and 60 to constitute pixel drivers PDC1 and PDC2. For convenience of explanation, FIG. 9A illustrates a cross section of any one of areas in which one light-emission part is disposed, by way of example.

The base layer BS may be a member that provides a base surface on which the pixel drivers PDC1 and PDC2 are disposed. The base layer BS may be a rigid substrate or a flexible substrate that may be bent, folded, rolled, or the like. The base layer BS may be, for example, a glass substrate, a metal substrate, or a polymer substrate. However, embodiments of the present disclosure are not limited thereto, and the base layer BS may be an inorganic layer, an organic layer, or a composite material layer according to embodiments.

The base layer BS may have a multi-layered structure. The base layer BS may include a first polymer resin layer, a silicon oxide (SiOx) layer that is disposed on the first polymer resin layer, an amorphous silicon (a-Si) layer that is disposed on the silicon oxide layer, and a second polymer resin layer that is disposed on the amorphous silicon layer. The silicon oxide layer and the amorphous silicon layer may be referred to as base barrier layers.

The polymer resin layer may include a polyimide-based resin. Furthermore, the polymer resin layer may include at least one of, for example, an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, and a perylene-based resin. In the specification, the "~-based" resin means including a functional group of "~~".

Each of the insulation layers, the conductive layers, and the semiconductor layers that are disposed on the base layer BS may be formed through coating and deposition. Thereafter, the insulation layer, the semiconductor layer, and the conductive layer may be selectively patterned through a plurality of photolithography processes to form a hole in the insulation layer, or to form a semiconductor pattern, a conductive pattern, a signal line, or the like.

The driving element layer DDL may include first to sixth insulation layers 10, 20, 30, 40, 50, and 60 that are sequentially laminated on the base layer BS, and pixel drivers PDC1 and PDC2. The first pixel driver PDC1 and the second pixel driver PDC2 illustrated in FIG. 4B are illustrated in FIG. 5 by way of example, the first pixel driver PDC1 illustrates one transistor TR1 and two capacitors C1 and C2, and the second pixel driver PDC2 illustrates one transistor TR2. The transistor TR2 may be one of a plurality of transistors included in the second pixel driver PDC2.

The transistor TR1 of the first pixel driver PDC1 may correspond to a transistor that is electrically connected to the light-emitting element LD through an intermediate connection electrode CN and a connection electrode CNE, that is, a connection transistor that is electrically connected to a node (e.g., the fourth node N4 of FIG. 4A, the second node N2 of FIG. 4B, or the fourth node N4 of FIG. 4C) corresponding to the cathode of the light-emitting element LD, and for example, may correspond to the sixth transistor T6 of FIG. 4A, the first transistor T1 of FIG. 4B, or the fourth transistor T4a of FIG. 4C. Hereinafter, the transistor TR1 of the first pixel driver PDC1 may be referred to as a connection transistor. The light-emitting element LD electrically connected to the first pixel driver PDC1 may be a first light-emitting element LD1 (see FIG. 7C).

The second pixel driver PDC2 may be electrically connected to a second light-emitting element LD2 (see FIG. 7C) that is adjacent to the first light-emitting element LD1. For example, the second pixel driver PDC2 may be electrically connected to the second light-emitting element LD2 through an intermediate connection electrode and a second connection electrode CNE2 (see FIG. 7C).

Other transistors that constitute the pixel drivers PDC1 or PDC2 may have the same structure as that of the transistor TR1 or TR2 illustrated in FIG. 9A. However, this is described by way of example, and other transistors that constitute the pixel drivers PDC1 or PDC2 may have a structure that is different from that of the transistor TR1 or TR2 illustrated in FIG. 9A, and embodiments of the present disclosure are not limited thereto.

A first insulation layer 10 may be disposed on the base layer BS. The first insulation layer 10 may be an inorganic layer and/or an organic layer, and may have a single-layered structure or a multi-layered structure. The first insulation layer 10 may include at least one of, for example, aluminum oxide, titanium oxide, silicon oxide, silicon nitride, silicon oxynitride, zirconium oxide, and hafnium oxide. In an embodiment, the first insulation layer 10 is illustrated as a single-layered silicon oxide. The insulation layers that will be described further below may be an inorganic layer and/or an organic layer, and may have a single-layered structure or a multi-layered structure. The inorganic layer may include at least one of the above-described materials, but the present disclosure is not limited thereto.

The first insulation layer 10 may cover lower conductive layers BCL1 and BCL2. That is, the display panel DP may further include the lower conductive layers BCL1 and BCL2 that are disposed to overlap the transistor TR1 or TR2. The lower conductive layers BCL1 and BCL2 may block an electric potential due to a polarization phenomenon of the base layer BS from affecting the transistor TR1 or TR2. Furthermore, the lower conductive layers BCL1 and BCL2 may block light input to the transistor TR1 or TR2 from a lower portion thereof. At least one of an inorganic barrier layer and a buffer layer may be further disposed between the lower conductive layers BCL1 and BCL2 and the base layer BS.

The lower conductive layers BCL1 and BCL2 may include reflective metals. For example, the lower conductive layers BCL1 and BCL2 may include titanium (Ti), molybdenum (Mo), an alloy containing molybdenum, aluminum (Al), an alloy containing aluminum, aluminum nitride (AlN), tungsten (W), tungsten nitride (WN), copper (Cu), and the like.

The lower conductive layers BCL1 and BCL2 may include a first lower conductive layer BCL1 and a second lower conductive layer BCL2. In an embodiment, the first lower conductive layer BCL1 may be connected to the source of the connection transistor TR1 through the first source electrode pattern S1 (or the (1-1)-th pattern). In this case, the first lower conductive layer BCL1 may be synchronized with a source of the connection transistor TR1. The second lower conductive layer BCL2 may be connected to the source of the transistor TR2 through the second source electrode pattern S2 (or the (1-2)-th pattern). In this case, the second lower conductive layer BCL2 may be synchronized with the source of the transistor TR2.

However, this is illustrated by way of example, and the lower conductive layer BCL1 or BCL2 may be electrically connected to a gate of the transistor TR1 or TR2 to be synchronized with the gate. In an embodiment, the lower conductive layer BCL1 or BCL2 may be connected to another electrode to independently receive a constant voltage or pulse signal. In an embodiment, the lower conductive layer BCL1 or BCL2 may be provided in a form that is isolated from another conductive pattern. The lower conductive layer BCL1 or BCL2 according to an embodiment of the present disclosure may be provided in various forms, and embodiments of the present disclosure are not limited to any one embodiment.

The transistor TR1 of the first pixel driver PDC1 and the transistor TR2 of the second pixel driver PDC2 may be disposed on the first insulation layer 10. The transistor TR1 of the first pixel driver PDC1 may include a first semiconductor pattern SP1 and a first gate electrode GE1. The transistor TR2 of the second pixel driver PDC2 may include a second semiconductor pattern SP2 and a second gate electrode GE2. The first and second semiconductor patterns SP1 and SP2 may be disposed on the first insulation layer 10. The first and second semiconductor patterns SP1 and SP2 may include an oxide semiconductor. For example, the oxide semiconductor may include a transparent conductive oxide (TCO), such as indium tin oxide (ITO), indium zinc oxide (IZO), indium gallium zinc oxide (IGZO), zinc oxide (ZnO), or indium oxide (In₂O₃). However, the present disclosure is not limited thereto, and the first and second semiconductor patterns SP1 and SP2 may include, for example, amorphous silicon, low-temperature polycrystalline silicon, or polycrystalline silicon.

Each of the first and second semiconductor patterns SP1 and SP2 may include a source area, a drain area, and a channel area, which are distinguished depending on a degree of conductivity. For example, the first semiconductor pattern SP1 may include a first source area SR1, a first drain area DR_1, and a first channel area CR1. The first source area SR1 and the first drain area DR_1 may be spaced apart from each other with the first channel area CR1 interposed therebetween. The first channel area CR1 may be a portion that overlaps the first gate electrode GE1 on a plane. The second semiconductor pattern SP2 may include a second source area SR2, a second drain area, and a second channel area CR2. The second source area SR2 and the second drain area may be spaced apart from each other with the second channel area CR2 interposed therebetween. The second channel area CR2 may be a portion that overlaps the second gate electrode GE2 on a plane. Because cutting line I-I' does not pass through the second drain area of the second semiconductor pattern SP2, the illustration of the second drain area is omitted in FIG. 5.

When the semiconductor pattern SP1 or SP2 is an oxide semiconductor, each of the source area SR1 or SR2 and the drain area DR_1 may be a reduced area. Accordingly, the source area SR1 or SR2 and the drain area DR_1 have a relatively high reduction metal content compared to the channel area CR1 or CR2. In an embodiment, when the semiconductor pattern SP1 or SP2 is polycrystalline silicon, each of the source area SR1 or SR2 and the drain area DR_1 may be an area that is doped at a high concentration.

The source area SR1 or SR2 and the drain area DR_1 may have a relatively higher conductivity than the channel area CR1 or CR2. The source area SR1 or SR2 may correspond to the source electrode of the transistor TR1 or TR2, and the drain area DR _1 may correspond to the drain electrode of the transistor TR1 or TR2. As illustrated in FIG. 9A, a separate source electrode pattern S1 or S2 and a drain electrode pattern D1 or D2 that are connected to the source area SR1 or SR2 and the drain area DR1, respectively, may be further provided. For example, the separate source electrode pattern S1 or S2 and the drain electrode pattern D1 or D2 may be integrally formed with one of lines that constitute a pixel driver (see PDC of FIG. 4A, PDC-1 of FIG. 4B, or PDC-2 of FIG. 4C), respectively, and embodiments of the present disclosure are not limited to any one embodiment.

The second insulation layer 20 may overlap a plurality of pixels in common, and may cover the semiconductor pattern SP1 or SP2. The second insulation layer 20 may be an inorganic layer and/or an organic layer, and may have a single-layered structure or multi-layered structure. The second insulation layer 20 may include at least one of, for example, aluminum oxide, titanium oxide, silicon oxide, silicon nitride, silicon oxynitride, zirconium oxide, and hafnium oxide. In an embodiment, the second insulation layer 20 may be a single-layered silicon oxide layer.

The gate electrodes GE1 and GE2 may be disposed on the second insulation layer 20. The first gate electrode GE1 may correspond to the gate of the transistor TR1 of the first pixel driver PDC1, and the second gate electrode GE2 may correspond to the gate of the transistor TR2 of the second pixel driver PDC2. The gate electrodes GE1 and GE2 may be disposed on upper sides of the semiconductor patterns SP1 and SP2, respectively. However, this is illustrated by way of example, and the gate electrodes GE1 and GE2 may be disposed on lower sides of the semiconductor patterns SP1 and SP2, respectively, and embodiments of the present disclosure are not limited to any one embodiment.

The gate electrodes GE1 and GE2 may include, for example, titanium (Ti), silver (Ag), molybdenum (Mo), aluminum (Al), aluminum nitride (AlN), tungsten (W), tungsten nitride (WN), copper (Cu), or alloys thereof, but the present disclosure is not particularly limited thereto.

A scan write line GWL may be disposed on the second insulation layer 20. The scan write line GWL may include a horizontal line HL and a vertical line VL. The horizontal line HL may be directly disposed on the second insulation layer 20. The horizontal line HL may be formed through the same process as that of the gate electrodes GE1 and GE2. The horizontal line HL may include, for example, titanium (Ti), silver (Ag), molybdenum (Mo), aluminum (Al), aluminum nitride (AlN), tungsten (W), tungsten nitride (WN), copper (Cu), or an alloy thereof, but the present disclosure is not limited thereto.

A third insulation layer 30 may be disposed on the gate electrodes GE1 and GE2. The third insulation layer 30 may be an inorganic layer and/or an organic layer, and may have a single-layered structure or a multi-layered structure. The fourth insulation layer 40 may include at least one of, for example, aluminum oxide, titanium oxide, silicon oxide, silicon nitride, silicon oxynitride, zirconium oxide, and hafnium oxide.

Among a plurality of conductive patterns S1, S2, D1, D2, CPE, CPE1, CPE2, and CPE3, the first capacitor electrode CPE1 and the second capacitor electrode CPE2 constitute a first capacitor C1. The first capacitor electrode CPE1 and the second capacitor electrode CPE2 may be spaced apart from each other with the first insulation layer 10 and the second insulation layer 20 interposed therebetween.

In an embodiment of the present disclosure, the first capacitor electrode CPE1 and the first lower conductive layer BCL1 may have an integral shape. Furthermore, the second capacitor electrode CPE2 and the first gate electrode GE1 may have an integral shape, in which they are connected to each other, and the capacitor electrode CPE and the second gate electrode GE2 may have an integral shape, in which they are connected to each other. However, this is only an example, and the present disclosure is not particularly limited thereto. For example, according to embodiments, the first capacitor electrode CPE1 and the first lower conductive layer BCL1 are disposed on the same layer and may be spaced apart from each other, the second capacitor electrode CPE2 and the first gate electrode GE1 are disposed on the same layer and may be spaced apart from each other, and the capacitor electrode CPE and the second gate electrode GE2 are disposed on the same layer and may be spaced apart from each other.

A third capacitor electrode CPE3 may be disposed on the third insulation layer 30. The third capacitor electrode CPE3 may be spaced apart from the second capacitor electrode CPE2 with the third insulation layer 30 interposed therebetween, and may overlap the second capacitor C2 on a plane. The third capacitor electrode CPE3 may constitute the second capacitor electrode CPE2 and the second capacitor C2.

A fourth insulation layer 40 may be disposed on the third insulation layer 30 and/or the third capacitor electrode CPE3. The fourth insulation layer 40 may be an inorganic layer and/or an organic layer, and may have a single-layered structure or a multi-layered structure. The fourth insulation layer 40 may include at least one of, for example, aluminum oxide, titanium oxide, silicon oxide, silicon nitride, silicon oxynitride, zirconium oxide, and hafnium oxide.

A first source electrode pattern S1 and a second drain electrode pattern D1 that are connected to the first semiconductor pattern SP1, and a second source electrode pattern S2 and a second drain electrode pattern D2 that are connected to the second semiconductor pattern SP2, may be disposed on the fourth insulation layer 40.

The first source electrode pattern S1 may be connected to a first source area SR1 of the connection transistor TR1 through a first contact hole CNT1, and the first source area SR1 of the first source electrode pattern S1 and the first semiconductor pattern SP may function as a source of the connection transistor TR1. The first drain electrode pattern D1 may be connected to the first drain area DR _1 of the connection transistor TR1 through a second contact hole CNT2, and the first drain area DR _1 of the first drain electrode pattern D1 and the first semiconductor pattern SP1 may function as a drain of the connection transistor TR1.

The second source electrode pattern S2 may be connected to a second source area SR2 of the transistor TR2 of the second pixel driver PDC2 and a second lower conductive layer BCL2 through a contact hole. The second source electrode pattern S2 and the second source area SR2 of the second semiconductor pattern SP2 may function as a source of the transistor TR2. The second drain electrode pattern D2 may be connected to a second gate electrode GE2 through a contact hole, and the second gate electrode GE2 may be connected to a second drain area of the second semiconductor pattern SP2. That is, the second drain electrode pattern D2 may be connected to a second drain area of the transistor TR2, and the second drain electrode pattern D2 and the second drain area may function as a drain of the transistor TR2.

A vertical line VL that is connected to the horizontal line HL may be disposed on the fourth insulation layer 40. The vertical line VL may be electrically connected to the horizontal line HL through a contact hole CNTa. The vertical line VL may be formed by the same process as those of the first source electrode pattern S1, the first drain electrode pattern D1, the second source electrode pattern S2, and the second drain electrode pattern D2.

The fifth insulation layer 50 may be disposed on the first source electrode pattern S1, the first drain electrode pattern D1, the second source electrode pattern S2, and the second drain electrode pattern D2.

An intermediate connection electrode CN may be disposed on the fifth insulation layer 50. The intermediate connection electrode CN may electrically connect the first pixel driver PDC1 to the connection electrode CNE. That is, the intermediate connection electrode CN may electrically connect the first pixel driver PDC1 (e.g., a connection transistor TR1 of the first pixel driver PDC1) to the light-emitting element LD. The intermediate connection electrode CN may be a connection node that connects the first pixel driver PDC1 to the light-emitting element LD. That is, the intermediate connection electrode CN may correspond to the fourth node N4 illustrated in FIG. 4A, may correspond to the second node N2 illustrated in FIG. 4B, or may correspond to the fourth node N4 illustrated in FIG. 4C.

A sixth insulation layer 60 may be disposed on the intermediate connection electrode CN. The sixth insulation layer 60 may be disposed on the fifth insulation layer 50 to cover at least a portion of the intermediate connection electrode CN. Each of the fifth insulation layer 50 and the sixth insulation layer 60 may be an organic layer. For example, each of the fifth insulation layer 50 and the sixth insulation layer 60 may include benzocyclobutene (BCB), polyimide (Polyimide), hexamethyldisiloxane (HMDSO), polymethylmethacrylate (PMMA), a polymer derivative having a general-purpose polymer such as polystyrene (PS), polymer derivatives having phenolic groups, an acryl-based polymer, an imide-based polymer, an aryl ether-based polymer, an amide polymer, a fluorine-based polymer, a p-xylene-based polymer, a vinyl alcohol-based polymer, and a blend thereof.

The sixth insulation layer 60 may be provided with a through-hole OP-60 that exposes at least a portion of the intermediate connection electrode CN. The intermediate connection electrode CN may be connected to the connection electrode CNE through a portion exposed from the sixth insulation layer 60 to be electrically connected to the light-emitting element LD. That is, the intermediate connection electrode CN may electrically connect the connection transistor TR1 and the light-emitting element LD together with the connection electrode CNE. In the display panel DP according to an embodiment of the present disclosure, the sixth insulation layer 60 may be omitted or a plurality of six insulation layers 60 may be provided, and embodiments of the present disclosure are not limited thereto. When the sixth insulation layer 60 is omitted, the intermediate connection electrode CN may also be omitted.

The intermediate connection electrode CN may include a first layer L1, a second layer L2, and a third layer L3 that are sequentially laminated along the third direction DR3. The second layer L2 may include a material that is different from that of the first layer L1. Furthermore, the second layer L2 may include a material that is different from that of the third layer L3. The second layer L2 may have a relatively thick thickness compared to the first layer L1. Furthermore, the second layer L2 may have a relatively thick thickness compared to the third layer L3. The second layer L2 may include a material having a high conductivity. In an embodiment, the second layer L2 may include aluminum (Al).

According to an embodiment, the second drain electrode pattern D2 and the vertical line VL are disposed on the same layer, the second drain electrode pattern D2 and the vertical line VL are not electrically connected to each other, and the second drain electrode pattern D2 and the vertical line VL may overlap each other in a cross-sectional view. As the second drain electrode pattern D2 and the vertical line VL, which are not electrically connected, overlap each other in a cross-sectional view, an electric field may be changed, and coupling noise caused by the change in the electric field may be generated or increased.

According to embodiments of the present disclosure, a shield pattern SHP may be disposed on the fifth insulation layer 50. According to an embodiment of the present disclosure, the shield pattern SHP may overlap at least a portion of the vertical line VL and the second drain electrode pattern D2 on a plane. The shield pattern SHP may be formed through the same process as that of the intermediate connection electrode CN. That is, like the intermediate connection electrode CN, the shield pattern SHP may include a first layer L1, a second layer L2, and a third layer L3, which are sequentially laminated along the third direction DR3. The shield pattern SHP may be electrically connected to a second power source line VSL (see FIG. 4A), and a second power source voltage VSS (see FIG. 4A) may be applied thereto. The shield pattern SHP may be connected to a second power source line VSL in a display area DA (see FIG. 5). However, the present disclosure is not limited thereto, and the shield pattern SHP may be connected to the first power source line VDL (see FIG. 4A), and the first power source voltage VDD (see FIG. 4A) may be applied thereto, according to embodiments.

According to an embodiment, the shield pattern SHP may overlap the vertical line VL and the second drain electrode pattern D2 on a plane. A second power source voltage VSS (see FIG. 4A) may be applied to the shield pattern SHP. That is, as the vertical line VL and the second drain electrode pattern D2 are shielded by using the shield pattern SHP, to which a constant voltage is provided, coupling noise formed between the vertical line VL and the second drain electrode pattern D2 may be decreased or prevented.

For example, according to an embodiment, the shield pattern SHP may be configured to overlap both the vertical line VL and the second drain electrode pattern D2 when viewed in a planar layout. The shield pattern SHP is supplied with a second power source voltage VSS (see FIG. 4A), thus enabling the shield pattern SHP to maintain a constant electrical potential. By positioning the shield pattern SHP in this manner and applying a stable voltage to it, the vertical line VL and the second drain electrode pattern D2 become electrically shielded. As a result, undesired coupling noise that would otherwise arise due to variations in the electric field between these two conductive elements may be significantly reduced or effectively eliminated, thereby enhancing signal integrity and display performance.

According to an embodiment, the second source electrode pattern S2 and the vertical line VL are disposed on the same layer, the second source electrode pattern S2 and the vertical line VL are not electrically connected to each other, and the second source electrode pattern S2 and the vertical line VL overlap each other in a cross-sectional view. As the second source electrode pattern S2 and the vertical line VL, which are not electrically connected, overlap in a cross-sectional view, an electric field may be changed, and coupling noise caused by the change in the electric field may be generated or increased.

A metal pattern MTP may be further disposed on the fifth insulation layer 50. According to an embodiment of the present disclosure, the metal pattern MTP may overlap at least a portion of the second source electrode pattern S2 on a plane. The metal pattern MTP may overlap at least a portion of the vertical line VL on a plane. The metal pattern MTP may be formed by the same process as that of the intermediate connection electrode CN. That is, like the intermediate connection electrode CN, the metal pattern MTP may include a first layer L1, a second layer L2, and a third layer L3, which are sequentially laminated along the third direction DR3. The metal pattern MTP may be electrically connected to a second power source line VSL (see FIG. 4A), and a second power source voltage VSS (see FIG. 4A) may be applied thereto. The metal pattern MTP may be connected to a second power source line VSL in a display area DA (see FIG. 5). However, the present disclosure is not limited thereto, and the metal pattern MTP may be connected to the first power source line VDL (see FIG. 4A), and the first power source voltage VDD (see FIG. 4A) may be applied thereto according to embodiments.

According to an embodiment, the metal pattern MTP may overlap the vertical line VL and the second source electrode pattern S2 on a plane. A second power source voltage VSS (see FIG. 4A) may be applied to the metal pattern MTP. That is, as the vertical line VL and the second source electrode pattern S2 are shielded by using the shield pattern SHP, to which a constant voltage is provided, coupling noise formed between the vertical line VL and the second source electrode pattern S2 may be decreased or prevented.

For example, according to embodiment, the metal pattern MTP may be positioned such that it overlaps both the vertical line VL and the second source electrode pattern S2 when viewed in a planar layout. A second power source voltage VSS (see FIG. 4A) may be supplied to the metal pattern MTP, thus enabling the metal pattern MTP to maintain a stable electrical potential. By implementing the metal pattern MTP in this manner, the vertical line VL and the second source electrode pattern S2 are effectively shielded. Since the shield pattern SHP is maintained at a constant voltage, it serves to mitigate or eliminate coupling noise that would otherwise be induced between the vertical line VL and the second source electrode pattern S2 due to electric field variations. This shielding mechanism helps to enhance the electrical stability of the display circuit and improve overall display performance by reducing unwanted interference.

A light-emitting element layer LDL may be disposed on the driving element layer DDL. The light-emitting element layer LDL may include a pixel definition film PDL, a light-emitting element LD, and a separator SPR.

The pixel definition film PDL may be an organic layer. For example, the pixel definition film PDL may include benzocyclobutene (BCB), polyimide (polyimide), hexamethyldisiloxane (EA4DSO), general-purpose polymer such as polymethylmethacrylate (PMMA), a polymer derivative having a phenolic group such as polystyrene (PS), an acryl-based polymer, an imide-based polymer, an aryl ether-based polymer, an amide-based polymer, a fluorine-based polymer, a p-xylene-based polymer, a vinyl alcohol-based polymer, and a blend thereof.

In an embodiment, the pixel definition film PDL may have a property of absorbing light, and may, for example, have a color of black. That is, the pixel definition film PDL may include a black coloring agent. The black coloring agent may include a black dye and a black pigment. The black coloring agent may include a metal, such as, for example, carbon black and chromium, or an oxide thereof. The pixel definition film PDL may correspond to a light shielding pattern having light shielding characteristics.

In the pixel definition film PDL, an opening OP-PDL (hereinafter, a light emission opening) that exposes at least a portion of the first electrode EL1, which is to be described below, may be defined. A plurality of light emission openings OP-PDL may be provided, and may be disposed to correspond to the light-emitting element, respectively. In the light emission opening OP-PDL, all components of the light-emitting element LD may be disposed to overlap each other, and the light emission opening OP-PDL may be an area in which light emitted by the light-emitting element LD is substantially displayed. Accordingly, the shape of the first light-emission part EP1 (see FIG. 7A) may substantially correspond to the shape of the light emission opening OP-PDL on a plane.

A connection electrode CNE may be disposed on the pixel definition film PDL. The connection electrode CNE may electrically connect the first pixel driver PDC1 to the light-emitting element LD. That is, the first pixel driver PDC1 may be electrically connected to the light-emitting element LD through the intermediate connection electrode CNE and the connection electrode CNE. The connection electrode CNE may correspond to the first connection electrode CNE1 illustrated in FIG. 7A. The second connection electrode CNE2 (see FIG. 7A) and the third connection electrode CNE3 (see FIG. 7A) may also have a structure that is similar to that of the connection electrode CNE.

The connection electrode CNE may include a first edge EG1c that is disposed adjacent to the light emission opening OP-PDL and a second edge EG2c that surrounds the first edge EG1c. The second electrode EL2 of the light-emitting element LD may contact the connection electrode CNE in an area that is adjacent to the second edge EG2c.

The connection electrode CNE may include, for example, a transparent conductive oxide (TCO), such as indium tin oxide (ITO), indium zinc oxide (IZO), indium gallium zinc oxide (IGZO), zinc oxide (ZnO), or indium oxide (In₂O₃). However, the material that constitutes the connection electrode CNE is not limited to the above example.

A through-hole OP-P that is spaced apart from the light emission opening OP-PDL may be defined in the pixel definition film PDL. A plurality of through-holes OP-P may be disposed to correspond to the light-emitting element, respectively. A size of the through-hole OP-P defined in the pixel definition film PDL may be larger than a size of the through-hole OP-60 defined in the sixth insulation layer 60. The connection electrode CNE may be disposed in the through-hole OP-P and the through-hole OP-60, and may be connected to the intermediate connection electrode CN.

The light-emitting element LD may include a first electrode EL1, an intermediate layer IML, and a second electrode EL2.

The first electrode EL1 may be a semi-transmissive, transmissive, or reflective electrode. According to an embodiment of the present disclosure, the first electrode EL1 may include a reflective layer that is formed of, for example, silver (Ag), magnesium (Mg), aluminum (Al), platinum (Pt), palladium (Pd), gold (Au), nickel (Ni), neodymium (Nd), iridium (Ir), chromium (Cr), or a compound thereof, and a transparent or translucent electrode layer that is formed on the reflective layer. The transparent or translucent electrode layer may include at least one of, for example, indium tin oxide (ITO), indium zinc oxide (IZO), indium gallium zinc oxide (IGZO), zinc oxide (ZnO) or indium oxide (In₂O₃), and aluminum-doped zinc oxide (AZO). For example, the first electrode EL1 may include a lamination structure of ITO/Ag/ITO.

In an embodiment, the first electrode EL1 may be the anode of the light-emitting element LD. That is, the first electrode EL1 may be connected to the first power source line VDL (see FIG. 4A), and the first power source voltage VDD (see FIG. 4A) may be applied thereto. The first electrode EL1 may be electrically connected to the first power source line VDL in the display area DA (see FIG. 5), or may be electrically connected to the first power source line VDL in the non-display area NDA. In the latter case, the first power source line VDL may be disposed in the non-display area NDA (see FIG. 5), and the first electrode EL1 may have a shape that extends to the non-display area NDA.

Although the first electrode EL1 overlaps the light emission opening OP-PDL and does not overlap the separator SPR in the cross-sectional view of FIG. 9A, as described above in FIG. 7D, the first electrodes EL1 of the light-emitting elements may have an integral shape and may have a mesh or lattice shape, in which openings are defined in a partial area. That is, when the same first power source voltage VDD is applied to the first electrodes EL1 of the plurality of light-emitting elements, the shapes of the first electrodes EL1 may be provided in various ways, and embodiments of the present disclosure are not limited to any one embodiment.

The intermediate layer IML may be disposed between the first electrode EL1 and the second electrode EL2. The intermediate layer IML may include a light emission layer EML and a functional layer FNL. The light-emitting element LD may include an intermediate layer IML having various structures, and embodiments of the present disclosure are not limited thereto. For example, the functional layer FNL may be provided as a plurality of layers, or may be provided as two or more layers that are spaced apart from each other with the light emission layer EML interposed therebetween.

The light emission layer EML may include an organic light-emitting material. Furthermore, the light emission layer EML may include an inorganic light-emitting material, or may be provided as a mixture layer of the organic light-emitting material and the inorganic light-emitting material. In an embodiment, the light emission layers EML included in the adjacent light-emission parts EP (see FIG. 3A) may include light-emitting materials that display different colors. For example, a light emission layer EML included in each of the light-emission parts EP may provide any one of blue, red, and green light. However, the present disclosure is not limited thereto, and the light emission layers EML disposed in all of the light-emission parts EP may include a light-emitting material that displays the same color. In this case, the light emission layer EML may provide blue light or white light.

The functional layer FNL may be disposed between the first electrode EL1 and the second electrode EL2. For example, the functional layer FNL may include a first intermediate functional layer FNLa (see FIG. 9B) that is disposed between the first electrode EL1 and the light emission layer EML, and a second intermediate functional layer FNLb (see FIG. 9B) that is disposed between the second electrode EL2 and the light emission layer EML. In an embodiment of the present disclosure, one of the first intermediate functional layer FNLa and the second intermediate functional layer FNLb may be omitted. In an embodiment, it is illustrated that the light emission layer EML is inserted into the functional layer FNL. That is, it may be understood that the light emission layer EML is disposed between the first intermediate functional layer FNLa and the second intermediate functional layer FNLb.

The functional layer FNL may control the flow of charges between the first electrode EL1 and the second electrode EL2. For example, the first intermediate functional layer FNLa may include a hole injection/transport material and/or an electron injection/transport material. The second intermediate functional layer FNLb may include at least one of, for example, an electron blocking layer, a hole transport layer, a hole blocking layer, an electron transport layer, an electron injection layer, and a charge generation layer.

The second electrode EL2 may be disposed on the intermediate layer IML. As described above, the second electrode EL2 may be electrically connected to the connection electrode CNE to be electrically connected to the first pixel driver PDC1. That is, the second electrode EL2 may be electrically connected to the connection transistor TR1 through the connection electrode CNE.

The separator SPR may be disposed on the pixel definition film PDL. In an embodiment, the second electrode EL2 and the functional layer FNL may be formed through common deposition in the plurality of pixels through an open mask. Then, the second electrode EL2 and the functional layer FNL may be divided by the separator SPR. As described above, the separator SPR may have a closed line shape with respect to each of the light-emission parts, and accordingly, the second electrode EL2 and the functional layer FNL may have a shape that is divided for each of the light-emission parts. That is, the second electrode EL2 and the intermediate layer IML may be electrically independent for each of the adjacent pixels. Hereinafter, the separator SPR will be described in detail with reference to FIG. 9A and FIG. 9B.

Referring to FIGS. 9A and 9B, the separator SPR may be disposed in a gap GP between the connection electrode CNE disposed on the pixel definition film PDL and an adjacent connection electrode CNEn that is adjacent to the connection electrode CNE.

The separator SPR may have an inverse taper shape. That is, the separator SPR may have a shape in which a width increases as a distance from an upper surface of the pixel definition film PDL increases. A side surface TP of the separator SPR may have a shape in which a taper angle inclined from the upper surface of a pixel definition film PDL is obtuse. However, this is illustrated by way of example, and the taper angle of the separator SPR may vary as long as it enables the electrical disconnection of the second electrode EL2 for each pixel. For example, the separator SPR may have a dual structure in which a taper angle is changed at different sections. Furthermore, the separator SPR may have the same structure as that of a tip part. However, embodiments of the present disclosure are not limited thereto.

The separator SPR may include an insulating material. For example, the separator SPR may include an organic insulating material. The separator SPR may also be referred to herein as an insulating material. The separator SPR may include an inorganic insulating material, an organic insulating material, and an inorganic insulating material formed in multiple layers, or may include a conductive material according to an embodiment. That is, when the second electrode EL2 is electrically disconnected for each of the pixels, the separator SPR is not particularly limited to the type of the material.

A dummy layer UP may be disposed on the separator SPR. The dummy layer UP may include a first dummy layer UP1 that is disposed on the separator SPR and a second dummy layer UP2 that is disposed on the first dummy layer UP1. The first dummy layer UP1 may be formed though the same process as that of the functional layer FNL, and may include the same material as the functional layer FNL. The first dummy layer UP1 may include a (1-1)-th dummy layer UP1a and a (1-2)-th dummy layer UP1b. The (1-1)-th dummy layer UP1a may be formed through the same process as that of the first intermediate functional layer FNLa, and may include the same material. The (1-2)-th dummy layer UP1b may be formed through the same process as the second intermediate functional layer FNLb, and may include the same material as the second intermediate functional layer FNLb. The second dummy layer UP2 may be formed through the same process as the second electrode EL2, and may include the same material as the second electrode EL2. That is, the first dummy layer UP1 and the second dummy layer UP2 may be formed simultaneously during the formation of the functional layer FNL and the second electrode EL2. As illustrated in FIG. 9, the dummy layer UP may be formed at a portion of the side surface TP as well as an upper surface of the separator SPR. In an embodiment, the display panel DP does not include the dummy layer UP. In an embodiment, the dummy layer UP does not contact the connection electrode CNE and the second electrode EL2. In an embodiment, the second dummy layer UP2 included in the dummy layer UP does not contact the connection electrode CNE and the second electrode EL2.

A portion of the second electrode EL2, which contacts the connection electrode CNE, may be defined as a contact area. The contact area is disposed adjacent to the separator SPR. An upper surface CNE-us of the connection electrode CNE contacts a lower surface EL2-bs of the second electrode EL2 in the contact area. Because the separator SPR has an inverse taper shape and the contact area is disposed adjacent to the separator SPR, at least a portion of the contact area, in which the second electrode EL2 and the connection electrode CNE contact each other, may be disposed under the side surface TP of the separator SPR.

In an embodiment, at least a portion of the connection electrode CNE may be disposed under the separator SPR. The separator SPR may be disposed in a gap GP between the connection electrode CNE and the adjacent connection electrode CNE that is adjacent to the connection electrode CNE, and a second edge EG2c of the second electrode EL2 may be covered by the separator SPR.

According to an embodiment of the present disclosure, the connection electrode CNE has a shape that surrounds at least a portion of the light emission area EA, in which the light-emitting element LD is disposed. Accordingly, a degree of freedom of a position, in which the connection electrode CNE and the light-emitting element LD are electrically connected to each other, and a degree of freedom of a position, in which the connection electrode CNE and the pixel driver PDC are connected to each other, may be improved. Furthermore, the upper surface CNE-us of the connection electrode CNE may contact the lower surface EL2-bs of the second electrode EL2 of the light-emitting element LD. Accordingly, contact reliability between the connection electrode CNE and the second electrode EL2 may be improved, for example, because the lower surface of the connection electrode CNE and the upper surface of the intermediate connection electrode CNE contact each other. Through the display panel DP according to an embodiment, sizes of the through-holes OP-P and OP-60 for connecting the connection electrode CNE and the intermediate connection electrode CN may be reduced through the above-described structure, and thus, resolution of the light-emission part of the display panel DP may be easily increased.

Referring back to FIG. 9A, an encapsulation layer ECL may be disposed on the light-emitting element layer LDL. The encapsulation layer ECL may cover the light-emitting element LD and may cover the separator SPR. The encapsulation layer ECL may include a first inorganic layer IL1, an organic layer OL, and a second inorganic layer IL2 that are sequentially laminated. However, the present disclosure is not limited thereto, and the encapsulation layer ECL may further include a plurality of inorganic layers and organic layers. Furthermore, the encapsulation layer ECL may be a glass substrate.

The first and second inorganic layers IL1 and IL2 may protect the light-emitting element LD from moisture and oxygen introduced from outside the display panel DP, and the organic layer OL may protect the light-emitting element LD from foreign substances, such as, for example, particles that remain after the process of forming the first inorganic layer IL1. The first and second inorganic layers IL1 and IL2 may include, for example, a silicon nitride layer, a silicon oxynitride layer, a silicon oxide layer, a titanium oxide layer, or an aluminum oxide layer. The organic layer OL may include, for example, an acrylic organic layer. However, the type of material is not limited to the above materials.

The sensing layer ISL may sense an external input. In an embodiment, the sensing layer ISL may be formed on the encapsulation layer ECL through a continuous process, and thus, the sensing layer ISL may be directly disposed on the encapsulation layer ECL. Direct disposition may mean that other components are not disposed between the sensing layer ISL and the encapsulation layer ECL. That is, in an embodiment, a separate adhesive member is not disposed between the sensing layer ISL and the encapsulation layer ECL. However, this is illustrated by way of example, and embodiments are not limited thereto. For example, in the display panel DP according to an embodiment of the present disclosure, the sensing layer ISL may be formed separately and then coupled to the display panel DP through an adhesive member.

The sensing layer ISL may include a plurality of conductive layers and a plurality of insulation layers. The plurality of conductive layers may include a first sensing conductive layer MTL1 and a second sensing conductive layer MTL2, and the plurality of insulation layers may include first to third sensing insulation layers 71, 72, and 73. However, this is illustrated by way of example, and the numbers of the conductive layers and the insulation layers are not limited to any one embodiment.

Each of the first to third sensing insulation layers 71, 72, and 73 may have a single-layered structure, or a multi-layered structure, in which they are laminated along the third direction DR3. The first to third sensing insulation layers 71, 72, and 73 may include an inorganic layer. The inorganic layer may include at least one of, for example, aluminum oxide, titanium oxide, silicon oxide, silicon nitride, silicon oxynitride, zirconium oxide, and hafnium oxide. The first to third sensing insulation layers 71, 72, and 73 may include an organic layer. The organic layer may include at least one of, for example, an acrylic resin, a methacrylic resin, a polyisoprene resin, a vinyl resin, an epoxy resin, a urethane resin, a cellulose resin, a siloxane resin, a polyimide resin, a polyamide resin, and a perylene resin.

The first sensing conductive layer MTL1 may be disposed between the first sensing insulation layer 71 and the second sensing insulation layer 72, and the second sensing conductive layer MTL2 may be disposed between the second sensing insulation layer 72 and the third sensing insulation layer 73. A portion of the second sensing conductive layer MTL2 may be electrically connected to the first sensing conductive layer MTL1 through the contact hole CNT formed in the second sensing insulation layer 72. Each of the first sensing conductive layer MTL1 and the second sensing conductive layer MTL2 may have a single-layered structure or a multi-layered structure, in which they are laminated along the third direction DR3.

The sensing conductive layer having a single-layered structure may include a metal layer or a transparent conductive layer. The metal layer may include, for example, molybdenum, silver, titanium, copper, aluminum, or alloys thereof. The transparent conductive layer may include a transparent conductive oxide such as, for example, indium tin oxide (ITO), indium zinc oxide (IZO), zinc oxide (ZnO), indium zinc oxide (IZO), or indium zinc tin oxide (IZTO). In an embodiment, the transparent conductive layer may include a conductive polymer, such as, for example, PEDOT, metal nanowires, graphene, or the like.

The sensing conductive layer of the multi-layered structure may include metal layers. The metal layers may, for example, have a three-layer structure of titanium (Ti)/aluminum (Al)/titanium (Ti). In an embodiment, the sensing conductive layer of the multi-layered structure may include at least one metal layer and at least one transparent conductive layer.

The first sensing conductive layer MTL1 and the second sensing conductive layer MTL2 may constitute a sensor for sensing an external input in the sensing layer ISL. The sensor may be driven through a capacitive method, and may be driven through any one of a mutual-capacitance method and a self-capacitance method. However, this is illustrated by way of example, and the sensor may be driven through, for example, a resistive method, an ultrasonic method, or an infrared method in addition to the capacitive method, according to embodiments.

Each of the first sensing conductive layer MTL1 and the second sensing conductive layer MTL2 may include a transparent conductive oxide, and may have a shape of a metal mesh that is formed of an opaque conductive material. The first sensing conductive layer MTL1 and the second sensing conductive layer MTL2 may have various materials and various shapes, provided that they do not degrade the visibility of an image displayed by the display panel DP. However, the present disclosure is not limited to any one embodiment.

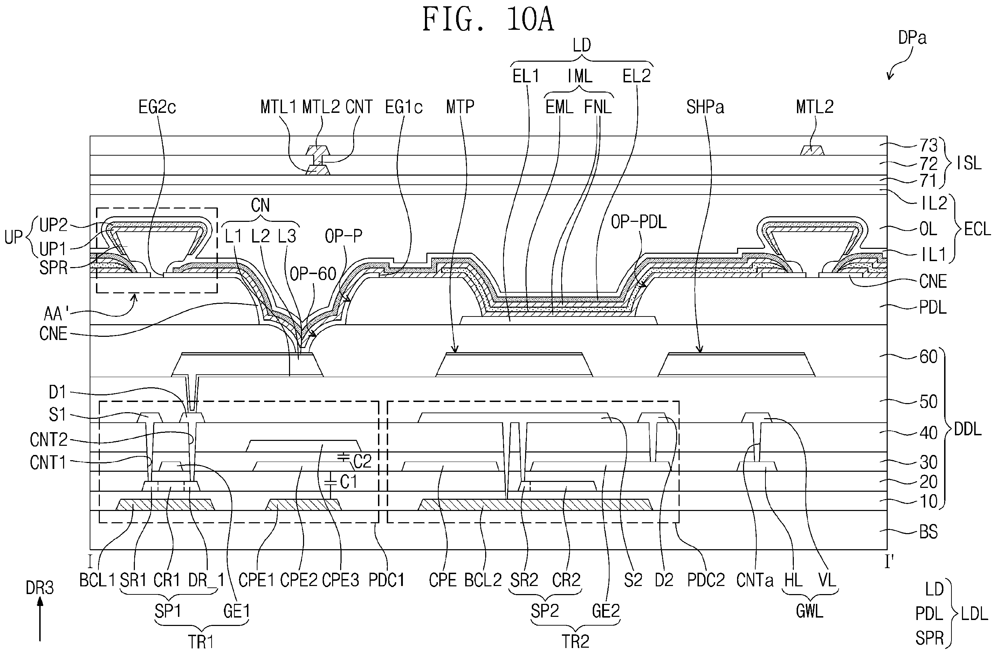

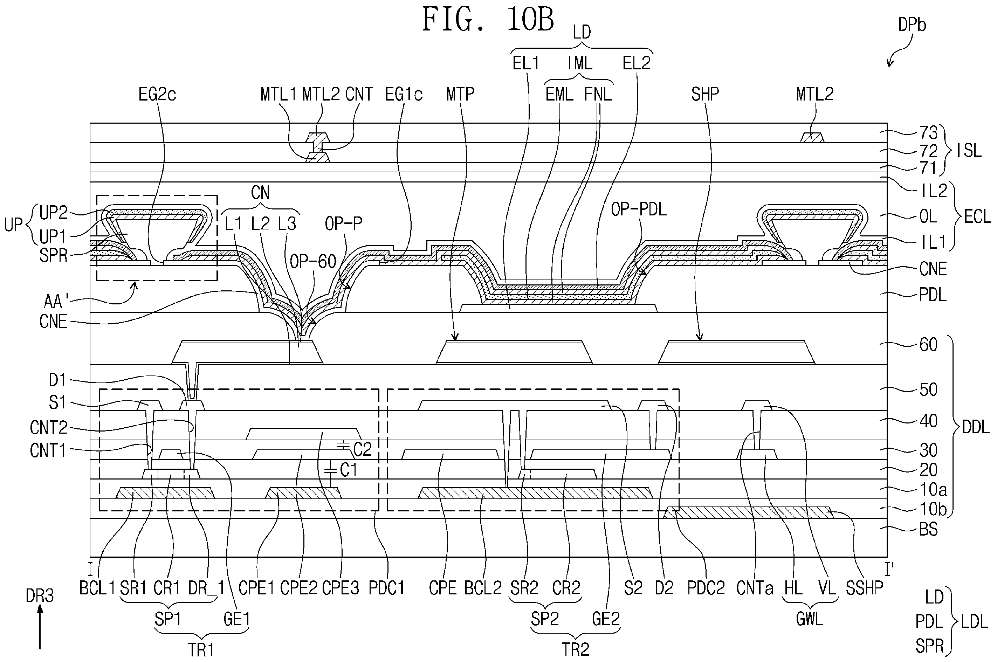

FIGS. 10A and 10B are cross-sectional views of a display panel according to an embodiment of the present disclosure illustrating a portion corresponding to line I-I' of FIG. 7A. Hereinafter, for convenience of explanation, a further description of components and technical aspects previously described will be omitted.

Referring to FIG. 10A, the display panel DPa according to an embodiment of the present disclosure may include a shield pattern SHPa that is disposed on a fifth insulation layer 50. According to an embodiment of the present disclosure, the shield pattern SHPa may overlap at least a portion of the vertical line VL and the second drain electrode pattern D2 on a plane. The shield pattern SHPa may be formed through the same process as that of the intermediate connection electrode CN. The shield pattern SHPa may be electrically connected to a third power source line VRL (see FIG. 4A), and a third power source voltage VREF may be applied thereto. The shield pattern SHPa may be connected to a third power source line VRL in the display area DA (see FIG. 5).

As the vertical line VL and the second drain electrode pattern D2 are shielded by using the shield pattern SHPa, to which a constant voltage is provided, coupling noise formed between the vertical line VL and the second drain electrode pattern D2 may be decreased or prevented.

Referring to FIG. 10B, a driving element layer DDL of the display panel DPb according to an embodiment of the present disclosure may include insulation layers 10a and 10b. According to an embodiment of the present disclosure, a sub-shield pattern SSHP disposed on the base layer BS may be included. The sub-shield pattern SSHP may be covered by the first insulation layer 10a, among the insulation layers 10a and 10b. According to an embodiment of the present disclosure, the sub-shield pattern SSHP may overlap at least a portion of the vertical line VL and the second drain electrode pattern D2 on a plane. The sub-shield pattern SSHP may be electrically connected to a second power source line VSL (see FIG. 4A), and a second power source voltage VSS (see FIG. 4A) may be applied thereto. The sub-shield pattern SSHP may be connected to a second power source line VSL in a display area DA (see FIG. 5). However, the present disclosure is not limited thereto, and the sub-shield pattern SSHP may be connected to the first power source line VDL (see FIG. 4A), and the first power source voltage (see VDD (see FIG. 4A) may be applied thereto.

Unlike the illustration of FIG. 10B, in an embodiment, the sub-shield pattern SSHP may be disposed on the same layer as the lower conductive layers BCL1 and BCL2. That is, the sub-shield pattern SSHP may be formed through the same process as that of the lower conductive layers BCL1 and BCL2. In this case, the sub-shield pattern SSHP may be referred to as a third lower conductive layer.

As the vertical line VL and the second drain electrode pattern D2 are shielded by using the sub-shield pattern SSHP, to which a constant voltage is provided, coupling noise formed between the vertical line VL and the second drain electrode pattern D2 may be decreased or prevented.

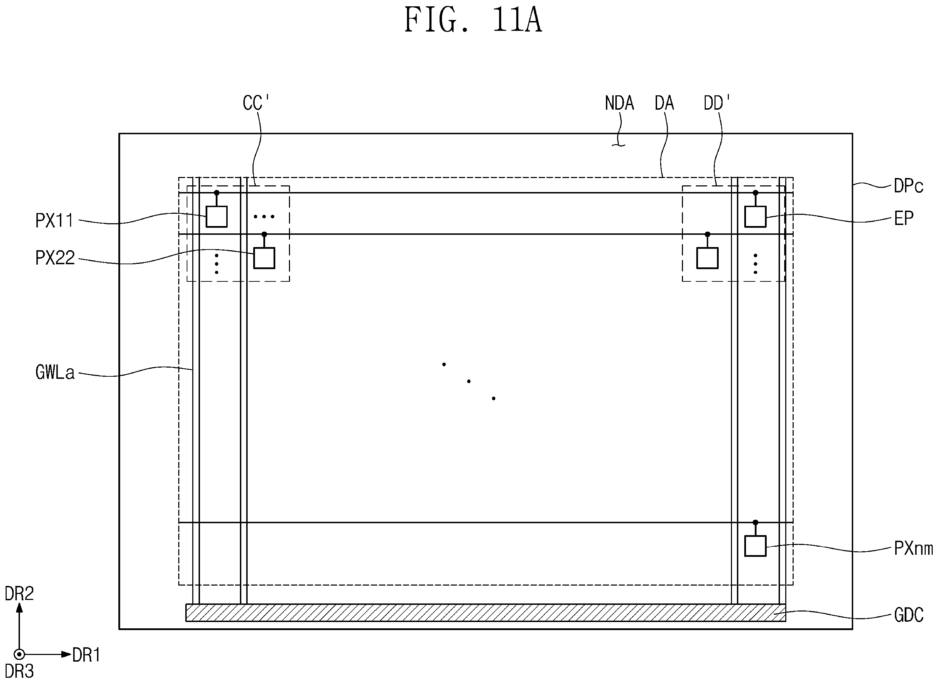

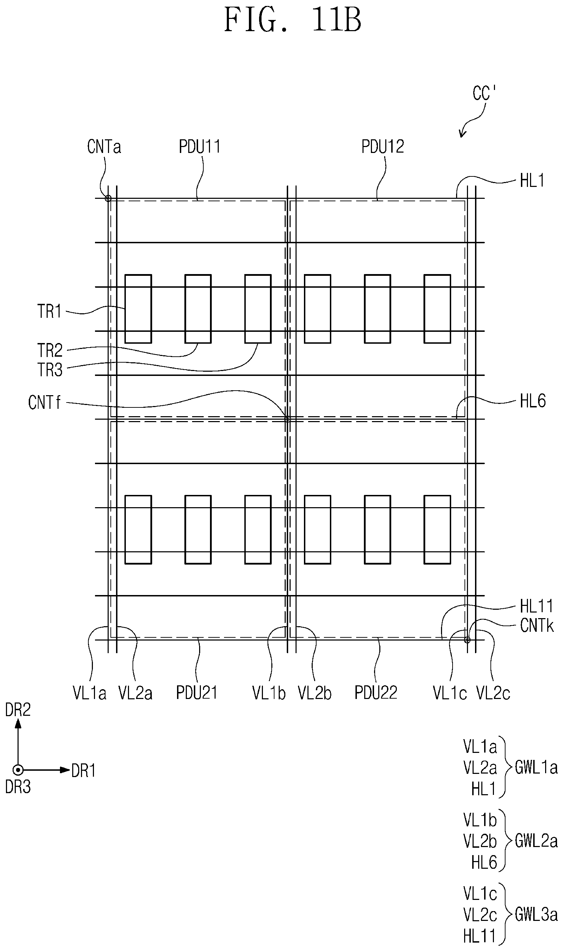

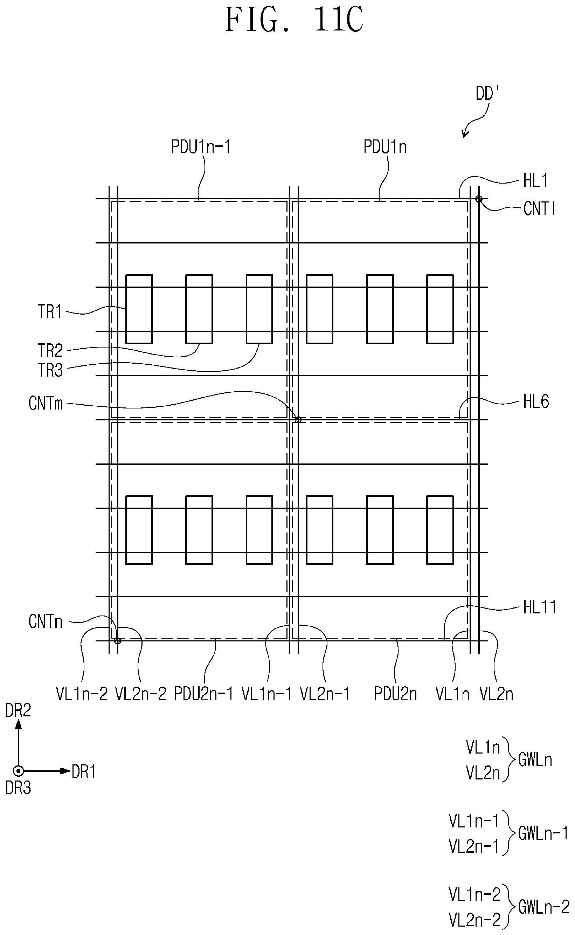

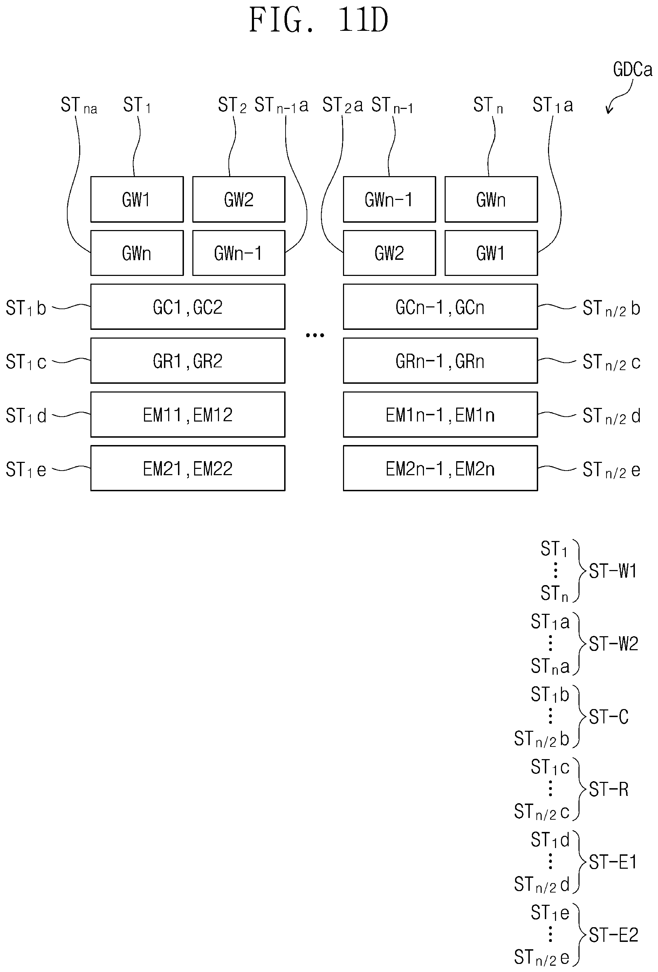

FIG. 11A is a plan view schematically illustrating a display panel according to an embodiment of the present disclosure. FIG. 11B is an enlarged cross-sectional view of area CC' of FIG. 11A. FIG. 11C is an enlarged cross-sectional view of area DD' of FIG. 11A. FIG. 11D is a block diagram of a gate driver according to an embodiment of the present disclosure. Hereinafter, for convenience of explanation, a further description of components and technical aspects previously described will be omitted.

Referring to FIG. 11A, the display panel DPc may include a write scan line GWLa. A plurality of write scan lines GWLa may be provided. The write scan line GWLa will be described in further detail with reference to FIGS. 11B and 11C.

Write scan lines GWL1a, GWL2a, GWL3a, GWLn-2, GWLn-1, and GWLn are illustrated in FIGS. 11B and 11C. The write scan lines GWL1a, GWL2a, GWL3a, GWLn-2, GWLn-1, and GWLn may be some of the write scan lines GWLa illustrated in FIG. 11A.

Referring to FIGS. 11A to 11C, the first scan write line GWL1a may include first vertical lines VL1a and VL2a that extend in the second direction DR2, and a first horizontal line HL1 that extends in the first direction DR1. The first vertical lines VL1a and VL2a and the first horizontal line HL1 may be disposed on different layers. The first vertical lines VL1a and VL2a may include a first sub-vertical line VL1a and a second sub-vertical line VL2a that are spaced apart from each other in the first direction DR1 and extend parallel to each other in the second direction DR2. The first sub-vertical line VL1a and the first horizontal line HL1 may be connected to each other through a contact hole CNTa. Hereinafter, the description of the write scan lines GWL2a, GWL3a, GWLn-2, GWLn-1, and GWLn may be similar to the description of the first scan write line GWL 1a.

The second scan write line GWL2a may include second vertical lines VL1b and VL2b and a sixth horizontal line HL6. The second vertical lines VL1b and VL2b may include a first sub-vertical line VL1b and a second sub-vertical line VL2b that are spaced apart from each other in the first direction DR1 and extend parallel to each other in the second direction DR2. The first sub-vertical line VL1b and the sixth horizontal line HL6 may be connected to each other through a contact hole CNTf.

The third scan write line GWL3a may include third vertical lines VL1c and VL2c and an eleventh horizontal line HL11. The third vertical lines VL1c and VL2c may include a first sub-vertical line VL1c and a second sub-vertical line VL2c that are spaced apart from each other in the first direction DR1 and extend parallel to each other in the second direction DR2. The first sub-vertical line VL1c and the eleventh horizontal line HL11 may be connected to each other through a contact hole CNTk.

The n-th scan write line GWLn may include n-th vertical lines VL1n and VL2n. In an embodiment, the n-th scan write line GWLn may further include a first horizontal line HL1. The n-th vertical lines VL1n and VL2n may include a first sub-vertical line VL1n and a second sub-vertical line VL2n that are spaced apart from each other in the first direction DR1 and extend parallel to each other in the second direction DR2. The second sub-vertical line VL2n and the first horizontal line HL1 may be connected to each other through a contact hole CNTl.

The (n-1)-th scan write line GWLn-1 may include (n-1)-th vertical lines VL1n-1 and VL2n-1. In an embodiment, the (n-1)-th scan write line GWLn-1 may further include a sixth horizontal line HL6. The (n-1)-th vertical lines VL1n-1 and VL2n-1 may include a first sub-vertical line VL1n-1 and a second sub-vertical line VL2n-1 that are spaced apart from each other in the first direction DR1 and extend parallel to each other in the second direction DR2. The second sub-vertical line VL2n-1 and the sixth horizontal line HL6 may be connected to each other through a contact hole CNTm.

The (n-2)-th scan write line GWLn-2 may include (n-2)-th vertical lines VL1n-2 and VL2n-2. In an embodiment, the (n-2)-th scan write line GWLn-2 may further include an eleventh horizontal line HL11. The (n-2)-th vertical lines VL1n-2 and VL2n-2 may include a first sub-vertical line VL1n-2 and a second sub-vertical line VL2n-2 that are spaced apart from each other in the first direction DR1 and extend parallel to each other in the second direction DR2. The second sub-vertical line VL2n-2 and the eleventh horizontal line HL11 may be connected to each other through a contact hole CNTn.

The first horizontal line HL1 may be connected to the first sub-vertical line VL1a and the second sub-vertical line VL2n, the sixth horizontal line HL6 may be connected to the first sub-vertical line VL1b and the second sub-vertical line VL2n-1, and the eleventh horizontal line HL11 may be connected to the first sub-vertical line VL1c and the second sub-vertical line VL2n-2.

FIG. 11D illustrates the stages ST-W1, ST-W2, ST-C, ST-R, ST-E1, and ST-E2 in a block diagram to describe the gate driver GDCa of FIG. 11A.

Referring to FIG. 11D, the gate driver GDCa may include a first write stage ST-W1, a second write stage ST-W2, a compensation stage ST-C, a reset stage ST-R, a first light emission stage ST-E1, and a second light emission stage ST-E2. The first write stage ST-W1 may include a plurality of stages ST1 to STn that are arranged sequentially, the second write stage ST-W2 may include a plurality of stages ST1a to STna that are arranged sequentially, the compensation stage ST-C may include a plurality of stages ST1b to STn/2b that are arranged sequentially, the reset stage ST-R may include a plurality of stages ST1c to STn/2c that are arranged sequentially, the first light emission stage ST-E1 may include a plurality of stages ST1d to STn/2d that are arranged sequentially, and the second light emission stage ST-E2 may include a plurality of stages ST1e to STn/2e that are arranged sequentially. According to an embodiment of the present disclosure, the plurality of stages ST1 to STn and the plurality of stages ST1a to STna may be arranged in opposite directions.

As illustrated in FIG. 11D, a plurality of stages ST1 to STn may output first to n-th write scan signals GW1 to GWn, a plurality of stages ST1a to STna may output first to n-th write scan signals GW1 to GWn, a plurality of stages ST1b to STn/2b may output first to n-th compensation scan signals GC1 to GCn, a plurality of stages ST1c to STn/2c may output first to n-th reset scan signals GR1 to GRn, a plurality of stages ST1d to STn/2d may output (1-1)-th to (1-n)-th light emission signals EM1-1 to EM1-n, and a plurality of stages ST1e to STn/2e may output (2-1)-th to (2-n)-th light emission signals EM2-1 to EM2-n.

Referring to FIGS. 11A to 11D, the pixels disposed in the first row, among a plurality of pixels PX11 to PXnm, may be connected to a first horizontal line HL1. For example, the first horizontal line HL1 may receive a first write scan signal GW1 from the first vertical line VL1a, and may receive the first write scan signal GW1 from the second sub-vertical line VL2n to supply it to the first row pixel driving units PDU11, PDU12, PDU1n-1, and PDU1n. That is, the first horizontal line HL1 may supply the first write scan signal GW1 to all of the pixel driving units disposed in the first row. All of the pixel driving units arranged in the first row may receive the same first write scan signal GW1. All of the pixel driving units disposed in the first row may receive the same first write scan signal GW1 on opposite sides thereof to decrease a delay of a signal applied depending on positions of the pixel driving units in the first row.

Referring to FIG. 8 and FIG. 11D, among the plurality of pixels PX11 to PXnm, the pixels that are disposed in the first row may be connected to a second horizontal line HL2, and the pixels that are disposed in the second row may be connected to a seventh horizontal line HL7. For example, the second horizontal line HL2 may receive the first compensation scan signal GC1 from the second vertical line VL2 to supply it to the first row pixel driving units PDU11, PDU12, PDU1n-1, and PDU1n, and may receive the second compensation scan signal GC2 from the second vertical line VL2 of the seventh horizontal line HL7 to supply it to the second row pixel driving units PDU21, PDU22, PDU2n-1, and PDU2n. That is, the second horizontal line HL2 may supply the first compensation scan signal GC1 to all of the pixel driving units disposed in the first row, and the seventh horizontal line HL7 may supply the second compensation scan signal GC2 to all of the pixel driving units disposed in the second row. According to an embodiment, the first compensation scan signal GC1 and the second compensation scan signal GC2 may be the same. That is, all of the pixel driving units disposed in the first row and the second row may receive the same compensation scan signal. Similarly, the first to n-th reset scan signals GR1 to GRn, the (1-1)-th to (1-n)-th light emission signals EM1 to EM1-n, and the (2-1)-th to (2-n)-th light emission signals EM2-1 to EM2-n may be applied to the plurality of pixels PX11 to PXnm.

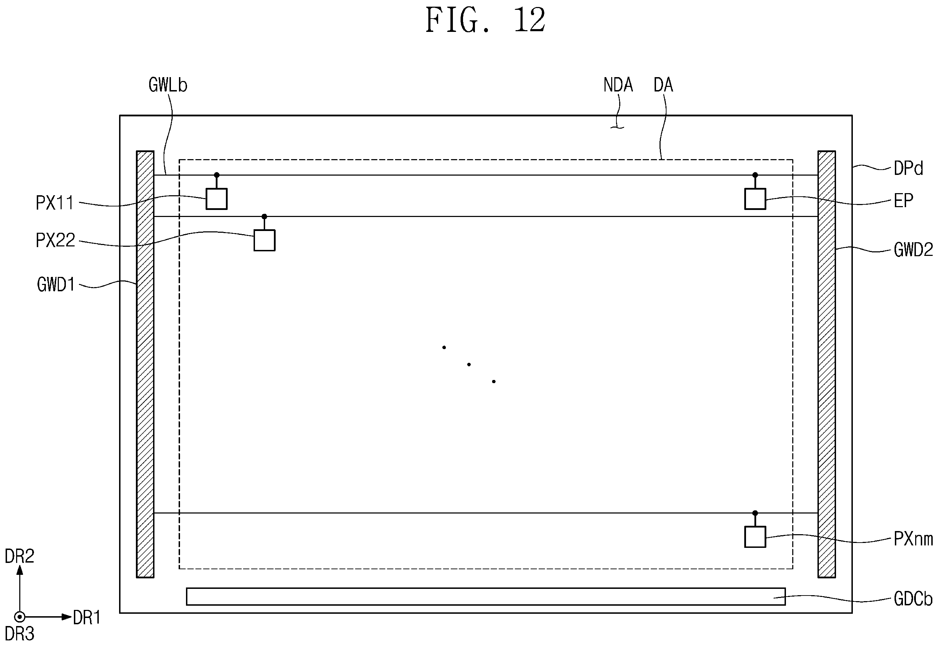

FIG. 12 is a plan view schematically illustrating a display panel according to an embodiment of the present disclosure.

Referring to FIG. 12, the display panel DPd according to an embodiment of the present disclosure may include a gate driver GDCb, a first driving part GWD1, and a second driving part GWD2. The first driving part GWD1 may be connected to sides of the write signal lines GWLb, and the second driving part GWD2 may be connected to the opposite sides of the write signal lines GWLb. The first driving part GWD1 may be disposed in a first area (e.g., a left area) of the non-display area NDA, the second driving part GWD2 may be disposed in a second area (e.g., a right area) of the non-display area NDA, and the gate driver GDCb may be disposed in a third area (e.g., a lower area) of the non-display area NDA.

Referring to FIGS. 11D and 12, the first driving part GWD1 may include a first write stage ST-W1, the second driving part GWD2 may include a second write stage ST-W2, and the gate driver GDCb may include a compensation stage ST-C, a reset stage ST-R, a first light emission stage ST-E1, and a second light emission stage ST-E2. That is, the first driving part GWD1 may output the first to n-th write scan signals GW1 to GWn, the second driving part GWD2 may output the first to n-th write scan signals GW1 to GWn, and the gate driver GDCb may output the first to n-th compensation scan signals GC1 to GCn, the first to n-th reset scan signals GR1 to GRn, the (1-1)-th to (1-n)-th light emission signals EM1-1 to EM1-n, and the (2-1)-th to (2-n)-th light emission signals EM2-1 to EM2-n.

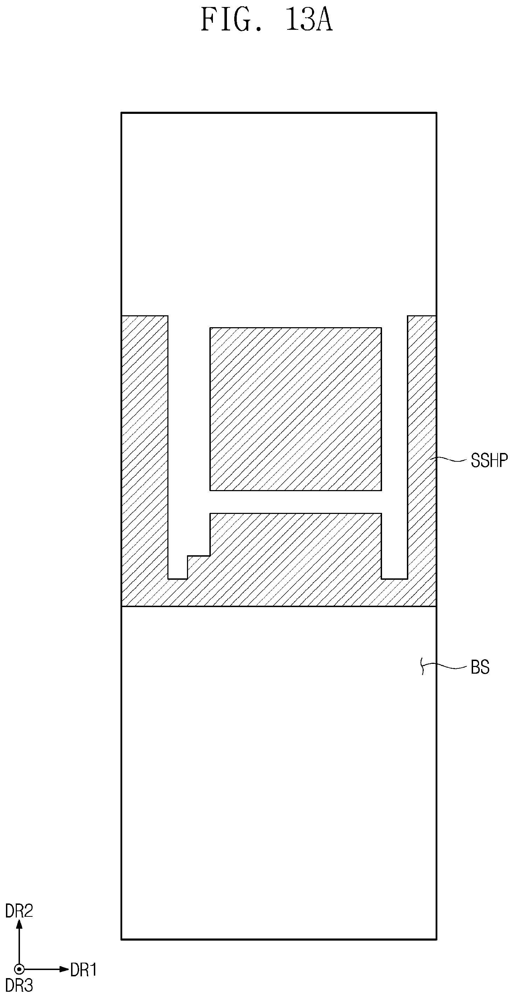

FIGS. 13A to 13G are process diagrams illustrating a disposition order of circuit layers according to an embodiment of the present disclosure.

Referring to FIGS. 13A to 13G, on a plane, each of the conductive patterns and the semiconductor patterns may have a structure that is repeatedly arranged following a specific rule or pattern. In FIGS. 13A to 13G, a portion of one of the first to third pixel drivers PDC1, PDC2, and PDC3 illustrated in FIG. 6 is illustrated.

Referring to FIG. 13A, a sub-shield pattern SSHP may be formed on a base layer BS. The sub-shield pattern SSHP may correspond to the sub-shield pattern SSHP illustrated in FIG. 10B. The sub-shield pattern SSHP may be disposed under the second drain electrode pattern D2 provided in the second pixel driver PDC2 (see FIG. 10B). The sub-shield pattern SSHP may be connected to a second power source line VSL in a display area DA (see FIG. 5). However, the present disclosure is not limited thereto, and the sub-shield pattern SSHP may be connected to the first power source line VDL (see FIG. 4A), and the first power source voltage VDD (see FIG. 4A) may be applied thereto.

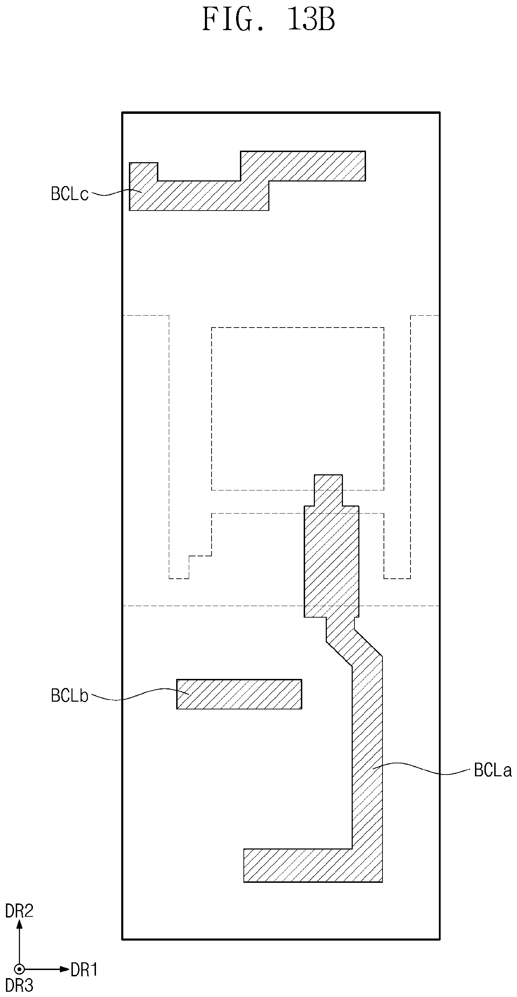

Referring to FIGS. 13A and 13B, lower conductive layers BCLa, BCLb, and BCLc may be disposed on the sub-shield pattern SSHP. The lower conductive layers BCLa, BCLb, and BCLc may shield light that is input to the transistor TR1 or TR2 (see FIG. 9A) from a lower portion thereof.

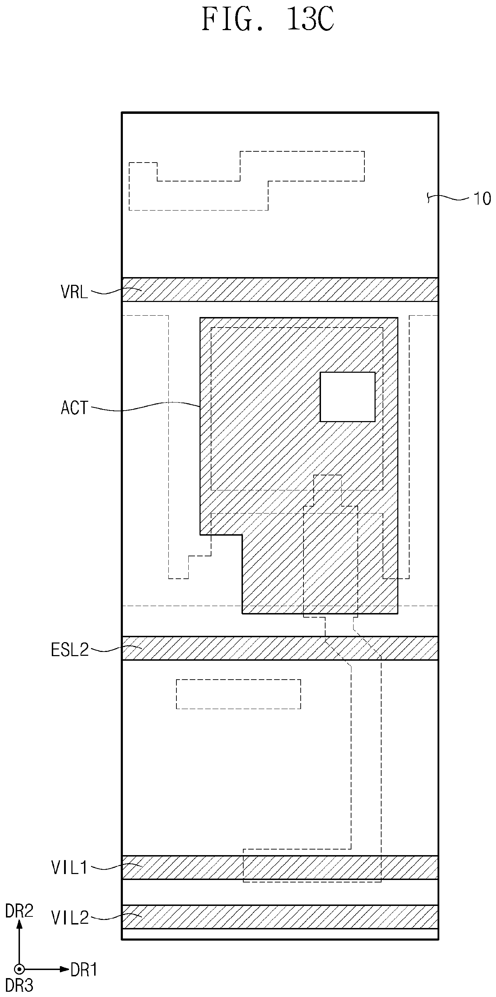

Referring to FIG. 13C, a semiconductor pattern layer ACT may be disposed on the first insulation layer 10. The semiconductor pattern layer ACT may include a silicon semiconductor. For example, the silicon semiconductor may include amorphous silicon, polycrystalline silicon, or the like. For example, the semiconductor pattern layer ACT may include low-temperature polysilicon (LTPS). The semiconductor pattern layer ACT may correspond to the second semiconductor pattern SP2 illustrated in FIG. 9A.

A reference voltage line VRL, a second light emission line ESL2, a first initialization voltage line VIL1, and a second initialization voltage line VIL2 may be further disposed on the first insulation layer 10. Each of the reference voltage line VRL, the second light emission line ESL2, the first initialization voltage line VIL1, and the second initialization voltage line VIL2 may extend in the first direction DR1.

The reference voltage line VRL may correspond to the third power source line VRL of FIG. 4C. For example, the reference voltage VREF (see FIG. 4C) may be provided as the reference voltage line VRL. The reference voltage line VRL may constitute the third transistor T3 of FIG. 4C.

The second light emission line ESL2 may correspond to the i-th second light emission line ESL2i of FIG. 4C. The second light emission signal EM2 (see FIG. 4c) may be provided as a second light emission line ESL2. The second light emission line ESL2 may constitute the fifth transistor T5a of FIG. 4C.

The first initialization voltage line VIL1 may correspond to the fourth power source line VIL1 of FIG. 4A. For example, the first initialization voltage VINT1 (see FIG. 4A) may be provided as the first initialization voltage line VIL1. The first initialization voltage line VIL1 may constitute the fourth transistor T4 of FIG. 4A.

The second initialization voltage line VIL2 may correspond to the fifth power source line VIL2 of FIG. 4A. For example, the second initialization voltage VINT2 (see FIG. 4A) may be provided as the second initialization voltage line VIL2. The second initialization voltage line VIL2 may constitute the eighth transistor T8 of FIG. 4A.

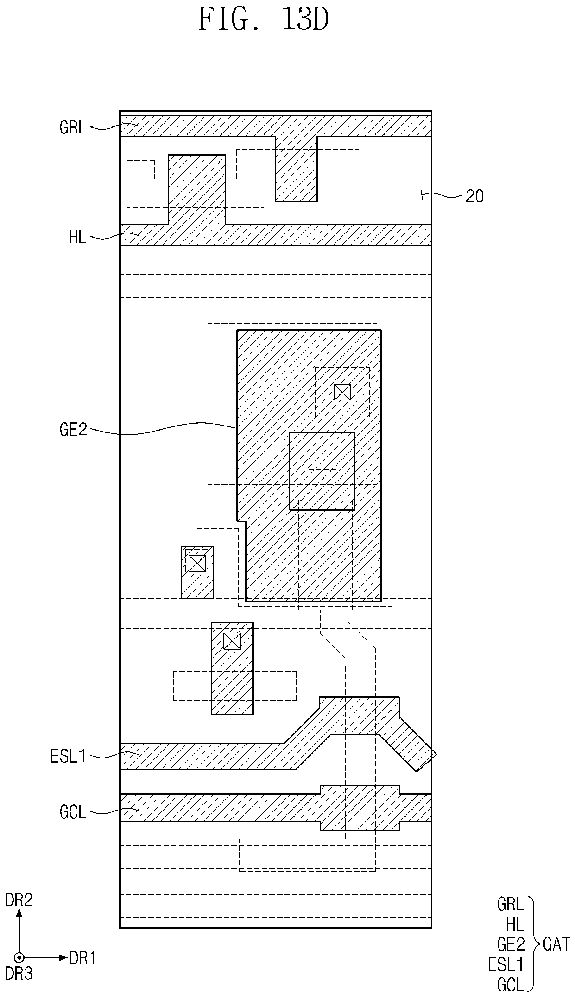

Referring to FIGS. 13C and 13D, the second insulation layer 20 may be disposed on the first insulation layer 10 while covering the semiconductor pattern layer ACT. A gate pattern layer GAT may be disposed on the second insulation layer 20. The gate pattern layer GAT may include, for example, a metal, an alloy, a conductive metal oxide, a transparent conductive material, or the like. For example, the gate pattern layer GAT may include silver (Ag), an alloy containing silver, molybdenum (Mo), an alloy containing molybdenum, aluminum (Al), an alloy containing aluminum (Al), aluminum nitride (AlN), tungsten (W), tungsten nitride (WN), copper (Cu), indium tin oxide (ITO), indium zinc oxide (IZO), or the like, but the present disclosure is not particularly limited thereto.

The gate pattern layer GAT may include a second gate electrode GE2, a reset scan line GRL, a horizontal line HL, a first light emission line ESL1, and a compensation scan line GCL. Each of the reset scan line GRL, the horizontal line HL, the first light emission line ESL1, and the compensation scan line GCL may extend in the first direction DR1.

The second gate electrode GE2 may be disposed in an island shape. The second gate electrode GE2 may constitute the second transistor T2 of FIG. 9A together with a semiconductor pattern layer ACT (see FIG. 13C).

The reset scan line GRL may correspond to the i-th fifth scan line GRLi of FIG. 4C. For example, the reset scan signal GR (see FIG. 4C) may be provided as the reset scan line GRL. The reset scan line GRL may constitute the third transistor T3 of FIG. 4C.

The horizontal line HL may correspond to one configuration of the i-th write scan line GWLi of FIG. 4C. For example, the write scan signal GW (see FIG. 4C) may be provided as the horizontal line HL. The horizontal line HL may constitute the second transistor T2 of FIG. 4C.

The first light emission line ESL1 may correspond to the i-th first light emission line ESL1i of FIG. 4C. The first light emission signal EM1 (see FIG. 4C) may be provided as the first light emission line ESL1. The first light emission line ESL1 may constitute the fourth transistor T4a of FIG. 4C.

The compensation scan line GCL may correspond to the i-th second scan line GCLi of FIG. 4C. For example, a compensation scan signal GC (see FIG. 4C) may be provided as the compensation scan line GCL. The compensation scan line GCL may constitute the sixth transistor T6a of FIG. 4C.

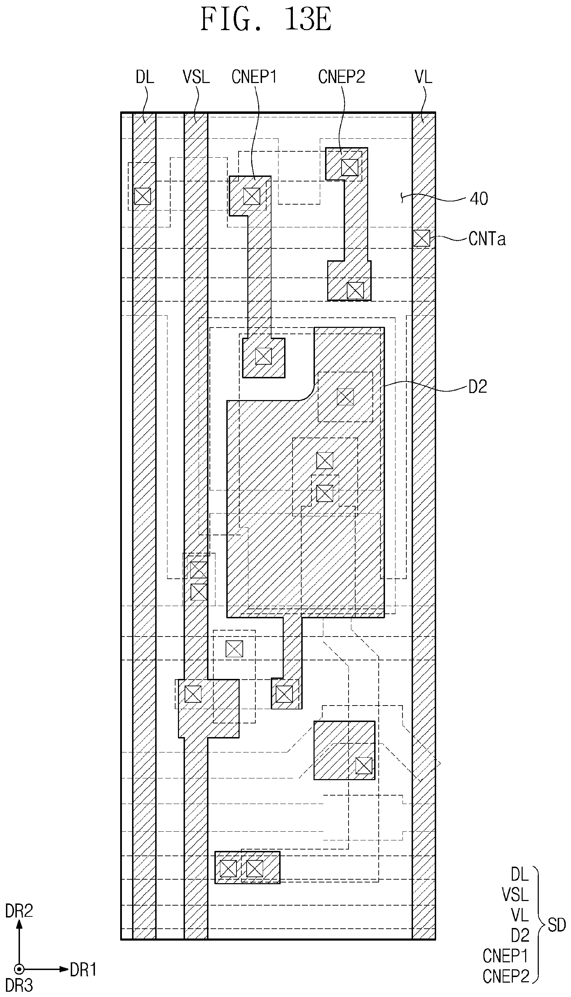

Referring to FIG. 13E, a data pattern layer SD may be disposed on the fourth insulation layer 40. For example, the data pattern layer SD may include a metal, an alloy, a conductive metal oxide, a transparent conductive material, and the like.

The data pattern layer SD may include a second drain electrode pattern D2, connection patterns CNEP1 and CNEP2, a data line DL, a second power source line VSL, and a vertical line VL. Each of the data line DL, the second power source line VSL, and the vertical line VL may extend in the second direction DR2.

The second drain electrode pattern D2 may correspond to the second drain electrode pattern D2 of FIG. 9A. The second drain electrode pattern D2 may be connected to the second gate electrode GE2 through a contact hole.

The connection patterns CNEP1 and CNEP2 may include a first connection pattern CNEP1 and a second connection pattern CNEP2. The first connection pattern CNEP1 and the second connection pattern CNEP2 may correspond to the second source electrode pattern S2 of FIG. 9A.

The data line DL may correspond to one configuration of the j-th data line DLj of FIG. 4C. For example, the data signal DATA (see FIG. 4C) may be provided to the data line DL. The data line DL may constitute the second transistor T2 of FIG. 4C.

The second power source line VSL may correspond to the second power source line VSL of FIG. 4C. For example, the second power source voltage VSS (see FIG. 4C) may be provided to the second power source line VSL. The second power source line VSL may be disposed in a mesh shape in the display area DA (see FIG. 5) of the display panel DP. The second power source line VSL may be connected to the fifth transistor T5a and the second capacitor C2 illustrated in FIG. 4C through a contact part.

The vertical line VL may correspond to one configuration of the i-th write scan line GWLi of FIG. 4C. For example, the write scan signal GW (see FIG. 4C) may be provided to a vertical line VL. The vertical line VL may constitute the second transistor T2 of FIG. 4C. The vertical line VL may be electrically connected to the horizontal line HL (see FIG. 13D) through a contact hole CNTa.

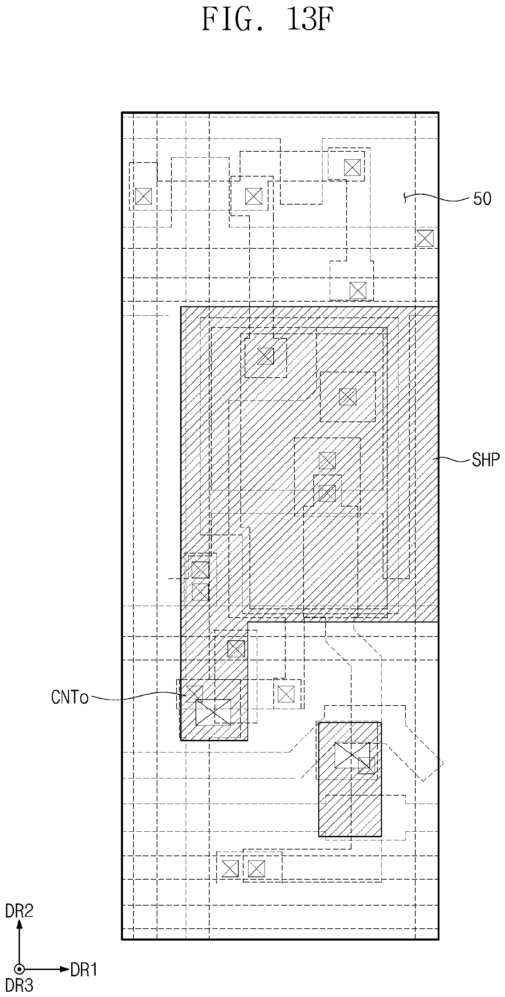

Referring to FIGS. 13E and 13F, a shield pattern SHP may be disposed on the fifth insulation layer 50. For example, the shield pattern SHP may include a metal, an alloy, a conductive metal oxide, a transparent conductive material, and the like. The shield pattern SHP may be disposed in an island shape. The shield pattern SHP may overlap at least a portion of the vertical line VL and the second drain electrode pattern D2 on a plane. However, the present disclosure is not limited thereto, and the shield pattern SHP may extend along the vertical line VL.

The shield pattern SHP may be connected to a second power source line VSL through a contact hole CNTo. The shield pattern SHP may receive a second power source voltage VSS (see FIG. 4C) through the second power source line VSL. As the vertical line VL and the second drain electrode pattern D2 are shielded by using the shield pattern SHP, to which a constant voltage is provided, coupling noise formed between the vertical line VL and the second drain electrode pattern D2 may be decreased or prevented.

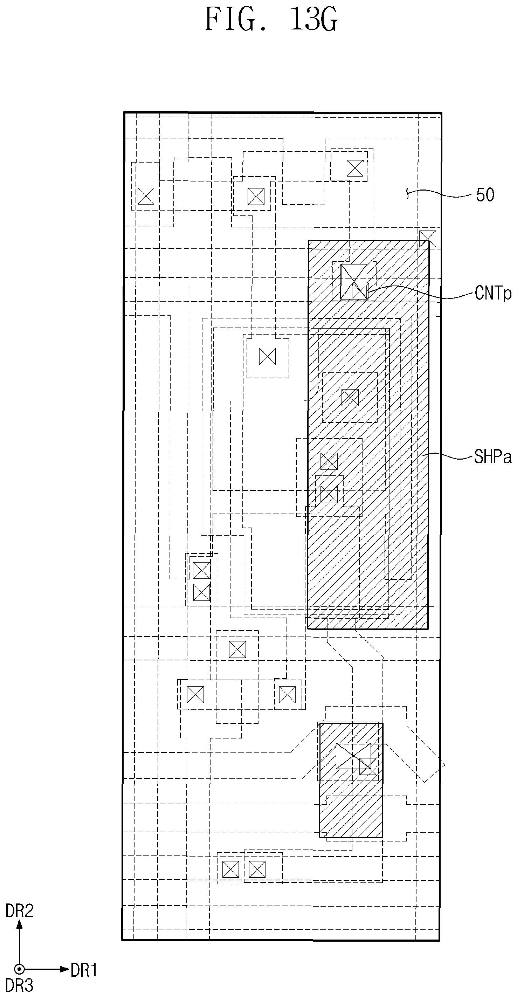

Referring to FIGS. 13E and 13G, a shield pattern SHPa may be disposed on the fifth insulation layer 50. For example, the shield pattern SHP may include a metal, an alloy, a conductive metal oxide, a transparent conductive material, and the like. The shield pattern SHP may be disposed in an island shape. The shield pattern SHP may overlap at least a portion of the vertical line VL and the second drain electrode pattern D2 on a plane. However, the present disclosure is not limited thereto, and the shield pattern SHP may overlap the entire second drain electrode pattern D2.

The shield pattern SHPa may be connected to a reference voltage line VRL (see FIG. 13C) through a contact hole CNTp. The shield pattern SHPa may receive a reference voltage VREF (see FIG. 4C) through the reference voltage line VRL. As the vertical line VL and the second drain electrode pattern D2 are shielded by using the shield pattern SHPa, to which a constant voltage is provided, coupling noise formed between the vertical line VL and the second drain electrode pattern D2 may be decreased or prevented.

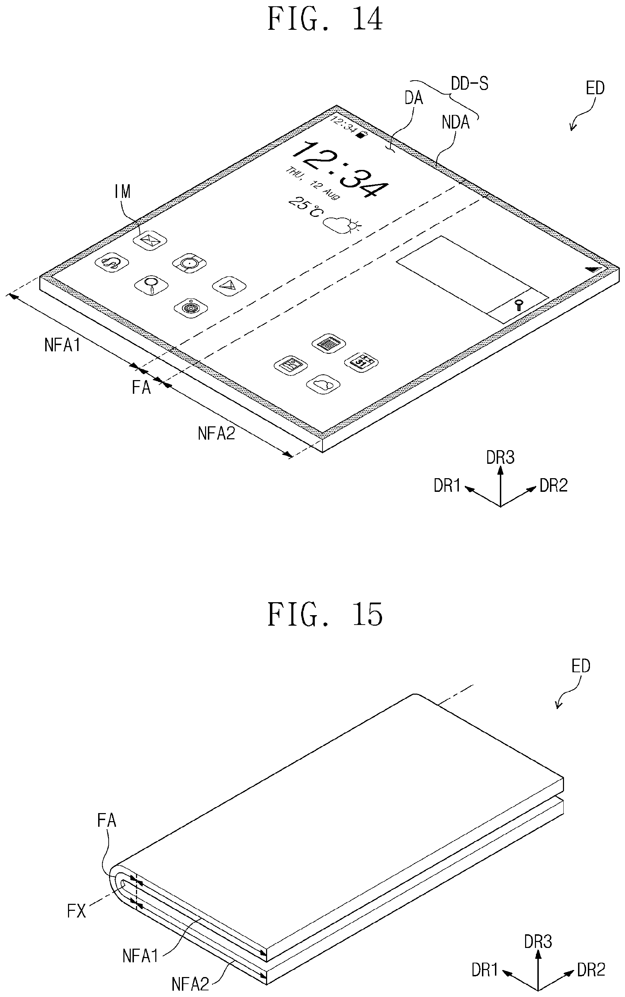

FIG. 14 is a perspective view of an electronic device according to an embodiment of the present disclosure. FIG. 15 is a view illustrating a folded state of the electronic device illustrated in FIG. 14.

Referring to FIG. 14, an electronic device ED according to an embodiment of the present disclosure may have a rectangular shape having short sides (relative to long sides) extending in a first direction DR1 and long sides (relative to the short sides) extending in a second direction DR2 intersecting the first direction DR1. However, the present disclosure is not limited thereto, and the electronic device ED may have various shapes such as, for example, a circular shape and a polygonal shape. The electronic device ED may be flexible.

The electronic device ED may include a folding area FA and a plurality of non-folding areas NFA1 and NFA2. The non-folding areas NFA1 and NFA2 may include a first non-folding area NFA1 and a second non-folding area NFA2. The folding area FA may be disposed between the first non-folding area NFA1 and the second non-folding area NFA2. The folding area FA, the first non-folding area NFA1, and the second non-folding area NFA2 may be arranged in the first direction DR1.

Although one folding area FA and two non-folding areas NFA1 and NFA2 are illustrated in FIG. 14, the numbers of folding areas FA and the non-folding areas NFA1 and NFA2 are not limited thereto. For example, the electronic device ED may include more than two non-folding areas and a plurality of folding areas arranged between the non-folding areas.

An upper surface of the electronic device ED may be defined as a display surface DS, and the display surface DS may have the plane defined by the first direction DR1 and the second direction DR2. Images IM generated by the electronic device ED may be provided to a user through the display surface DS.

The display surface DS may include a display area DA and a non-display area NDA disposed around the display area DA. An image may be displayed in the display area DA, and an image is not displayed in the non-display area NDA. The non-display area NDA may surround the display area DA and may define an edge of the electronic device ED, and may be printed in a predetermined color (e.g., the non-display area NDA may correspond to a bezel area).

Referring to FIG. 15, the electronic device ED may be a foldable electronic device ED that is folded or unfolded. For example, the folding area FA may be bent with respect to a folding axis FX parallel to the second direction DR2, and thus, the electronic device ED may be folded. The folding axis FX may be defined as a long axis parallel to the long sides of the electronic device ED. When the electronic device ED is folded, the first non-folding area NFA1 and the second non-folding area NFA2 may face each other, and the electronic device ED may be in-folded so that the display surface DS is not exposed to the outside. However, embodiments of the present disclosure are not limited thereto. For example, according to embodiments, the electronic device ED may be out-folded so that the display surface DS is exposed to the outside about the folding axis FX. Further, the electronic device ED may be capable of being both in-folded and out-folded.

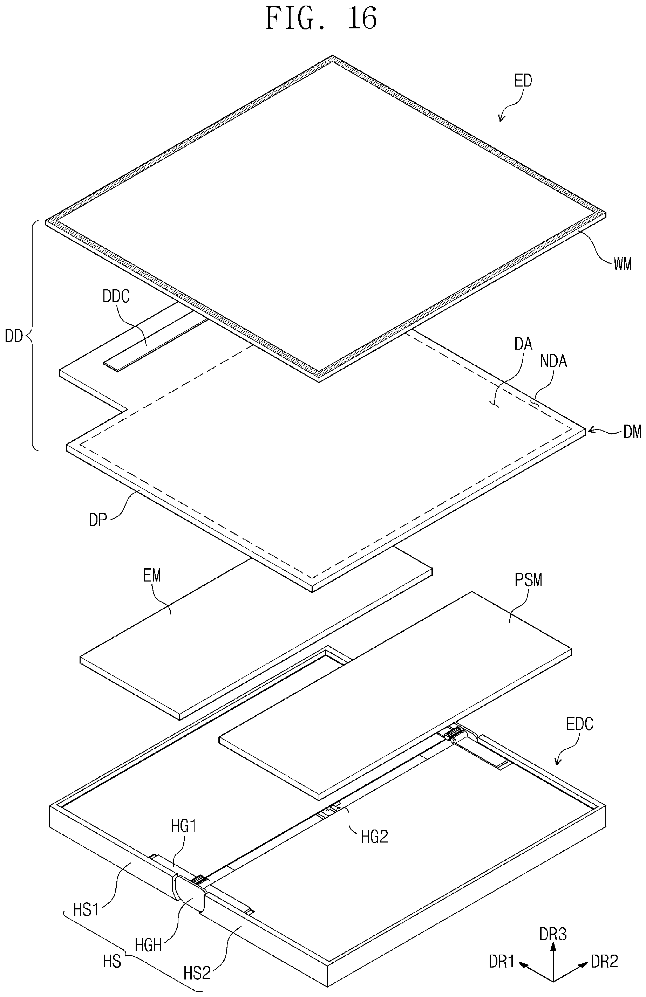

FIG. 16 is an exploded perspective view of the electronic device illustrated in FIG. 14.

Referring to FIG. 16, the electronic device ED may include a display device DD, an electronic module EM, a power supply module PSM, and a hinge module EDC. The electronic device ED may further include a mechanical structure (e.g., a hinge) for controlling a folding operation of the display device DD.

The display device DD may generate an image and sense an external input. The display device DD may include a window module WM and a display module DM. The window module WM may provide a front surface of the electronic device ED. The window module WM may be disposed on the display module DM to protect the display module DM. The window module WM may transmit light generated by the display module DM and provide the light to the user.

The display module DM may include a display panel DP. FIG. 16 illustrates only the display panel DP among laminated structures of the display module DM, but substantially, the display module DM may further include a plurality of components arranged on an upper side and a lower side of the display panel DP. The display panel DP may include a display area DA and a non-display area NDA corresponding to the display area DA and the non-display area NDA of FIG. 14 of the electronic device ED.

The display module DM may include a data driver DDC disposed on the non-display area NDA of the display panel DP. The data driver DDC may be directly manufactured in the form of a circuit chip and mounted on the non-display area NDA. However, the present disclosure is not limited thereto, and the data driver DDC may be mounted on a flexible circuit board connected to the display panel DP according to embodiments.

The electronic module EM and the power supply module PSM may be arranged inside the hinge module EDC. In an embodiment, as shown in FIG. 14, the electronic module EM and the power supply module PSM are exposed to the outside from the hinge module EDC. In an embodiment, the electronic module EM and the power supply module PSM may be connected to each other through a separate flexible circuit board. The electronic module EM may control an operation of the display device DD. The power supply module PSM may supply power to the electronic module EM.

The hinge module EDC may accommodate the display device DD, the electronic module EM, and the power supply module PSM. The hinge module EDC may include first and second housings HS1 and HS2 for folding the display device DD. The first and second housings HS1 and HS2 may extend in the second direction DR2 and may be arranged in the first direction DR1.

The hinge module EDC may include a housing assembly HS. The housing assembly HS may include the first housing HS1 and the second housing HS2 spaced apart from each other in the first direction DR1 and a hinge housing HGH disposed between the first housing HS1 and the second housing HS2. The hinge module EDC may further include hinges HG1 and HG2 for connecting the first and second housings HS1 and HS2, a plurality of main plates, and a plurality of moving plates.

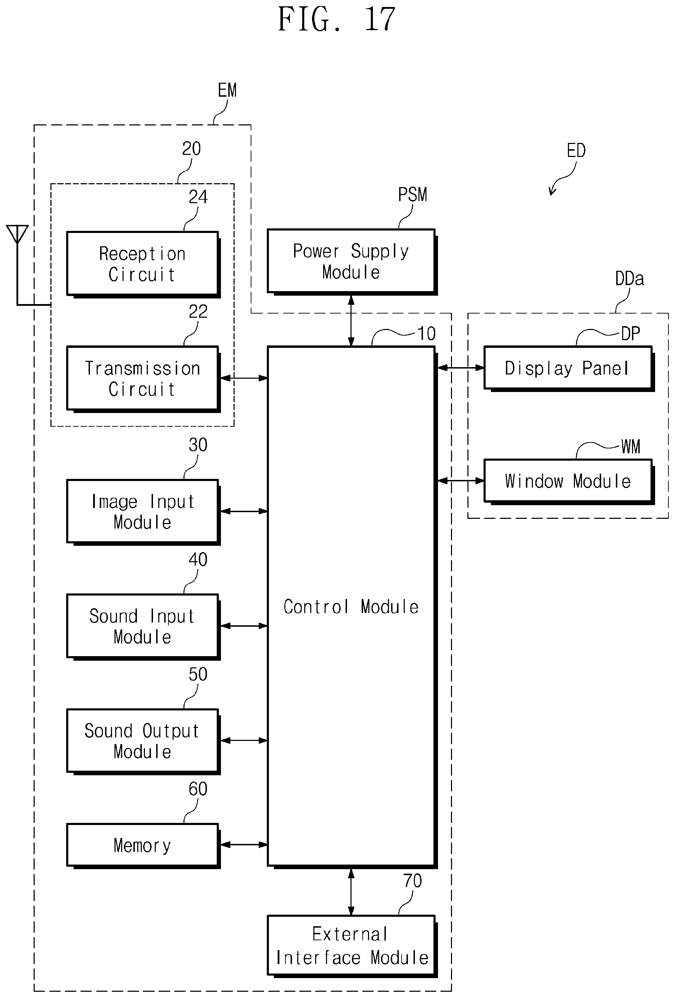

FIG. 17 is a block diagram of the electronic device illustrated in FIG. 14.

Referring to FIG. 17, the electronic device ED may include the electronic module EM, the power supply module PSM, and the display device DD. The electronic module EM may include a control module 10, a wireless communication module 20, an image input module 30, a sound input module 40, a sound output module 50, a memory 60, an external interface module 70, and the like. The modules may be mounted on a circuit board or may be electrically connected through a flexible circuit board. The electronic module EM may be electrically connected to the power supply module PSM.

The control module 10 may control an overall operation of the electronic device ED. For example, the control module 10 may activate or deactivate the display device DD in accordance with a user input. The control module 10 may control the image input module 30, the sound input module 40, the sound output module 50, and the like in accordance with the user input. The control module 10 may include at least one microprocessor.

The wireless communication module 20 may transmit/receive a wireless signal to/from another terminal using a Bluetooth line or a Wi-Fi line. The wireless communication module 20 may transmit/receive a voice signal using a general communication line. The wireless communication module 20 may include a transmission circuit 22 for modulating and transmitting a signal to be transmitted, and a reception circuit 24 for demodulating a received signal.

The image input module 30 may process an image signal and convert the image signal into image data that may be displayed on the display device DD. The sound input module 40 may receive an external sound signal through a microphone in a recording mode or a voice recognition mode and convert the received external sound signal into electrical voice data. The sound output module 50 may convert sound data received from the wireless communication module 20 or sound data stored in the memory 60, and output the converted sound data.

The external interface module 70 may serve as an interface connected to an external charger, a wired/wireless data port, and a card socket (e.g., a memory card, a subscriber identity module (SIM)/user interface model (UIM) card).

The power supply module PSM may supply power utilized for an overall operation of the electronic device ED. The power supply module PSM may include a general battery device.

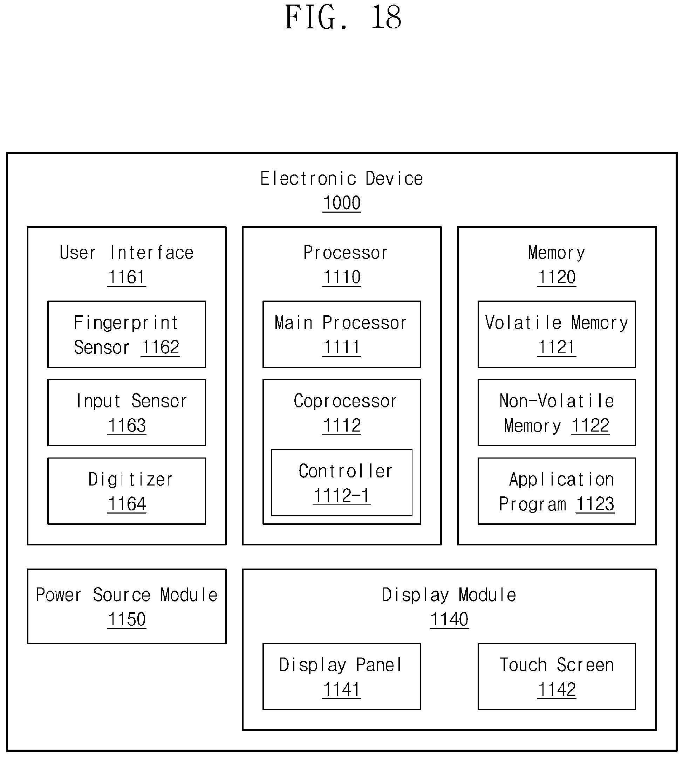

FIG. 18 is a diagram illustrating an electronic device according to an embodiment of the present disclosure.

Referring to FIG. 18, the electronic device 1000 according to an embodiment of the present disclosure may output various information (e.g., images, text, music, etc.) through a display module 1140, which, for example, may correspond to the display device DD described above. When a processor 1110 executes an application stored in a memory 1120, the display module 1140 may provide application information to a user through a display panel 1141.

In some embodiments, the electronic device 1000 may be configured as, for example, a smartphone, camera, smart TV, monitor, smartwatch, tablet, automotive display, or AR/VR headset. For example, the electronic device 1000 may be a smartphone including a touch-sensitive display area DA for interaction and a non-display area NDA including sensors and circuits for enhanced functionality. For example, the electronic device 1000 may be a television or monitor including a large display area DA for high-resolution video playback and a non-display area NDA incorporating driving circuits or connectivity modules for external inputs. For example, the electronic device 1000 may be a smartwatch including a display area DA optimized for compact and high-clarity visuals and a non-display area NDA integrating biometric sensors for health monitoring. In some cases, the electronic device 1000 be an AR/VR headset.

In some embodiments, memory 1120 may store information such as software codes for operating an application program 1123. The application program 1123 may include software designed to execute specific tasks or provide functionality to a user. The application program 1123 may operate under the control of the processor 1110 and utilizes data stored in the memory 1120 to deliver a wide range of features, such as, for example, productivity tools, multimedia streaming and playback, file or mail deliveries or communication services. The application program 1123 interacts seamlessly with the user interface 1161 or touch screen 1142, allowing a user to launch, navigate, and utilize the program through user inputs such as, for example, touch, tap, gesture, or voice interaction.

Upon user selection of an application via touch screen 1142 or user interface 1161, the processor 1110 may execute the application program 1123 corresponding to the selected application retrieved from the memory 1120 to perform functionalities of the application. For example, when a user selects a camera application by tapping the icon (or a camera application icon) presented on the display panel 1141, the processor 1110 activates a camera module. The processor 1110 may transmit image data corresponding to a captured image acquired through the camera module to the display module 1140. The display module 1140 may display an image corresponding to the captured image through the display panel 1141.

In an embodiment, when a user wishes to make a phone call, the user taps the telephone icon displayed on the display module 1140, and the processor 1110 may execute a phone application program stored in the memory 1120. A telephone keypad may be presented on the display panel 1141 for the user to enter a phone number to call.

In an embodiment, the display module 1140 may be integrated into an electronic device 1000, such as, for example, a laptop computer, smart TV, or tablet. A user wishing to access a multimedia streaming application (e.g., to watch a music video or movie) can do so by tapping the corresponding icon. This action activates the application, allowing the user to view the streamed content.

The processor 1110 may include a main processor 1111 and an auxiliary or coprocessor 1112. The main processor 1111 may include a central processing unit (CPU). The main processor 1111 may further include one or more of a graphics processing unit (GPU), a communication processor (CP), and an image signal processor (ISP).

The coprocessor 1112 may include a controller 1112-1. The controller 1112-1 may include an interface conversion circuit and a timing control circuit. The controller 1112-1 may receive an image signal from the main processor 1111, convert the data format of the image signal to match the interface specifications with the display module 1140, and output image data. The controller 1112-1 may output various control signals to drive the display module 1140. For example, the controller 1112-1 may drive the display module 1140 to display the icon on the display screen suitable for selection by a user to cause execution of an application program 1123.

The memory 1120 may store one or more application programs 1123 and various data used by at least one component (for example, the processor 1110 or the user interface 1161) of the electronic device 1000 and input data or output data for commands related thereto. For example, a camera application program, a GPS application program, an augmented reality and virtual reality application program, and other application programs that can be executed by the processor 1110 upon selection of corresponding icons presented on the display screen (or display panel 1141) via the touch screen 1142 or user interface 1161 by the user. In addition, various setting data corresponding to user settings may be stored in the memory 1120. The memory 1120 may include volatile memory 1121 and non-volatile memory 1122.

The display module 1140 may output visual information (images) to the user. The display module 1140 may include the display panel 1141, a gate driver, the source driver, a voltage generation circuit, and a touch screen 1142. The display module 1140 may further include a window, a chassis, and a bracket to protect the display panel 1141. The display module 1140 may include at least a part of the configuration of the display device DD described above.

The user interface 1161 serves as the interaction medium between a user and the electronic device 1000. The user interface 1161 may detect an input by a part (e.g., finger) of a user's body or an input by a pen or a mouse, and generate an electric signal or data value corresponding to the input. The user interface 1161 includes the fingerprint sensor 1162, the input sensor 1163, and a digitizer 1164.

The fingerprint sensor 1162 may sense a fingerprint for biometric recognition of the user and may also measure one or more biological signals such as, for example, blood pressure, moisture, or body mass.

The input sensor 1163 may sense user interactions including, for example, touch, tap, gesture, motion, spoken command, and eye movement. The input sensor 1163 includes optical sensors for image capture, eye tracking, or motion and gesture detection. Optical sensors may be infrared or semiconductor photodetectors. The input sensor 1163 includes audio and acoustic sensors, which may be MEMS microphones for voice recognition or sound-based interaction. The audio and acoustic sensors can be installed as part of the user interface 1161 or embedded in the display panel 1141.

The digitizer 1164 may generate a data value corresponding to coordinate information of input by a pen or a mouse to control movement of an onscreen cursor. The digitizer 1164 may generate the amount of change in electromagnetic due to the input as the data value. The digitizer may detect an input by a passive pen or transmit and receive data with an active pen or a remote.

At least one of the fingerprint sensor 1162, the input sensor 1163, or the digitizer 1164 may be implemented as a sensor layer formed on the top layer of the display panel 1141 through a continuous process with a process of forming elements (for example, the light emitting element, the transistor, and the like) included in the display panel 1141.

In addition, the user interface 1161 may further include, for example, a gesture sensor, a gyro sensor that senses rotational movements, an acceleration sensor to track translational movement, a grip sensor, a pressure sensor, a proximity sensor, a color sensor, an infrared (IR) emitter and camera sensor for tracking gaze direction and eye movements, a temperature sensor, or a light sensor. For example, the gyro sensor, acceleration sensor, and infrared emitter and camera may be particularly suitable for AR/VR headset functions.

The touch screen 1142 includes touch sensors embedded in semiconductor layers of the display panel 1141 to sense pressure applied to the top layer (screen) of the display panel 1141. The touch sensors can be a capacitive or a resistive type. The touch screen 1142 may serve as the primary interface for the user to select and navigate applications, control, and interact with the electronic device 1000.

The display panel 1141 (or display) may include, for example, a liquid crystal display panel, an organic light emitting display panel, or an inorganic light emitting display panel. However, the type of the display panel 1141 is not particularly limited. The display panel 1141 may be of a rigid type or a flexible type that can be rolled or folded. The display module 1140 may further include a supporter, bracket, heat dissipation member, and the like that support the display panel 1141. The display panel 1141 may include the display device DD described above.

The power source module 1150 may supply power to the components of the electronic device 1000. The power source module 1150 may include a battery that charges the power source voltage. The battery may include a non-rechargeable primary battery or a rechargeable secondary battery or fuel cell. The power source module 1150 may include a power management integrated circuit (PMIC). The PMIC may supply optimized power to each of the components described above including the display module 1140.

As is traditional in the field of the present disclosure, embodiments are described, and illustrated in the drawings, in terms of functional blocks, units and/or modules. Those skilled in the art will appreciate that these blocks, units and/or modules are physically implemented by electronic (or optical) circuits such as logic circuits, discrete components, microprocessors, hard-wired circuits, memory elements, wiring connections, etc., which may be formed using semiconductor-based fabrication techniques or other manufacturing technologies. In the case of the blocks, units and/or modules being implemented by microprocessors or similar, they may be programmed using software (e.g., microcode) to perform various functions discussed herein and may optionally be driven by firmware and/or software. Alternatively, each block, unit and/or module may be implemented by dedicated hardware, or as a combination of dedicated hardware to perform some functions and a processor (e.g., one or more programmed microprocessors and associated circuitry) to perform other functions.

Referring to a comparative example, coupling noise may occur due to a change in the electric fields between the second drain electrode pattern and the scan line, which are disposed on the same layer and are not electrically connected to each other. The display device according to embodiments of the present disclosure may include a shield pattern that overlaps the second drain electrode pattern and the scan line on a plane and, to which a constant voltage is applied. By shielding the second drain electrode pattern and the scan line by using the shield pattern, to which the constant voltage is applied, coupling noise formed between the second drain electrode pattern and the scan line can be reduced or eliminated.

That is, in a comparative example, coupling noise may arise due to variations in the electric fields between the second drain electrode pattern and the scan line. For example, when these elements are disposed on the same layer and are not electrically connected, coupling noise can result due to variations in electric fields. To address this issue, a display device according to embodiments of the present disclosure incorporates a shield pattern that overlaps both the second drain electrode pattern and the scan line when viewed in a planar layout. A constant voltage is applied to the shield pattern, which may effectively reduce or eliminate coupling noise by electrically shielding the second drain electrode pattern and the scan line. This shielding mechanism may improve signal stability and improve overall display performance.

While the present disclosure has been particularly shown and described with reference to embodiments thereof, it will be understood by those of ordinary skill in the art that various changes in form and detail may be made therein without departing from the scope of the present disclosure as defined by the following claims.

Embodiments are set out in the following clauses:
Clause 1. A display device comprising:
   a base layer including a display area, and a non-display area disposed around the display area;
   a driving element layer disposed on the base layer;
   a plurality of light emitting elements disposed on the driving element layer, and each including a first electrode, an intermediate layer disposed on the first electrode, and a second electrode disposed on the intermediate layer; and
   a gate driver disposed in the non-display area, and configured to output a write scan signal,
   wherein the driving element layer includes:
      a scan line electrically connected to the gate driver;
      a first transistor electrically connected to the second electrode;
      a second electrode, to which the write scan signal is applied from the scan line; and
      a shield pattern overlapping the scan line and at least a portion of a drain pattern of a second transistor on a plane.
Clause 2. The display device of clause 1, wherein the scan line includes:
   a vertical line extending in a first direction from the gate driver; and
   a horizontal line electrically connected to the vertical line, and extending in a second direction crossing the first direction.
Clause 3. The display device of clause 2, wherein the shield pattern is disposed between the vertical line and the first electrode.
Clause 4. The display device of clause 3, further comprising:
   a voltage line disposed on the same layer as the vertical line, and to which a constant voltage is applied,
   wherein the constant voltage is applied to the shield pattern.
Clause 5. The display device of any of clauses 1 to 4, further comprising:
   a metal pattern overlapping a source pattern of the second transistor on a plane, and to which a constant voltage is applied.
Clause 6. The display device of any of clauses 1 to 5, wherein the non-display area includes a first area and a second area spaced apart from each other with respect to the display area, and
   wherein the gate driver includes:
   a first driving part disposed in the first area, and configured to output a first write scan signal in the write scan signal; and
   a second driving part disposed in the second area, and configured to output a second write scan signal having the same voltage level as that of the first write scan signal, in the write scan signal.
Clause 7. The display device of clause 6, wherein the non-display area further includes a third area connecting the first area and the second area, and
   wherein the gate driver further includes a third driving part disposed in the third area.
Clause 8. The display device of clause 7, wherein the third driving part outputs a compensation scan signal, a reset scan signal, and a light emission signal.

## Claims

1. A display device, comprising:
a base layer including a display area in which a plurality of pixels is disposed and a non-display area disposed adjacent to the display area;
a gate driver disposed in the non-display area and configured to output a write scan signal;
a scan line, comprising:
a vertical line extending from the gate driver in a first direction and configured to apply the write scan signal to the plurality of pixels; and
a horizontal line extending in a second direction crossing the first direction and electrically connected to the vertical line; and
a shield pattern overlapping the vertical line.

2. The display device of claim 1, wherein each of the plurality of pixels includes:
a pixel driver disposed on the base layer and including at least one transistor; and
a light-emitting element disposed on the at least one transistor, and including a first electrode, an intermediate layer disposed on the first electrode, and a second electrode disposed on the intermediate layer, and
wherein the shield pattern is disposed between the vertical line and the first electrode.

3. The display device of claim 2, further comprising:
a voltage line extending in the first direction and configured to apply a constant voltage to the shield pattern.

4. The display device of claim 3, wherein the voltage line is disposed on a same layer as the vertical line.

5. The display device of claim 3 or claim 4, further comprising:
a lower conductive layer disposed under the transistor, and a sub-shield pattern disposed on a same layer as the lower conductive layer and overlapping the vertical line;
optionally wherein the constant voltage is applied to the sub-shield pattern.

6. The display device of any of claims 2 to 5, wherein the at least one transistor includes:
a first transistor electrically connected to the second electrode; and
a second transistor, to which the write scan signal is applied, and
wherein the shield pattern overlaps at least a portion of a drain pattern of the second transistor.

7. The display device of claim 6, further comprising:
a metal pattern overlapping a source pattern of the second transistor, and to which a constant voltage is applied; and/or
wherein the drain pattern is disposed on a same layer as the vertical line.

8. The display device of any preceding claim, wherein among the plurality of pixels, pixels disposed in a first row are defined as first row pixels, and
wherein the horizontal line is electrically connected to the first row pixels, and applies the write scan signal to the first row pixels.

9. The display device of claim 8, further comprising:
a light emission line including a vertical light emission line extending from the gate driver in the first direction and configured to apply a light emission signal from the gate driver to the plurality of pixels, and a horizontal light emission line extending in the second direction and electrically connected to the vertical light emission line.

10. The display device of claim 9, (i) wherein among the plurality of pixels, pixels disposed in a second row are defined as second row pixels, and
wherein the horizontal light emission line is electrically connected to the first row pixels and the second row pixels, and applies the light emission signal to the first row pixels and the second row pixels; and/or
(ii) wherein the display device further comprises:
a compensation scan line configured to apply a compensation scan signal from the gate driver to the plurality of pixels; and
a reset scan line configured to apply a reset scan signal from the gate driver to the plurality of pixels.

11. The display device of any of claims 8 to 10, wherein the vertical line includes:
a first vertical line connected to a first end of the horizontal line; and
a second vertical line connected to a second end of the horizontal line, which is opposite to the first end, and
wherein the write scan signal is applied to the first vertical line and the second vertical line.

12. The display device of any preceding claim, wherein the horizontal line is disposed on a different layer from the vertical line, and is electrically connected to the vertical line through a contact hole.

13. The display device of any preceding claim, wherein each of the plurality of pixels includes:
a pixel driver disposed on the base layer and including at least one transistor; and
a light-emitting element disposed on the at least one transistor, and including a first electrode, an intermediate layer disposed on the first electrode, and a second electrode disposed on the intermediate layer, and
wherein the display device further includes a connection electrode electrically connecting the transistor and the second electrode;
optionally (i) wherein the display device further comprises:
a pixel definition film, in which an opening exposing at least a portion of the first electrode is defined; and
an insulating material disposed on the pixel definition film,
wherein, in a contact area adjacent to the insulating material, a lower surface of the second electrode contacts an upper surface of the connection electrode; and/or
(ii) wherein the shield pattern is disposed on a same layer as the connection electrode.

14. A display device, comprising:
a base layer including a display area and a non-display area disposed adjacent to the display area;
a driving element layer disposed on the base layer;
a plurality of light-emitting elements disposed on the driving element layer,
wherein each of the plurality of light-emitting elements includes a first electrode, an intermediate layer disposed on the first electrode, and a second electrode disposed on the intermediate layer; and
a gate driver disposed in the non-display area and configured to output a write scan signal,
wherein the driving element layer includes:
a scan line electrically connected to the gate driver;
a first transistor electrically connected to the second electrode;
a third electrode, to which the write scan signal is applied from the scan line; and
a shield pattern overlapping the scan line and at least a portion of a drain pattern of a second transistor.

15. An electronic device, comprising:
a display device;
an electronic module overlapping the display device; and
a housing accommodating the display device,
wherein the display device comprises:
a base layer including a display area in which a plurality of pixels is disposed and a non-display area disposed adjacent to the display area;
a gate driver disposed in the non-display area and configured to output a write scan signal;
a scan line, comprising:
a vertical line extending from the gate driver in a first direction and configured to apply the write scan signal to the plurality of pixels; and
a horizontal line extending in a second direction crossing the first direction and electrically connected to the vertical line; and
a shield pattern overlapping the vertical line.
